(19) Europäisches Patentamt
European Patent Office
Office européen des brevets

(11) EP 2 706 077 A1

(12) EUROPEAN PATENT APPLICATION
published in accordance with Art. 153(4) EPC

(43) Date of publication:
12.03.2014 Bulletin 2014/11

(21) Application number: 12757048.9

(22) Date of filing: 09.03.2012

(51) Int Cl.:
C08G 61/12 (2006.01) C08K 3/04 (2006.01)
C08L 65/00 (2006.01) H01L 51/42 (2006.01)

(86) International application number:
PCT/JP2012/056118

(87) International publication number:
WO 2012/124627 (20.09.2012 Gazette 2012/38)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: 11.03.2011 JP 2011054455
26.08.2011 JP 2011184628

(71) Applicant: Kuraray Co., Ltd.
Okayama 710-0801 (JP)

(72) Inventors:
- INAGAKI, Takuya
Kurashiki-shi, Okayama 710-0801 (JP)
- SHIBUYA, Hiromasa
Kurashiki-shi, Okayama 710-0801 (JP)
- SUGIOKA, Takashi
Kurashiki-shi, Okayama 710-0801 (JP)
- IZAWA, Takafumi
Kurashiki-shi, Okayama 710-0801 (JP)
- MORIHARA, Yasushi
Kurashiki-shi, Okayama 710-0801 (JP)
- NAKAHARA, Atsuhiro
Kurashiki-shi, Okayama 710-0801 (JP)
- FUJITA, Akio
Kurashiki-shi, Okayama 710-0801 (JP)
- OGI, Hiroyuki
Kurashiki-shi, Okayama 710-0801 (JP)

(74) Representative: Müller-Boré & Partner
Patentanwälte PartG mbB
Friedenheimer Brücke 21
80639 München (DE)

# (54) ELECTRON CONJUGATED BLOCK COPOLYMER AND PHOTOELECTRIC CONVERSION ELEMENT

(57) Provided is a conjugated block copolymer that is capable of morphology control and that can achieve superior conversion efficiency. A $\pi$-electron conjugated block copolymer contiguously or non-contiguously bonding polymer block (A) involving a monomer unit having in a portion of a chemical structure at least one heteroaryl skeleton selected from a thiophene, a fluorine, a carbazole, a dibenzosilole and a dibenzogermole; and a polymer block (B) involving a monomer unit similarly having at least one heteroaryl skeleton; wherein the polymer block (A) comprises a homopolymer block of a monomer unit having a substituent $R^{nA}$ that is an alkoxy group or an alkyl group having 1 - 18 carbon atoms, and the polymer block (B) comprises a copolymer block of at least two different from each other types of monomer units having substituent $R^{nB}$ selected from an alkoxy group or an alkyl group having 1 - 18 carbon atoms, which may be substituted with an alkoxy group, a halogen atom, a hydroxyl group, an amino group, a thiole group, a silyl group, an ester group, an aryl group, hetero aryl group.

EP 2 706 077 A1

**Description**

TECHNICAL FIELD

The present invention relates to a novel $\pi$-electron conjugated block copolymer having a self-assembly property, and to a photoelectric conversion element comprising the copolymer thereof.

BACKGROUND ART

Organic thin film solar cells which are produced by coating with a method using a polymer material that is soluble in solvent has attracted much attention, because they can be manufactured at low cost when compared with inorganic solar cells which are mainstream solar cells that have been made of polycrystalline silicon, amorphous silicon, compound semiconductor, etc.

The organic thin film solar cell, which is one of the photoelectric conversion elements, generally has a photoelectric conversion active layer which has a bulk heterojunction structure formed with a mixture of a conjugated polymer and an electron accepting material. As a specific example, there is an organic thin film solar cell having a photoelectric conversion active layer including a mixture of poly(3-hexylthiophene) (an conjugated polymer) and [6,6]-phenyl $C_{61}$ butyric acid methyl ester (PCBM), a fullerene derivative which is an electron accepting material (Non-Patent Document 1).

In the bulk heterojunction structure, incident light entering from the transparent electrode is absorbed by an electron accepting material and a conjugated polymer to generate an exciton which is a bound state of an electron and a hole. The generated exciton moves to the heterojunction interface where the electron accepting material abuts on the conjugated polymer, to charge-separate into an electron and a hole. Holes and electrons are then each transported through the conjugated polymer phase and the electron accepting material phase, and are then taken out from the electrode. Therefore, in order to improve the conversion efficiency of organic thin film solar cells, the key point is how to controll the morphology which is formed during phase separation from the conjugated polymer and the electron accepting material both of which form a bulk heterojunction structure.

As a superior method for controlling the morphology of the electron accepting material and the conjugated polymer, a method in which a conjugated block copolymer is used has been known. For example, organic thin film solar cells have been reported, in which a fullerene derivative is used as an electron accepting material, and as a conjugated block copolymer, a diblock copolymer made from 3-hexylthiophene and 3-(2-ethylhexyl)thiophene (Non-Patent Document 2), a diblock copolymer made from 3-hexylthiophene and 3-(phenoxymethyl)thiophene (Non-Patent Document 3), a diblock copolymer made from 3-butylthiophene and 3-octylthiophene (Non-Patent Document 4), or a diblock copolymer made from 3-hexylthiophene and 3-cyclohexylthiophene (Non-Patent Document 5) is used respectively. Further, an organic thin film solar cell element using a conjugated block copolymer having a skeleton different from the polythiophene has been disclosed in order to achieve high conversion efficiency (Patent Document 1).

[PRIOR ART DOCUMENTS]

[Patent Document]

[Patent Document 1] Japan Patent Application Publication No. 2008-266459

[Non-Patent Documents]

[Non-Patent Document 1] Angew. Chem. Int. Ed, 47, p.58 (2008)
[Non-Patent Document 2] J. Am. Chem. Soc., 130, p.7812 (2008)
[Non-Patent Document 3] Organic Electronics, 10, p.1541 (2009)
[Non-Patent Document 4] Chem. Mater., 22, p.2020 (2010)
[Non-Patent Document 5] J. Polym. Sci. Part A: Polym, Chem., 48, p.614 (2010)

SUMMARY OF THE INVENTION

PROBLEMS TO BE SOLVED BY THE INVENTION

The organic thin film solar cells using conjugated block copolymer listed in the prior art documents mentioned above, are allowed to control morphology to some extent, but the conversion efficiency has remained low at around only

2 to 3 percent. The present invention was made to solve such problems and to provide a conjugated block copolymer capable of controlling morphology and expressing excellent conversion efficiency, and also to provide a photoelectric conversion element including an electron accepting material and a conjugated block copolymer.

MEANS TO SOLVE THE PROBLEMS

The present invention which was made to achieve the previously described objects is a p-electron conjugated block copolymer contiguously or non-contiguously bonding a polymer block (A) involving a monomer unit having in a portion of a chemical structure at least one heteroaryl skeleton selected from a thiophene, a fluorene, a carbazole, a dibenzosilole and a dibenzogermole; and a polymer block (B) involving a monomer unit similarly having at least one heteroaryl skeleton; wherein the polymer block (A) comprises a homopolymer block of a monomer unit having a substituent $R^{nA}$ that is an alkoxy group or an alkyl group having 1 - 18 carbon atoms, and the polymer block (B) comprises a copolymer block of at least two different from each other types of monomer units having substituents $R^{nB}$ selected from an alkoxy group or an alkyl group having 1 - 18 carbon atoms, which may be substituted with an alkoxy group, a halogen atom, a hydroxyl group, an amino group, a thiol group, a silyl group, an aryl group, an ester group or a heteroaryl group.

The present invention is the p-electron conjugated block copolymer, which is characterized in that the heteroaryl skeleton of the monomer unit that constitutes the polymer block (A) and the polymer block (B) is a group having at least one thiophene ring in a portion of the chemical structure.

The present invention is the $\pi$-electron conjugated block copolymer, which is characterized in that the polymer block (A) or the polymer block (B) includes a monomer unit of -a-b-, and the -a- has any one of groups represented by chemical formulas (1) - (8) below,

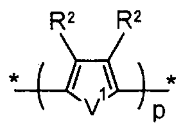

・・・ (1)

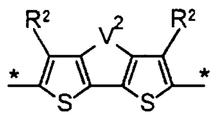

・・・ (2)

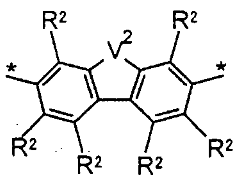

・・・ (3)

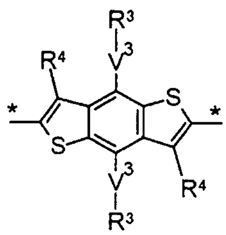

・・・ (4)

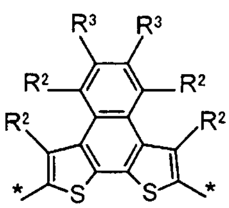

・・・ (5)

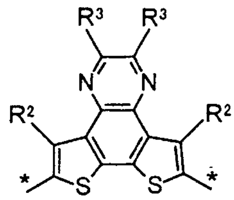

・・・(6)

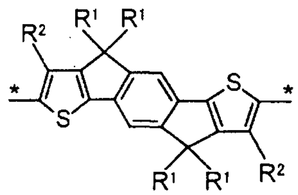

・・・(7)

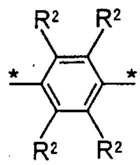

・・・(8)

the -b- has any one of groups represented by the chemical formulas (9) - (19) below.

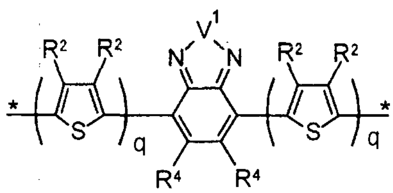

・・・(9)

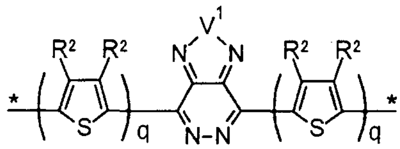

・・・(10)

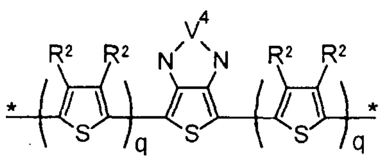

・・・(11)

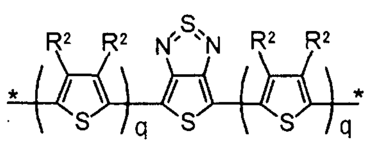

・・・(12)

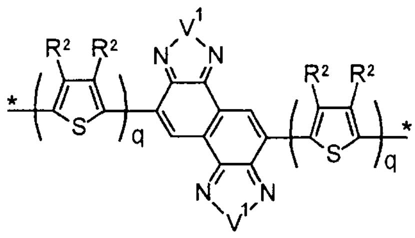

・・・(13)

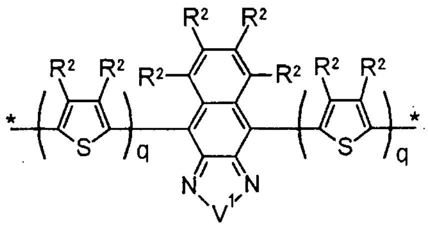

・・・(14)

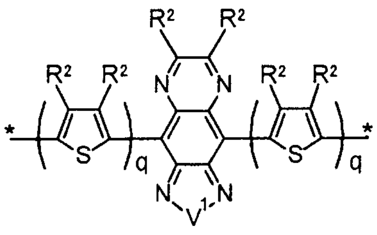

・・・(15)

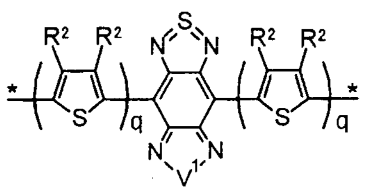

・・・(16)

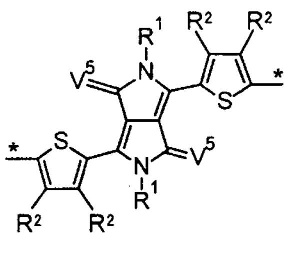

・・・(17)

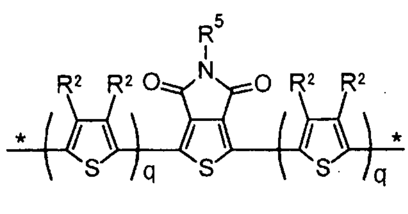

・・・(18)

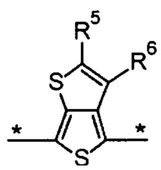

・・・(19)

In the formulas (1) - (19) described above, $V^1$ is nitrogen ($-NR^1-$), oxygen (-O-) or sulfur (-S-); $V^2$ is carbon (-

$CR^1{}_2$-), nitrogen (-$NR^1$-), silicone (-$SiR^1{}_2$-) or germanium (-$GeR^1{}_2$-); $V^3$ is an aryl group or hetero aryl group represented by -(Ar)q-; $V^4$ is nitrogen (-$NR^1$-), oxygen (-O-) or- $CR^2$=$CR^2$-; and $V^5$ is oxygen (O) or sulfur (S). $R^1$ is each independently an alkyl group having 1 - 18 carbon atoms which may be substituted, $R^2$ is each independently a hydrogen atom or an alkyl group having 1-18 carbon atoms which may be substituted, $R^3$ is each independently an alkoxy group or an alkyl group having 1-18 carbon atoms which may be substituted, $R^4$ is each independently a hydrogen atom, a halogen atom, or an aryl group or an alkyl group having 1-18 carbon atoms which may be substituted, $R^5$ is an aryl group, an alkylcarbonyl group, an alkyloxy carbonyl group, or an alkyl group having 1 - 18 carbon atoms which may be substituted, and $R^6$ is a hydrogen atom or a halogen atom.

p is an integer of 1 - 3, and q represents an integer of 0 - 3.

Here, at least one of $R^1$ - $R^5$ of monomer unit -a-b-, which is included in the polymer block (A), is $R^{nA}$, and at least one of $R^1$ - $R^5$ of monomer unit -a-b-, which is included in the polymer block (B), is $R^{nB}$ that may be substituted with an alkoxy group, a halogen atom, a hydroxyl group, an amino group, a thiol group, a silyl group, an ester group, an aryl group or a heteroaryl group.

The present invention is the $\pi$-electron conjugated block copolymer, which is characterized in that the monomer unit -a-b- is any one of groups selected from the following chemical formulas (20) - (31).

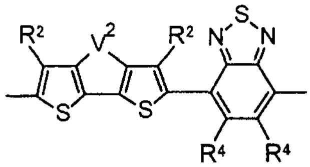

・・・(20)

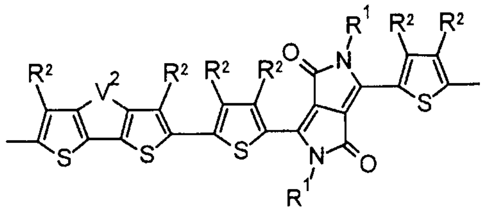

・・・(21)

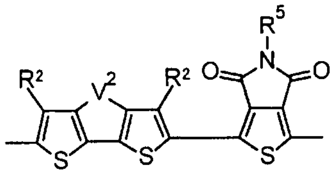

・・・(22)

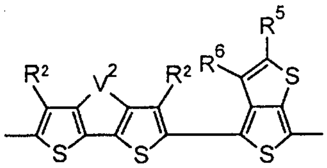

・・・(23)

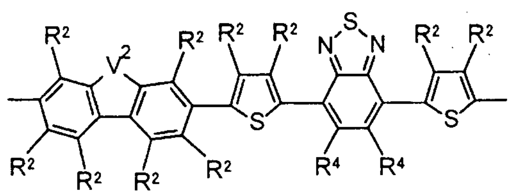

・・・(24)

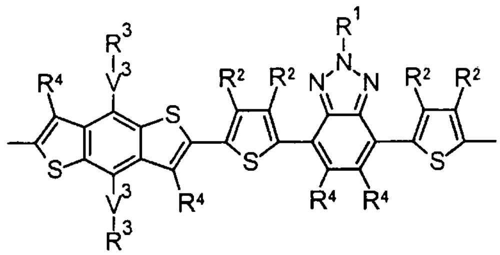

・・・（２５）

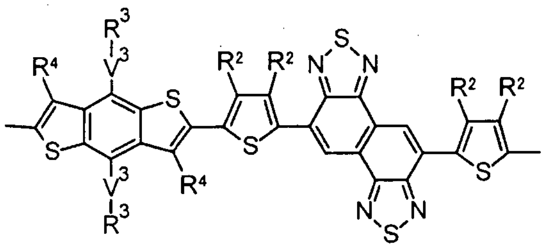

・・・（２６）

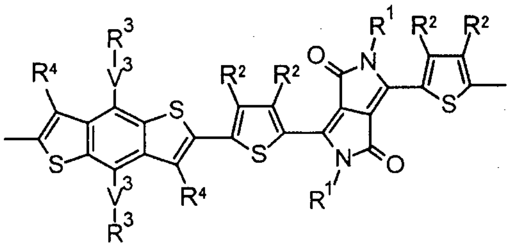

・・・（２７）

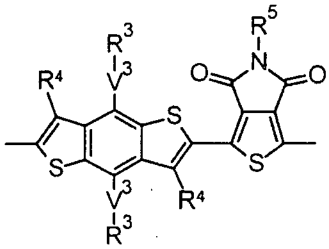

・・・（２８）

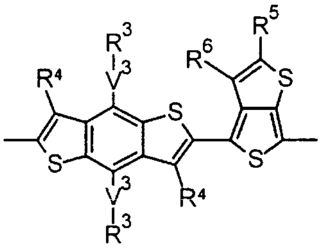

・・・（２９）

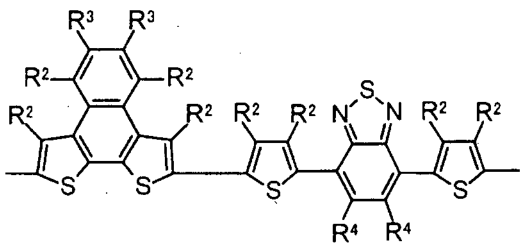

・・・（３０）

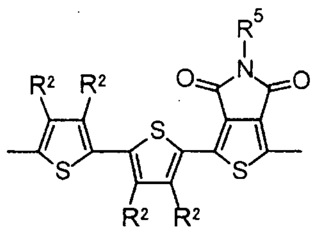

・・・(31)

In the formulas (20) - (31), $V^2$ is a carbon ($-CR^1_2-$), nitrogen ($-NR^1-$), silicon ($-SiR^1_2-$) or germanium ($-GeR^1_2$), $V^3$ is an aryl group or a heteroaryl group represented by -(Ar)q-. $R^1$, $R^2$, $R^3$, $R^4$, $R^5$ and $R^6$ are the same as defined above. q represents an integer of 0 - 3. However, at least one of $R^1$ - $R^5$ of the monomer unit -a-b-, which is included in the polymer block (A) is $R^{nA}$. At least one of $R^1$ - $R^5$ of the monomer unit -a-b-, which is included in the polymer block (B), is $R^{nB}$ that may be substituted with an alkoxy group, a halogen atom, a hydroxyl group, an amino group, a thiol group, a silyl group, an ester group, an aryl group or a heteroaryl group.

The present invention is the $\pi$-electron conjugated block copolymer, which is characterized in that a polymer block that including the monomer unit of -a-b- is both the polymer block (A) and the polymer block (B).

The present invention is the $\pi$-electron conjugated block copolymer, which is characterized in that the polymer block (B) is a random copolymer.

The present invention is the $\pi$-electron conjugated block copolymer, which is characterized in that the random copolymer comprises a plurality of different types of monomer units -a-b- from each other.

The present invention which was made to achieve the object of the present invention is a composition comprising an electron accepting material and the $\pi$-electron conjugated block copolymer described above.

Similarly, the present invention which was made to achieve the object of the present invention is a photoelectric conversion element comprising a layer essentially consisting of the composition described above.

The present invention is the photoelectric conversion element, in which the electron accepting material comprises a fullerene or/and a derivative thereof.

ADVANTAGEOUS EFFECT OF THE INVENTION

When the present $\pi$-electron conjugated block copolymer is used in a photoelectric conversion element together with an electron accepting material, an increase in the current value and a decrease in the resistance can be realized, and performance is significantly improved.

MODE FOR CARRYING OUT THE INVENTION

Preferred embodiment for carrying out the present invention will be precisely explained below, but the scope of the present invention is not limited to these embodiments.

In the present $\pi$-electron conjugated block copolymer, the polymer block (A) and polymer block (B) are combined or bonded, and a main chain skeleton of its monomer unit is a divalent group exhibiting a $\pi$-electron conjugation. The monomer unit has at least, in a portion of its chemical structure, one heteroaryl skeleton selected from a thiophene, a fluorene, a carbazole, a dibenzosilole, and a dibenzogermole. As the $\pi$-electron conjugated compounds having a thiophene ring in a portion of the chemical structure, for example, thiophene, cyclopentadithiophene, dithieno pyrrole, dithienosilole, dithienogermole, benzodithiophene, naphthodithiophene and the like are exemplified. A substituent is introduced by a covalent bond to the main chain skeleton for the purpose of controlling solubility and polarity of the $\pi$-electron conjugated block copolymer.

The polymer block (A) has, as a substituent, $R^{nA}$ that is an alkoxy group or an alkyl group having 1 - 18 carbon atoms, and involves a monomer unit having, in a portion of the chemical structure, at least one heteroaryl skeleton selected from the group consisting of a thiophene, a fluorene, a carbazole, a dibenzosilole and a dibenzogermole. In a case where the monomer unit has substituents in a plurality of portions, each substituent itself may be different from each other, but the monomer units included in the polymer block (A) each has preferably the same structure even in terms of structure of its substituent. However, other monomer units having different structure may be used, as long as the other monomer does not impair the effects of the present invention.

As a single type of alkyl group of $R^{nA}$ having 1 - 18 carbon atoms, for example, methyl group, ethyl group, n-propyl group, isopropyl group, n-butyl group, isobutyl group, sec-butyl group, tert-butyl group, n-pentyl group, isopentyl group, neopentyl group, tert-pentyl group, n-hexyl group, isohexyl group, 2-ethylhexyl group, n-heptyl group, n-octyl group, n-nonyl group, n-decyl group, cyclopropyl group, cyclopentyl group, cyclohexyl group, cyclooctyl group, and the like are exemplified.

As a single type of alkoxy group of $R^{nA}$ having 1 - 18 carbon atoms, for example, methoxy group, ethoxy group, n-propyloxy group, isopropyloxy group, n-butoxy group, n-hexyloxy group, ethylhexyloxy group, cyclohexyloxy group, n-octyloxy group, n-decyloxy group, n-dodecyloxy group, and the like, are exemplified. The alkyl group or alkoxy group which constitutes $R^{nA}$ may be either linear, branched or cycloaliphatic, and two adjacent $R^{nA}$ may also form a ring by bonding with each other.

The polymer block (B) involves a plural types or kinds of monomer units having, in a portion of a chemical structure thereof, at least one heteroaryl skeleton selected from the group consisting of a thiophene, a fluorene, a carbazole, a dibenzosilole and a dibenzogermole; and having different substituents $R^{nB}$ different from each other and selected from an alkoxy group or an alkyl group having 1 - 18 carbon atoms which may be substituted with an alkoxy group, a halogen atom, a hydroxyl group, an amino group, a thiol group, a silyl group, an ester group, an aryl group, a heteroaryl group. In other words, it is required that the polymer block (B) should be a copolymer block comprising a plural types of monomer units which have the same main chain skeleton but have different substituents, or should be a copolymer block comprising a plural types of monomer units which have different main chain skeletons. If the polymer block (B) comprises a plural types of monomer units having different substituents, it is preferable that at least one substituent is a non-substituted alkyl group or alkoxy group.

As an alkyl group of $R^{nB}$ having 1-18 carbon atoms, for example, methyl group, ethyl group, n-propyl group, isopropyl group, n-butyl group, isobutyl group, sec-butyl group, tert-butyl group, n-pentyl group, isopentyl group, neopentyl group, tert -pentyl group, n-hexyl group, isohexyl group, 2-ethylhexyl group, n-heptyl group, n-octyl group, n-nonyl group, n-decyl group, cyclopropyl group, cyclopentyl group, cyclohexyl group, cyclooctyl group, etc. can be exemplified.

As an alkoxy group of $R^{nB}$, for example, an alkoxy group such as methoxy group, ethoxy group, n-propyloxy group, isopropyloxy group, n-butoxy group, n-hexyloxy group, ethylhexyloxy group, cyclohexyloxy group, n-octyloxy group, n-decyloxy group, n-dodecyloxy group, etc. can be exemplified. As an alkyl group or an alkoxy group which constitutes $R^{nB}$ may be either linear, branched or cycloaliphatic, and two adjacent $R^{nB}$ may also form a ring by bonding with each other.

As a halogen atom that may substitute $R^{nB}$ of the polymer block (B), for example, a fluorine atom, a chlorine atom, a bromine atom and an iodine atom are exemplified. As an alkyl group that is substituted with a halogen atom, for example, an ω-bromoalkyl group, a perfluoroalkyl group, and the like are exemplified.

As an amino group, for example, a primary or secondary amino group such as dimethylamino group, diphenylamino group, methylphenylamino group, methylamino group and ethyl amino group are exemplified.

As a thiol group, for example, a mercapto group, an alkylthio group can be exemplified. As a silyl groups, e.g. trimethylsilyl group, triethylsilyl group, tripropylsilyl group, triisopropylsilyl group, dimethylisopropylsilyl group, dimethyl-tert-butylsilyl group are exemplified.

As an aryl group, for example, phenyl group, 1-naphthyl group, 2-naphthyl group, 1-anthracenyl group, 2-anthracenyl group, 9-anthracenyl group, etc. are exemplified. These aryl groups may have a substituent such as an alkyl group, an alkoxy group, etc.

As a heteroaryl group, for example, pyridyl group, thienyl group, furyl group, pyrrolyl group, quinolyl group, isoquinolyl group, etc. are exemplified.

As a heteroaryl skeleton of a monomer unit that constitutes the polymer block (A) and the polymer block (B), a group having at least one thiophen ring in a portion of the chemical structure is exemplified. The thiophene ring may exist in the heteroaryl skeleton as one or more thiophene-2,5-diyl group, or may exist in the form of a condensed ring such as a thienothiophene, a dithienopyrrole, a benzodithiophene. More preferably, a group having a condensed thiophene ring or thiophene-2,5-diyl group having a substituent at least at 3-position, yet more preferably, a group having a condensed thiophene ring, is exemplified.

As a preferable monomer unit that constitutes the polymer block (A) or the polymer block (B), those including a group represented by the chemical formulas (1) - (19) are exemplified. The polymer block (A) or the polymer block (B) preferably comprises -a-b- monomer unit. -a- is preferably a monomer unit having any one of groups (a group comprising a donor type unit) represented by the chemical formulas (1) - (8), and -b- is preferably a monomer unit having any one of groups (a group comprising a unit having a ring serving as an acceptor) represented by the chemical formulas (9) - (19). Here, in the chemical formula (4), $V^3$ is a monocyclic or polycyclic aryl group or heteroaryl group (q is an integer of 0 - 3) represented by -(Ar)q-, and is a portion of the main chain skeleton in the monomer unit. As $V^3$, a thiophene ring is particularly preferable.

Further, as a specific example of the monomer units that constitute -a-b-, monomer units represented by the chemical formulas (20) - (31) are exemplified. For example, a monomer unit represented by the chemical formula -(2)-(9)- is a formula represented by the chemical formula (20), similarly, a monomer unit represented by the chemical formula -(2)-(17)-is a formula represented by the chemical formula (21), a monomer unit represented by the chemical formula -(2)-(18)- is a formula represented by the chemical formula (22), a monomer unit represented by the chemical formula -(2)-(19)- is a formula represented by the chemical formula (23), a monomer unit represented by the chemical formula -(3)-(9)- is a formula represented by the chemical formula (24), a monomer unit represented by the chemical formula

-(4)-(9)- is a formula represented by the chemical formula (25), a monomer unit represented by the chemical formula -(4)-(13)- is a formula represented by the chemical formula (26), a monomer unit represented by the chemical formula -(4)-(17)- is a formula represented by the chemical formula (27), a monomer unit represented by the chemical formula -(4)-(18)- is a formula represented by the chemical formula (28), a monomer unit represented by the chemical formula -(4)-(19)- is a formula represented by the chemical formula (29), a monomer unit represented by the chemical formula -(5)-(9)- is a formula represented by the chemical formula (30), and a monomer unit represented by the chemical formula -(1)-(18)- is a formula represented by the chemical formula (31). Note that in the monomer unit of the present invention, as long as a polymer has a plurality of certain repeating structures in the polymer, a plurality of bonded heteroaryl structures (or, for example, a monomer unit of -a-b-) comprising a thiophene, a fluorene, a carbazole, a dibenzosilole or a dibenzogermole is also included as the monomer unit of the present invention. In other words, as long as the substituent groups are the same, a complete alternating copolymer block of the monomer unit -a- and the other monomer unit -b- is considered to be a homopolymer block of the monomer unit -a-b-.

As the substituent of the monomer unit of -a-b-, those represented by $R^1$-$R^6$ in the chemical formulas (1) - (31) can be exemplified. $R^1$ is each independently an alkyl group having 1 - 18 carbon atoms which may be substituted. $R^2$ is each independently a hydrogen atom or an alkyl group having 1 - 18 carbon atoms which may be substituted. $R^3$ is each independently an alkoxy group or an alkyl group having 1 - 18 carbon atoms which may be substituted. $R^4$ is each independently a hydrogen atom, a halogen atom, or an aryl group or an alkyl group having 1 - 18 carbon atoms which may be substituted. $R^5$ is an aryl group, an alkylcarbonyl group, an alkyloxy carbonyl group, or an alkyl group having 1 - 18 carbon atoms which may be substituted, and $R^6$ is a hydrogen atom or a halogen atom.

However, if the polymer block (A) comprises the monomer unit of -a-b-, at least one of the substituents of $R^1$ - $R^5$ of -a-b- is $R^{nA}$ that is an alkoxy group or an alkyl group having 1 - 18 carbon atoms. If the polymer block (B) comprises the monomer units of -a-b-, at least one of $R^1$ - $R^5$ of -a-b- is $R^{nB}$ which is an alkoxy group or an alkyl group having 1 - 18 carbon atoms which may be substituted with an alkoxy group, a halogen atom, a hydroxyl group, an amino group, a thiol group, a silyl group, an ester group, an aryl group or heteroaryl group. If the polymer block (B) comprises two or more types of monomer units of -a-b-, it is preferable that each monomer unit has a different $R^{nB}$ from each other.

The specific preferable example of -a- represented by the chemical formulas (1) - (8), is not particularly limited, but for example, a group represented by the following chemical formulas (32) - (38) can be exemplified.

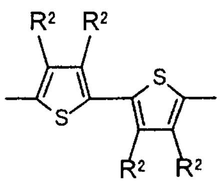
(32)

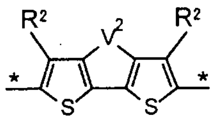
(33)

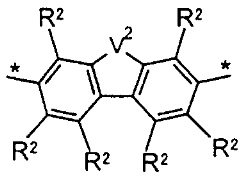
(34)

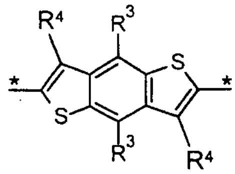
(35)

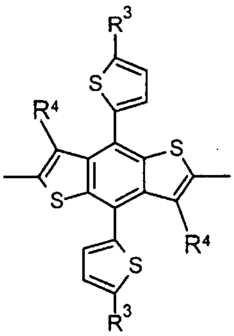
(36)

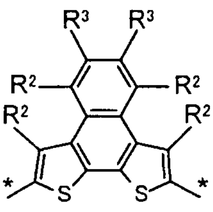
(37)

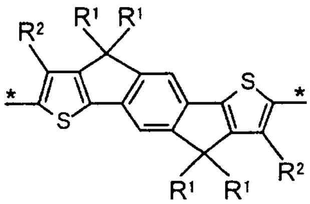
(38)

In the chemical formulas (32) - (38), $V^2$, $R^1$, $R^2$, $R^3$ and $R^4$ are the same as defined above.

A preferred embodiment of -b- represented by the chemical formulas (9)-(19), is not particularly limited, but for example, a group represented by the following chemical formulas (39) - (44) can be exemplified.

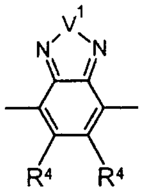
(39)

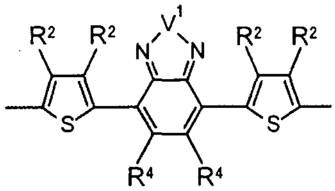
(40)

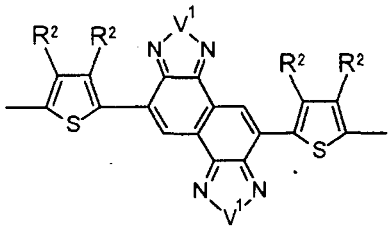
(41)

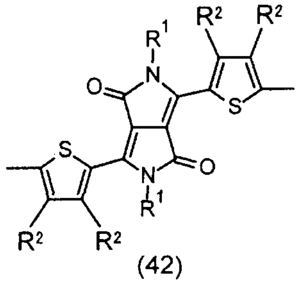
(42)

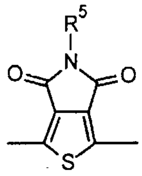
(43)

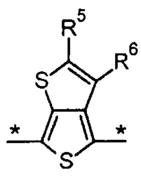
(44)

In the chemical formulas (39) - (44), $V^1$, $R^1$, $R^2$, $R^3$, $R^4$, $R^5$ and $R^6$ are the same as defined above.

Further, as a preferred embodiment of -a-b- represented by the chemical formulas (20) - (31), for example, following chemical formulas represented by (45) - (64) can be exemplified. However they are not particularly limited.

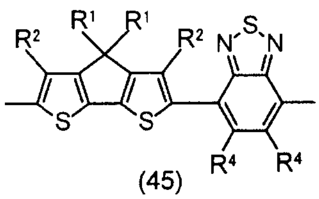
(45)

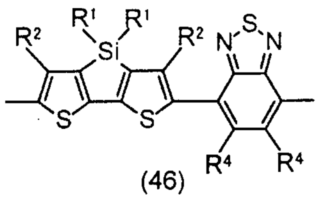
(46)

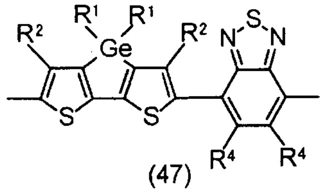
(47)

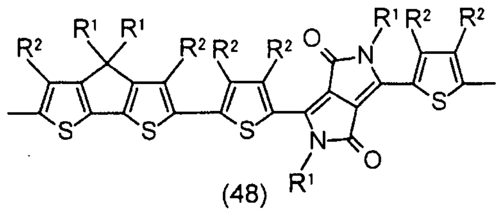
(48)

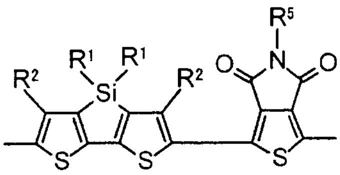
(49)

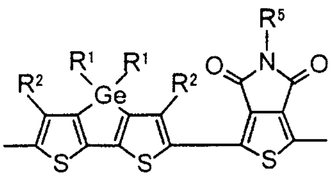
(50)

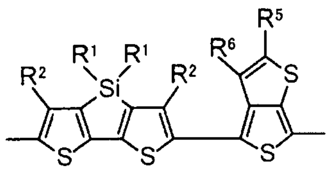
(51)

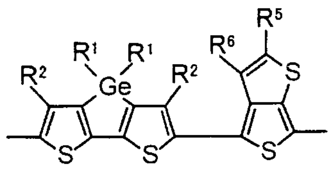
(52)

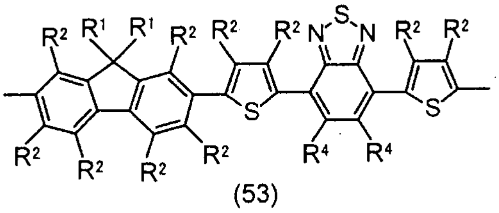
(53)

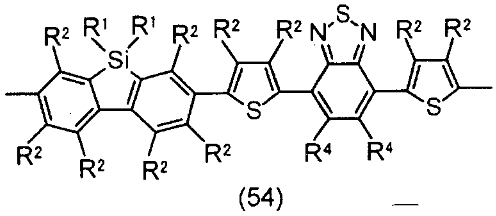
(54)

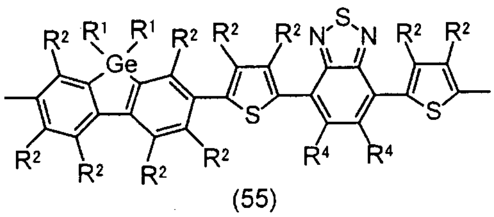

(55)

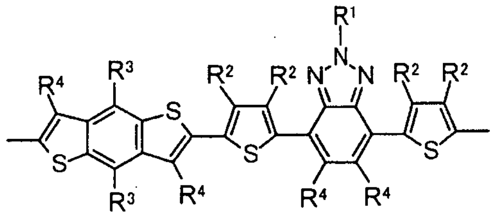

(56)

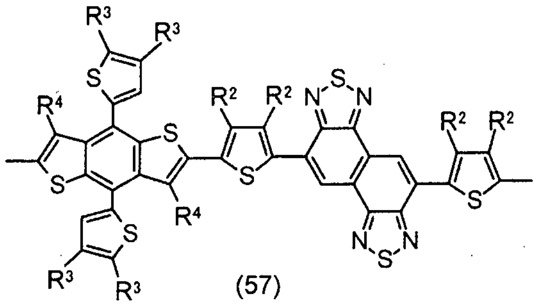

(57)

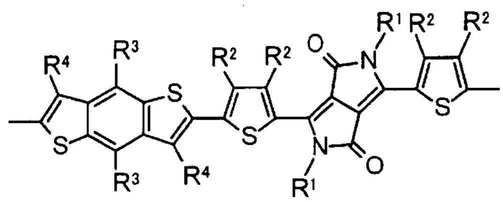

(58)

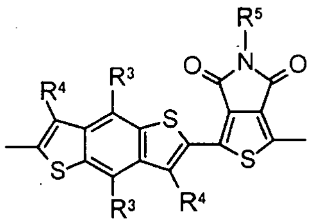

(59)

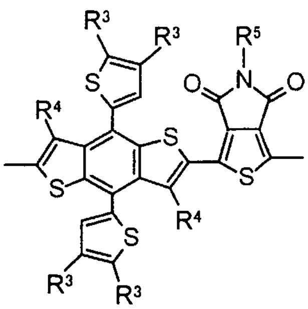

(60)

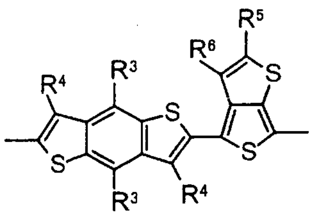

(61)

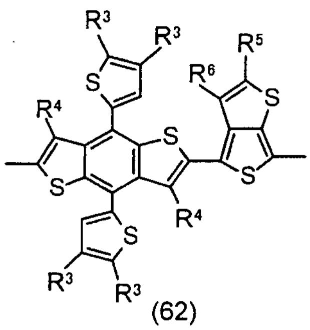

(62)

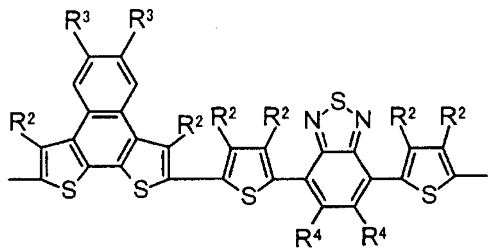

(63)

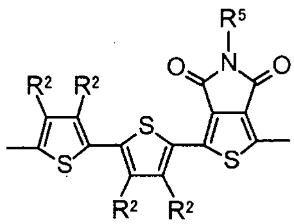

(64)

In the chemical formulas (45) - (64), $R^1$ - $R^6$ are the same as defined above.

Bonding structures between the polymer block (A) and the polymer block (B) included in the $\pi$-electron conjugated block copolymer of the present invention is not particularly limited. As a structure to be bonded contiguously, for

example, B-A type diblock copolymer or A-B type diblock copolymer, B-A-B type triblock copolymer or A-B-A type triblock copolymer, B-A-B-A type tetrablock copolymer or A-B-A-B type tetrablock copolymer, A-B-A-B-A type pentablock copolymer or B-A-B-A-B type pentablock copolymer, and the like can be exemplified. These block copolymers may be used alone, or may be used in combination of two or more.

A weight ratio of the polymer block (A) to the polymer block (B) is preferably in the range of 99:1 - 1:99. It is more preferably 95:5 - 5:95. When weight ratio of the polymer block (A) to the polymer block (B) is too small, being undesirable, more preferably from 90:10 - 10:90.

The polymer block (B) comprises at least two unlike monomer units. The weight ratio of the monomer units is not particularly limited. When at least two unlike monomer units are used, preferred weight ratio of one monomer unit to otherwise monomer units is in the range of 10:90 - 99:1. When a certain kind of monomer unit is excessively used, functions derived from the polymer block (B) can not be developed. Accordingly, more preferably the ratio is in the range of 10:90 - 95:5.

The number average molecular weight of the present $\pi$-electron conjugated block copolymer is preferably in the range of 1,000 - 500,000 g/mol, more preferably from 5,000 - 300,000 g/mol, still more preferably from 10,000 - 300,000 g/mol, in view of workability, crystallinity, solubility, and photoelectric conversion characteristics. Solubility decreases and workability of the thin film decreases with increase in the number average molecular weight. When the number average molecular weight is set too low, properties such as crystalline properties, stability of the film, photoelectric conversion properties, are decreased. The number average molecular weight means the polystyrene equivalent molecular weight in gel permeation chromatography.

The present $\pi$-electron conjugated block copolymer may include an optional polymer block (C) that is different from the polymer block (A) or the polymer block (B). The polymer block (C) is not a $\pi$-electron conjugated polymer. As monomers that constitute the polymer block (C), aromatic vinyl compounds such as styrene, chloromethyl styrene, vinylpyridine, and vinylnaphthalene; (meth) acrylic acid esters such as (meth) methyl acrylate (meth) ethyl acrylate, and (meth) acrylic acid hydroxyethyl; vinyl esters such as vinyl acetate, vinyl propionate, vinyl butyrate, and vinyl pivalate; alpha hydroxy acids such as lactic acid, glycolic acid, and the like, are exemplified.

When the present $\pi$-electron conjugated block copolymer includes the polymer block (C), the structures of the block copolymer are exemplified below. As a structure of the polymer block in which the polymer block (A) and the polymer block (B) is contiguously bonded, for example, A-B-C type triblock copolymer, B-A-C type triblock copolymer, C-A-B type triblock copolymer, C-B-A type triblock copolymer, A-B-A-C type tetrablock copolymer, B-A-B-C type tetrablock copolymer, C-A-B-A type tetrablock copolymer, C-B-A-B type tetrablock copolymer, C-A-B-C type tetrablock copolymer, C-B-A-C type tetrablock copolymer, C-A-B-A-C type pentablock copolymer, C-B-A-B-C type pentablock copolymer, A-B-A-B-C type pentablock copolymer, B-A-B-A-C type pentablock copolymer, C-B-A-B-A type pentablock copolymer, C-A-B-A-B-type pentablock copolymer, and the like are exemplified.

That the polymer block (A) and the polymer block (B) is non-contiguously bonded means that the polymer block (C) is inserted between the polymer block (A) and the polymer block (B). As a structure of the polymer block in which the polymer block (A) and the polymer block (B) is non-contiguously bonded, for example, A-C-B type triblock copolymer, B-C-A type triblock copolymer, A-C-B-A type tetrablock copolymer, A-B-C-A type tetrablock copolymer, B-C-A-B type tetrablock copolymer, B-A-C-B type tetrablock copolymer, A-B-C-A-B type pentablock copolymer, A-C-B-C-A type pentablock copolymer, B-A-C-B-A type pentablock copolymer, and B-C-A-C-B type pentablock copolymer and the like can be exemplified. Further, another polymer block (A), the polymer block (B) and the polymer block (C) may be bonded to the above mentioned triblock, tetrablock or pentablock copolymer.

When the present $\pi$-electron conjugated block copolymer includes the polymer block (C), the percentage of the polymer block (C) in the block copolymer is preferably 40% by mass or less. The polymer block (C) is a non-$\pi$-electron conjugated block copolymer, so that considering that it does not contribute to photoelectric conversion, the percentage is preferably less than 30% by mass or less, still more preferably 20% by mass or less.

As examples of manufacturing methods of the present $\pi$-electron conjugated block copolymers, reaction steps and production methods will be described in detail below.

The present $\pi$-electron conjugated block copolymer can be produced by sequentially polymerizing a polymer block (A) and a polymer block (B) using a pseudo-living polymerization (hereinafter, sometimes referred to as "sequential polymerization method"). As a second method, the polymer block (B) and the polymer block (A) are separately synthesized, then they are bonded to each other (hereinafter sometimes referred to as "bonding method"). As a third method, block polymers (A) and (B) are polymerized in the presence of the polymer blocks (A) and (B) respectively (hereinafter sometimes referred to as "macroinitiator method"). An optimal polymerization method can be selected from the sequential polymerization method, the bonding method, and the macroinitiator method based on an intended type of the $\pi$-electron conjugated block copolymer.

When polythiophene is used as the main skeleton of both the polymer block (A) and the polymer block (B), the sequential polymerization method is effectively used. Basic polymerization reaction is described below. Incidentally, the order of preparing the polymer blocks may be selected arbitrarily based on the type of an intended $\pi$-electron conjugated

polymer block. Polymer block (B) may be prepared at first and then polymer block (A) may be prepared.

In an inert solvent, a monomer represented by the following chemical formula (I)

X-W-X (I)

(in the formula (I), W is a divalent thienylene group that may have a substituent, X is a halogen atom, both of X may be the same or different) and Grignard reagent represented by the following chemical formula (II)

R'-MgX (II)

(in the formula (II), R' is an alkyl group having a carbon number of 1 - 10; X is a halogen atom) are exchange-reacted by the Grignard metathesis reaction with an organomagnesium halide compounds represented by the chemical formula (II) above to obtain an organomagnesium compound represented by the following chemical formula (III).

X-W-MgX (III)

(in the formula (III), W is a divalent thienylene group that may have a substituent; X is a halogen atom; both of X may be identical or different from each other)

A $\pi$-conjugated polymer is obtained in a solvent from the obtained organomagnesium compound (III) in the presence of a metal complex catalyst by the so-called coupling reaction. A series of reactions are shown in the reaction formula (IV).

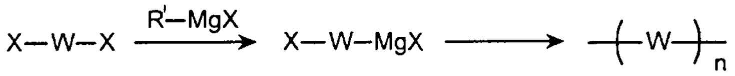


· · · (IV)

The compound represented by the chemical formula (I) is a polymer precursor needed to produce a polymer block, and is more specifically represented by the chemical formula (1-1) below.

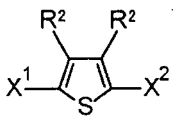

· · · (1 — 1)

In the formula (1-1), $R^2$ is each independently a hydrogen atom or substituent $R^{nA}$ which is an alkyl group having 1 - 18 carbon atoms, or substituent $R^{nB}$ which is an alkyl group having 1 - 8 carbon atoms that may be substituted with an alkoxy group, a halogen atom, a hydroxyl group, an amino group, a thiol group, a silyl group, an ester group, an aryl group or a heteroaryl group. A plurality of $R^2$ may be the same or different from each other, and $X^1$, $X^2$ are bromine or iodine.

For example, a monomer unit of the formula (1-1) in which $X^1$ is iodine, $X^2$ is bromine, $R^2$ at 3-position of thiophene ring is an n-hexyl group, and $R^2$ at 4-position of thiophene ring is a hydrogen atom, can be synthesized through coupling of 3-bromothiophene with bromohexyl, then through bromination with N-bromosuccinimide, and then iodination with iodine. For more information, refer to A. Yokoyama, R. Miyakoshi, T. Yokozawa, Macromolecules, 40, p.4093 (2007).

Next, a bonding method will be precisely described. As shown in the following reaction formula (V), the $\pi$-electron conjugated block copolymer of the present invention can be produced through coupling reaction in the presence of a catalyst between a compound A-X having polymer block (A) and a compound B-$M^p$ having polymer block (B).

$$A\text{-}X + B\text{-}M^p \rightarrow A\text{-}B \qquad (V)$$

In the formula (V), A and B represent polymer blocks, X is a halogen atom, $M^p$ is boronic acid, boronic ester, -MgX, -ZnX, -$SiX_3$ or -$SnRa_3$ (where Ra is a straight-chain alkyl group having 1 - 4 carbon atoms).

The terminal substituent of the polymer block (A) may be swapped with the terminal substituent of the polymer block (B), as shown in the following reaction formula (VI), because the coupling reaction between the compound B-X having the polymer block (B) and the compound A-$M^p$ having the polymer block (A) can be conducted in the presence of the catalyst.

$$B\text{-}X + A\text{-}M^p \rightarrow A\text{-}B \qquad (VI)$$

In the formula (VI), A, B, X and $M^p$ are the same as defined above.

Next, the macroinitiator method will be explained. The macroinitiator method is a method of carrying out the polymerization of the polymer block (B) in the presence of compound A-X or A-$M^p$ that has the polymer block (A) at an early or a medium stage of polymerization of the polymer block (B). It is also possible to carry out polymerization of the polymer block (A) in the presence of compound B-X or B-$M^p$ that has the polymer block (B) at an early or a medium stage of polymerization of the polymer block (A). Optimal processing order can be determined for the intended purpose of the $\pi$-electron conjugated block copolymer.

In more detail, as shown in the reaction formula according to (VII) and in the presence of compound A-X having a polymer block (A) and a catalyst, reaction between $M^{q1}$-Y-$M^{q1}$ and $M^{q2}$-Z-$M^{q2}$ which are monomers of the polymer block (B) can be carried out, to bond the end of the polymer block (A) to the polymer block (B) itself or to a monomer to be used for the polymer block (B) through a coupling reaction during the polymerization, obtaining a $\pi$-electron conjugated block copolymer of the present invention. Further, in the presence of a catalyst and a compound A-$M^p$ having a polymer block (A), and according to the following reaction formula (VIII), $M^{q1}$-Y-$M^{q1}$ and $M^{q2}$-Z-$M^{q2}$ which are monomers of the polymer block (B) are reacted, to bond the end of the polymer block (A) to the polymer block (B) or to a monomer to be used for the polymer block (B) through a coupling reaction during the polymerization, obtaining the present $\pi$-electron conjugated block copolymer.

Similarly, as shown in the reaction formula according to (VII) and in the presence of compound B-X having a polymer block (B) and a catalyst, reaction between $M^{q1}$-Y-$M^{q1}$ and $M^{q2}$-Z-$M^{q2}$ which are monomers of a polymer block (A) is carried out, to bond the end of the polymer block (B) to the polymer block (A) itself or to a monomer to be used for the polymer block (A) through a coupling reaction during the polymerization, obtaining the present $\pi$-electron conjugated block copolymer.

Further, in the presence of a catalyst and compound B-$M^p$ having a polymer block (B), and according to the following reaction formula (VIII), $M^{q1}$-Y-$M^{q1}$ and $M^{q2}$-Z-$M^{q2}$ which are monomers of a polymer block (A) are reacted, to bond the end of the polymer block (B) to the polymer block (A) or to a monomer to be used for the polymer block (A) through a coupling reaction during the polymerization, obtaining the present $\pi$-electron conjugated block copolymer. Here, Y and Z show heteroaryl skeletons that constitute at least a part of the monomer unit of the present $\pi$-electron conjugated block copolymer. For example, the skeleton is a heteroaryl skeleton having one of groups represented by, for example, the chemical formulas (1) - (19).

$$M^{q1}\text{—Y—}M^{q1} + M^{q2}\text{—Z—}M^{q2} \xrightarrow{\text{A—X or B—X}} \text{A—B} \quad \cdots \text{(VII)}$$

$$M^{q1}\text{—Y—}M^{q1} + M^{q2}\text{—Z—}M^{q2} \xrightarrow{\text{A—}M^p\text{ or B—}M^p} \text{A—B} \quad \cdots \text{(VIII)}$$

In the formulas (VII) and (VIII), A, B, X and $M^p$ are the same as defined above. $M^{q1}$ and $M^{q2}$ are not identical but are each independently a halogen atom, boronic acid, a boronic ester, -MgX, -ZnX, -$SiX_3$ or -$SnRa_3$ (Ra is a straight-chain alkyl group having 1 - 4 carbon atoms, X is the same as defined above). That is, when $M^{q1}$ is designated as a halogen atom, $M^{q2}$ becomes a boronic acid, boronic acid ester, -MgX, -ZnX, -$SiX_3$ or -$SnRa_3$. When $M^{q2}$ is, on the contrary, designated as a halogen atom, the $M^{q1}$ becomes a boronic acid, boronic acid ester, -MgX, -ZnX, -$SiX_3$ or -$SnRa_3$. Y and Z represent a heteroaryl skeleton that constitutes at least a part of monomer unit of the present $\pi$-electron conjugated block copolymer. A-B that is a product of the reaction formula is a block copolymer including the copolymer of Y and Z.

Compound A-X or A-$M^p$ that has a polymer block (A), or compound B-X or B-$M^p$ that has a polymer block (B) can be prepared through a so-called coupling reaction, in the presence of a catalyst, according to the following reaction formulas (IX) and (X), between $M^{q1}$-Y-$M^{q1}$ and $M^{q2}$-Z-$M^{q2}$ which are monomers.

$$M^{q1}\text{-Y-}M^{q1} + M^{q2}\text{-Z-}M^{q2} \rightarrow \text{A-X or B-X} \qquad \text{(IX)}$$

$$M^{q1}\text{-Y-}M^{q1} + M^{q2}\text{-Z-}M^{q2} \rightarrow \text{A-}M^{p}\ {}^{p}\text{ or B-}M^p \qquad \text{(X)}$$

When prepared in this manner, X or $M^p$ from the compound A-X, A-$M^p$, B-X and B-$M^p$ become the terminal functional groups of a polymer block (A) or a polymer block (B), usually become functional groups derived from the monomer of $M^{q1}$-Y-$M^{q1}$ and $M^{q2}$-Z-$M^{q2}$.

A polymer block (A) or a polymer block (B) can be prepared by carrying out a coupling reaction using compounds showed by the compound $M^{q1}$-Y-$M^{q1}$ and $M^{q2}$-Z-$M^{q2}$ and a compound represented by the formula of Ar- $M^r$ (hereinafter

referred to as "endcapping agent"). However, Ar is an aryl group, $M^r$ represents $M^p$ or X, and $M^p$ and X have the same meaning as defined above. It is, accordingly, easy to introduce a functional group at only one of terminal groups of the polymer block (B) and the polymer block (A) like in the same manner as seen in the compound A-X, compound B-X, compound A-$M^p$ and compound B-$M^P$.

X or $M^p$ of compounds A-X, A-$M^P$, B-X and B-$M^p$ may be functional groups derived from the $M^{q1}$-Y-$M^{q1}$ or $M^{q2}$-Z-$M^{q2}$ which are the monomers of the polymer block (A) or the polymer block (B), or may be functional group originated from a linker composition $M^r$-Q-$M^r$ which is different from the monomer of the polymer block (A) or the polymer block (B). However, Q is an arylene group, $M^r$ represents $M^p$ or X, and $M^p$ and X are the same as defined above.

Preferably, Q is a divalent monocyclic arylene from the viewpoint of availability and reactivity. A divalent thiophene or benzene which may have a substituent is more preferable. As specific examples, for example, 2,5-dibromothiophene, 2,5-bis(trimethyltin)thiophene, 2,5-thiophenediboronic acid, 2,5-bis(3,3,4,4-tetramethyl-2,5,1-dioxaborolane-1-yl)thiophene, p-dibromobenzene, p-bis(trimethyltin)benzene, p-benzendiboronic acid, p-bis(3,3,4,4-tetramethyl-2,5,1-dioxaborolane-1-yl)benzene, etc. are exemplified.

When the compound A-X or A-$M^p$ or the compound B-X or B-$M^p$ is produced on the reaction formulas (IX) and (X), it is possible to introduce preferentially either $M^p$ or X as the terminal functional group by excessively charging either monomer of $M^{q1}$-Y-$M^{q1}$ or $M^{q2}$-Z-$M^{q2}$. However, since the polymerization does not proceed if either $M^{q1}$-Y-$M^{q1}$ or $M^{q2}$-Z-$M^{q2}$ is used too much, the preferable molar ratio of $M^{q1}$-Y-$M^{q1}$ to $M^{q2}$-Z-$M^{q2}$ is in the range of 0.5 - 1.5 and more preferably 0.7 - 1.3.

In addition to the above method, at an early, middle or late stage of polymerization between monomer $M^{q1}$-Y-$M^{q1}$ and monomer $M^{q2}$-Z-$M^{q2}$, it is possible to add an excessive amount of $M^{q1}$-Y-$M^{q1}$, $M^{q2}$-Z-$M^{q2}$ or a linker compound $M^r$-Q-$M^r$ to preferentially introduce X or $M^p$ which is derived from the monomer or the linker compound. The amount of $M^{q1}$-Y-$M^{q1}$, $M^{q2}$-Z-$M^{q2}$ or the linker compound $M^r$-Q-$M^r$ added is 1.5 times or more equivalent, preferably 2 times or more equivalent, more preferably 5 times or more equivalent of the terminal functional group calculated from a number average molecular weight (Mn) of a polymer block (A) or a polymer block (B) during polymerization.

The polymer block (B) includes a copolymer block comprising two or more types of monomer units each having different substituent $R^{nB}$ from each other and each having the same heteroaryl skeleton that constitutes the main chain of the monomer unit, and also includes a copolymer block comprising two or more types of monomer units each having different substituents $R^{nB}$ from each other and each having different heteroaryl skeleton that constitutes the main chain of the monomer unit. When the polymer block (B) is synthesized by the sequential polymerization method and the bonding method, the polymer block (B) can be produced by adding two or more types of monomers simultaneously. It is possible to configure the ratio of monomer units in the polymer block (B) by controlling the amount of monomers to be added. Obtained polymer block (B) can be a multiblock copolymer, a random copolymer or a gradient copolymer comprising two or more types of monomer units.

The term of random copolymer in the present invention means a copolymer block in which multiple type monomer units having the same or different heteroaryl skeleton that constitutes the main chain of the monomer unit, and having different substituents $R^{nB}$, is bonded randomly. Note that as long as the copolymer has a plurality of certain repeating structures within the polymer, a structure of a bonding of a plurality of heteroaryls such as thiophene, fluorene, carbazole, dibenzosilole, and dibenzogermole is included as the monomer unit of the present invention. For example, in the present invention, the monomer unit of -a-b- is considered to be one of the monomer units. That is, in the present invention, completely alternating copolymer block comprising a monomer unit of -a- and a monomer unit of -b- is not considered to be a random copolymer.

The polymer block (B) can be synthesized by the sequential polymerization method and the bonding method using at least two types of monomer units each having a different substituent of $R^{nB}$ that is different from each other and selected from an alkoxy group or an alkyl group having 1 - 18 carbon atoms which may be substituted with an alkoxy group, a halogen atom, a hydroxy group, an amino group, a thiol group, a silyl group or a heteroaryl group. However, among those groups such as an alkoxy group, a halogen atom, a hydroxyl group, an amino group, a thiol group, a silyl group and a heteroaryl group, especially those such as a hydroxyl group, an amino group, a thiol group and a heteroaryl group may inhibit the coupling reaction. However, even in such cases, it is possible to obtain the desired $\pi$-electron conjugated block copolymer by suitably protecting a hydroxyl group, an amino group, a thiol group and a heteroaryl group, or modifying thereof after the completion of the coupling reaction. For example, a hydroxyl group can be protected by a benzyl group or a tetrahydropyranyl group, and an amino group can be protected by a benzyloxycarbonyl group or a t-butyloxycarbonyl group, etc. After the coupling reaction, deprotection can be carried out. Concerning the thiol group, for example, a monomer having a halogen atom, more preferably a bromine atom-substituted alkyl group or alkoxy group is subjected to the coupling reaction, and then the halogen atom is substituted with thioacetic acid and subsequently hydrolyzed to carry out the introduction. Of course, it is not limited to these methods, an appropriate method can be used depending on an intended purpose.

It is necessary to use a complex of a transition metal as a catalyst for the three methods of the sequential polymerization method, the bonding method and a macroinitiator method. Usually, a complex of a transition metal (group

3 - 10, especially group 8 - 10 of the periodic table, long form periodic table arranged according to 18 groups) are exemplified. Specifically, publicly known complexes of Ni, Pd, Ti, Zr, V, Cr, Co, Fe, etc. are exemplified. Among them, Ni complex and Pd complex are more preferable.

Further, as a ligand of the complex to be used, a monodentate phosphine ligand such as trimethylphosphine, triethylphosphine, triisopropylphosphine, tri-t-butylphosphine, tricyclohexylphosphine, triphenylphosphine, tris(2-methylphenyl)phosphine; a bidentate phosphine ligand such as diphenylphosphino methane (dppm), 1,2-diphenylphosphino ethane (dppe), 1,3-diphenylphosphino propane (dppp), 1,4-diphenylphosphino butane (pddb), 1,3-bis(dicyclohexylphosphino)propane (dcpp), 1,1'-bis(diphenylphosphino)ferrocene (dppf), 2,2-dimethyl-1,3-bis(diphenylhosphino)propane, etc.; a nitrogen-containing ligand such as tetramethylethylenediamine, bipyridine, acetonitrile, etc. are preferably contained.

In the sequential polymerization, the bonding method and the macroinitiator method, the amount of the complex to be used is depending on the type of the $\pi$-electron conjugated block copolymer, 0.001 - 0.1 mol for the monomer is preferably used. When the amount of catalyst is excessively used, molecular weight of the polymer becomes low and it is economically disadvantageous. On the other hand, the amount of catalyst is added too small, reaction rate becomes deteriorated, causing difficulty in stable production.

The present $\pi$-electron conjugated block copolymer can be preferably prepared in the presence of solvent. The type of the solvent should be used selectively depending on the type of $\pi$-electron conjugated block copolymer. However, generally available solvent can be selected and used for the processes of the sequential polymerization method, the bonding method and the macroinitiator method. For example, ether solvents such as tetrahydrofuran, 2-methyltetrahydrofuran, 1,4-dioxane, dimethyl ether, ethyl methyl ether, diethyl ether, dipropyl ether, butyl methyl ether, t-butyl methyl ether, dibutyl ether, cyclopentyl methyl ether, diphenyl ether, and the like; aliphatic or alicyclic saturated hydrocarbon solvents such as pentane, hexane, heptane cyclohexane, and the like; aromatic hydrocarbon solvents such as benzene, toluene, xylene, and the like; alkyl halide solvents such as dichloromethane, chloroform, and the like; aromatic aryl halide solvents such as chlorobenzene, dichlorobenzene, and the like; amide solvents such as dimethylformamide, diethyl formamide, N-methylpyrrolidone, and the like; and water and mixtures thereof are exemplified.

The amount of the organic solvent to be used is preferably in the range of 1 - 1,000 times by weight for a monomer of the $\pi$-electron conjugated block copolymer, and preferably is 10 times by weight or more from the point of view of stirring efficiency of the reaction mixture and solubility of the bonding body. It is preferably in the range of 100 times or less by weight from the viewpoint of reaction rate.

The polymerization temperature varies depending on the type of the $\pi$-electron conjugated block copolymer. The sequential polymerization method, the bonding method and the macroinitiator method are generally carried out at temperature in the range of -80°C - 200°C. There is no specific limit for reaction pressure, but the pressure is preferably in the range of 0.1 - 10 atms. Generally, reaction is carried out at about 1 atm. The reaction time varies depending on the type of the polymer block (A) or polymer block (B) being produced, but is usually 20 minutes - 100 hours.

The $\pi$-electron conjugated block copolymer that can be synthesized by sequential polymerization method, bonding method or macroinitiator method can be obtained by, for example, reprecipitation, removal of the solvent under heating, a reduced pressure, or by steaming (steam stripping).

These steps are usually processed to separate the block copolymer from reaction mixtures and by-products. The obtained crude product can be purified by extracting or washing with generally commercially available solvents using a Soxhlet extractor. For example, ether solvents such as tetrahydrofuran, 2-methyltetrahydrofuran, 1,4-dioxane, dimethyl ether, ethyl methyl ether, diethyl ether, dipropyl ether, butyl methyl ether, t-butyl methyl ether, dibutyl ether, cyclopentyl methyl ether, diphenyl ether and the like; aliphatic or alicyclic saturated hydrocarbon solvents such as pentane, hexane, heptane and cyclohexane; aromatic hydrocarbon solvents such as benzene, toluene, xylene, and the like; ketone solvents such as acetone, ethyl methyl ketone, diethyl ketone, and the like; halogenated alkyl solvents such as dichloromethane, chloroform, and the like; aromatic aryl halide solvents such as chlorobenzene and dichlorobenzene, and the like; amide solvents such as dimethylformamide, diethyl formamide, N-methylpyrrolidone, and the like; and water and mixtures thereof are exemplified.

The present $\pi$-electron conjugated block copolymer may have a coupling residue as a terminal group such as a halogen atom, a trialkyl tin group, boronic acid group, boronic acid ester group, or a desorbed hydrogen atom that is caught by the atoms or the groups mentioned above. Further, these terminal groups may become a terminal structure substituted by an endcapping agent comprising aromatic boronic acid compounds or aromatic halides such as benzene bromide etc.

As long as the effect of the present invention is not impaired, a homopolymer and a random polymer of components such as the polymer block (A) and the polymer block (B) may be remained on the $\pi$-electron conjugated block copolymer. These residual components are preferably 70% or less.

The present $\pi$-electron conjugated block copolymer can be used in the photoelectric conversion active layer of the photoelectric conversion element by providing a composition containing an electron accepting material. If the electron accepting material in the composition has n-type semiconductor characteristics, any electron accepting material

can be used.

For example, oxazole derivatives such as 1,4,5,8-naphthalenetetracarboxylic dianhydride (NTCDA), 3,4,9,10-perylenetetracarboxylic dianhydride (PTCDA), N,N'-dioctyl-3,4,9,10-naphthyl tetracarboxylic diimide (NTCDI-C8H), 2-(4-biphenylyl)-5-(4-t-butylphenyl)-1,3,4-oxadiazole, 2,5-di(1-naphthyl)-1,3,4-oxadiazole, etc.; triazole derivatives such as 3-(4-biphenylyl)-phenyl-5-(4-t-butylphenyl)-1,2,4-triazole, etc.; phenanthroline derivatives, $C_{60}$ or $C_{70}$ fullerene derivative, carbon nanotubes (CNT), derivatives (CN-PPV) obtained by introducing a cyano group into a poly(p-phenylene vinylene) polymers, etc. are exemplified. These may be used alone respectively, or used by mixing two or more thereof. Among them, the fullerene derivative is preferably used from the viewpoint of n-type semiconductors with excellent carrier mobility and stability.

As fullerene derivatives preferably used as electron accepting organic semiconductor, non-substituted one's such as $C_{60}$, $C_{70}$, $C_{76}$, $C_{78}$, $C_{82}$, $C_{84}$, $C_{90}$, $C_{94}$, substituted ones such as [6,6]-phenyl $C_{61}$ butyrick acid methyl ester ([6,6]-$C_{61}$-PCBM), [5,6]-phenyl $C_{61}$ butyric acid methyl ester, [6,6]-phenyl $C_{61}$ butyric acid n-butyl ester, [6,6]-phenyl $C_{61}$ butyric acid i-butyl ester, [6,6]-phenyl $C_{61}$ butyric acid hexyl ester, [6,6]-phenyl $C_{61}$ butyric acid dodecyl ester, [6,6]-diphenyl $C_{62}$ bis(butyric acid methyl ester) ([6,6]-$C_{62}$-bis-PCBM), [6,6]-phenyl $C_{71}$ butyric acid methyl ester ([6,6]-$C_{71}$-PCBM) are exemplified.

The fullerene derivatives mentioned above can be used alone or as a mixture thereof, but from the viewpoint of solubility in organic solvents, [6,6]-$C_{61}$-PCBM, [6,6]-$C_{62}$-bis-PCBM, [6,6]-$C_{71}$-PCBM are preferably used.

A photoelectric conversion element of the present invention comprises an organic photoelectric conversion layer which is provided from the composition comprising the $\pi$-electron conjugated block copolymer and electron accepting materials, and is capable of generating electricity due to function of the layer provided from the composition.

The ratio of the electron accepting material in the composition, is 10 - 1,000 parts by weight against 100 parts by weight of the $\pi$-electron conjugated block copolymer, more preferably 50 - 500 parts by weight.

A mixing method of the $\pi$-electron conjugated block copolymer and the electron accepting materials is not particularly limited, but after the addition of a solvent in a desired ratio, the mixture is subjected to one or more processes including processes of heating, stirring, ultrasonic irradiation, etc. to dissolve them into the solvent, is exemplified.

The solvent should be selected from the viewpoint of solubility in 20°C of the $\pi$-electron conjugated block copolymer and the electron accepting material. Preferable solubility at 20°C is 1 mg/mL or more from the viewpoint of forming the organic thin film. In the case of a solubility of less than 1 mg/mL, it is difficult to produce a homogeneous organic thin film, accordingly it is impossible to obtain a composition of the present invention. Furthermore, from the viewpoint of arbitrarily controlling the film thickness of the organic thin film, a solvent having the solubility of 3 mg/mL or more at 20°C for the $\pi$-electron conjugated block copolymer and the electron accepting material, is preferably used. Further, the boiling points of these solvents are preferably from the viewpoint of the manufacturing process in the range of room temperature to 200°C.

As the above solvents, tetrahydrofuran, 1,2-dichloroethane, cyclohexane, chloroform, bromoform, benzene, toluene, o-xylene, chlorobenzene, bromobenzene, iodobenzene, o-dichlorobenzene, anisole, methoxybenzene, trichlorobenzene, pyridine, and the like are exemplified. Well, these solvents may be used alone or may be used by mixing two or more. Especially o-dichlorobenzene, chlorobenzene, bromobenzene, iodobenzene, chloroform, and the mixtures of them are preferable used, because the solubility of the $\pi$-electron conjugated block copolymer and of the electron accepting material is high. More preferably, o-dichlorobenzene, chlorobenzene, or the mixtures thereof are used.

Other than the $\pi$-electron conjugated block copolymer and the electron accepting material, additives having a boiling point higher than that of the solvent may be added into the solution described above. By the presence of the additives, fine and continuous phase-separated structure of the $\pi$-electron conjugated block copolymer and the electron accepting material can be formed during an organic thin film-forming process. Accordingly, it is possible to obtain an active layer excellent in photoelectric conversion efficiency. As the additives, octanedithiol (boiling point: 270°C), dibromooctane (boiling point: 272°C), diiodooctane (boiling point: 327°C) and the like are exemplified.

To the composition which is used in the photoelectric conversion element of the present invention, other additives such as binder resins, surfactants, fillers, etc. may be added to an extent that does not impair the object of the present invention.

The amount of the additives to be added is not particularly limited as long as the $\pi$-electron conjugated block copolymer and an electron accepting material are not precipitated and a homogeneous solution is given, but the addition amount is preferably in the range of 0.1 - 20% by volume of the solvent. When additives are added in less than 0.1%, it is impossible to obtain a sufficient effect in continuous fine phase separation structure, on the contrary when more than 20%, drying rate becomes slow, so that it is difficult to obtain a homogeneous organic thin film. More preferably, the amount of additives is in the range of 0.5% - 10%.

The thickness of the organic photoelectric conversion layer usually is in the range of 1 nm - 1 $\mu$m, preferably in the range of 2 nm - 1,000 nm, more preferably 5 nm - 500 nm, still more preferably 20 nm - 300nm. Light is not absorbed sufficiently if the film thickness is too thin. The carrier does not easily reach to an electrode if the film is too thick on the contrary.

Coating method of the solution containing the $\pi$-electron conjugated block copolymer and the electron accepting material, on a substrate or support board is not particularly limited. Any conventionally known coating methods using liquid type coating materials can be employed. For example, any coating method such as a dip coating method, a spray coating method, an ink jet method, an aerosol jet method, a spin coating method, a bead coating method, a wire bar coating method, a blade coating method, a roller coating method, a curtain coating method, a slit die coater method, a gravure coater method, a slit reverse coater method, a micro gravure method, and a comma coater method, etc. can be employed depending on the coating characteristics such as alignment control, coating thickness, etc.

The organic photoelectric conversion layer may be additionally subjected to thermal annealing, if necessary. The thermal annealing of an organic thin film on the substrate is performed by holding the desired temperature.

The thermal annealing may be performed under an inert gas atmosphere or under reduced pressure. Preferred temperature is 40°C - 300°C, more preferably, 70°C - 200°C. Sufficient effect is not obtained when the temperature is low. When temperature is too high, oxidation and/or degradation occurs in the organic thin film, sufficient photoelectric conversion characteristics are not obtained. The thermal annealing process may be performed after forming all of the electrodes as described below.

Substrates on which a photoelectric conversion element is formed, may be any film or plate which does not change when forming the organic photoelectric conversion layer and electrodes. For example, inorganic material such as non-alkali glass or quartz glass, metal film such as aluminum, organic material such as polyester, polycarbonate, polyolefin, polyamide, polyimide, polyphenylene sulfide, polyparaxylene, epoxy resin, fluorine resin, etc. can be used. In the case of using an opaque substrate, the opposite electrode (i.e., the electrode that is located far from the substrate) that is transparent or semi-transparent is preferably used. The thickness of the substrate is not particularly limited, but is usually in the range of 1 $\mu$m - 10 mm.

Light permeability is necessary for either one of positive or negative electrode of the photovoltaic element. As long as incident light reaches the organic photoelectric conversion layer and generates the electromotive forces, the light transmittance of the electrode is not particularly limited. The thickness of the electrode is depending on electrode materials, but is not particularly limited, however preferably 20 nm - 300 nm as long as the electrode is electrically conductive and optically transparent. The light transmissive property is not required for the other electrode as long as the other electrode is electrically conductive. The thickness thereof is not particularly limited.

As the positive or the negative electrode, metal such as lithium, magnesium, calcium, tin, gold, platinum, silver, copper, chromium, nickel etc.; as an transparent electrode, metal oxide such as indium, tin, etc.; complex metal oxide such as indium tin oxide (ITO), indium zinc oxide (IZO), fluorine-doped tin oxide (FTO), etc.; are preferably used. A grid electrode which is transparent because of using a mesh metal, an organic transparent conductive film made from polyaniline or its derivatives or made from polythiophene or its derivatives, may be used. As a manufacturing method of the positive electrode, vacuum deposition method, sputtering method, ion plating method, plating method and the like are exemplified. The positive electrode can also be manufactured by coating method using metal ink, metal paste, low melting point metal, organic conductive ink, etc.

It is also possible to improve the output current by introducing, between the organic photoelectric conversion layer and the negative electrode, metal fluoride such as lithium fluoride, sodium fluoride, potassium fluoride, magnesium fluoride, calcium fluoride, and cesium fluoride, more preferably lithium fluoride or cesium fluoride.

The photoelectric conversion element may be provided with a hole transport layer between the organic photoelectric conversion layer and the positive electrode as needed. As a material for forming the hole transport layer is not particularly limited as long as it has a p-type semiconductor properties. Conductive polymers such as polythiophene containing polymer, polyaniline containing polymer, poly(p-phenylene vinylene)containing polymer, polyfluorene containing polymer, etc.; low molecular weight organic compounds showing p-type semiconductor properties such as porphyrin derivatives and phthalocyanine derivatives such as phthalocyanine, copper phthalocyanine, and zinc phthalocyanine etc.; metal oxides such as molybdenum oxide, zinc oxide, vanadium oxide, etc. are preferably used. The thickness of the hole transport layer is preferably in the range of 10 nm - 600 nm, more preferably 20 nm - 300 nm.

An electron transport layer may be provided between the active layer and the negative electrode if necessary. A material for forming the electron transport layer is not particularly limited as long as it has n-type semiconductor characteristics. The electron accepting organic material described above, for example, NTCDA, PTCDA, NTCDI-C8H, oxazole derivatives, triazole derivatives, phenanthroline derivatives, fullerene derivatives, CNT, CN-PPV are preferably used. The thickness of the electron transport layer is preferably in the range of 1 nm - 600 nm, more preferably 5 nm - 100 nm.

When producing a hole transport layer between the active layer and the positive electrode, for example, in the case of the conductive polymer is soluble in a solvent it can be applied by coating method such as dip coating method, a spray coating method, an inkjet method, an aerosol jet method, a spin coating method, a bead coating method, a wire bar coating method, a blade coating method, a roller coating method, a curtain coating method, a slit die coater method, a gravure coater method, a slit reverse coater method, micro gravure method, comma coater method, etc. When using the low molecular organic material such as porphyrin derivative or a phthalocyanine derivative, it can be preferable

applied by a deposition method using a vacuum deposition device. The electron transport layer can be produced in the same manner as described above.

The photoelectric conversion element is applicable to various photoelectric conversion devices having photoelectric conversion function, and optical rectification function, etc. such as, for example, photovoltaic cells such as solar cells, etc.; electric devices such as light sensors, light switches, photo transistors, etc.; and optical recording materials such as optical memories, etc.

EMBODIMENTS

Embodiments of the present invention are described in detail, but the scope of the present invention is not limited by these embodiments.

Physical properties measurement and purification of the materials produced in the respective steps described above and the materials produced in the following steps were carried out as follows.

[Number Average Molecular Weight • Weight Average Molecular Weight]

Number average molecular weight (Mn) and weight average molecular weight (Mw) is determined based on the measurement of gel permeation chromatography (GPC), obtained in terms of polystyrene converted values, using a GPC apparatus (HLC-8320, trade name, produced by Tosoh Corporation.) and two columns connected in series (TSKgel Multipore HZ, trade name, produced by Tosoh Corporation).

[Purification of Polymers]

Purification of the obtained polymers was carried out using a preparative GPC column. A chromatograph apparatus (Recycling Preparative HPLC LC-908 produced by Japan Analytical Industry Co., Ltd.) is used. Two columns (2H-40 and 2.5H-40, produced by Japan Analytical Industry Co., Ltd.) were connected in series (elution solvent: chloroform).

[Purification of Solvent (THF)]

Dehydrated tetrahydrofuran (THF (Stabilizer Free), produced by Wako Pure Chemical Industries, Ltd.) was distilled and purified in the presence of sodium metal. After distillation, the solvent was contacted with molecular sieves 5A (produced by Wako Pure Chemical Industries, Ltd.) for more than one day.

[$^1$H-NMR Measurement]

$^1$H-NMR measurement was carried out using NMR spectrometer (JEOL JNM-EX270FT produced by JEOL Ltd.). Unless otherwise indicated, $^1$H-NMR measurement was carried out at room temperature and at 270 MHz with chloroform ($CDCl_3$).

[Synthesis Example 1]

A monomer represented by the following chemical formula (i) was synthesized.

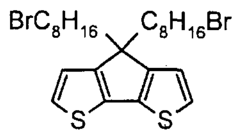

· · · ( i )

Under a nitrogen atmosphere, cyclopenta[2,1-b:3,4-b']dithiophene (0.36 g, 2.0 mmol) and tetrahydrofuran (30 mL) were charged into a 100 mL three-necked flask and cooled to below 0°C. Then 1.6M solution of n-butyl lithium in hexane (1.38 mL, 2.2 mmol) was slowly added dropwise, followed by stirring for 1 hour after the temperature was raised to room temperature. After the temperature was cooled down again to 0°C, 8-bromo-1-iodo-octane (0.64 g, 2.0 mmol) was added, followed by stirring for 1 hour. Then 1.6M solution of n-butyl lithium in hexane (1.38 mL, 2.2 mmol) was slowly added dropwise. After the temperature was raised to room temperature, stirring was continued for 1 hour. After the temperature was cooled down again to 0°C, 8-bromo-1-iodo-octane (0.64 g, 2.0 mmol) was added, followed by stirring for 1 hour. After completion of the reaction, the reacted mixture was poured into saturated brine (100 mL) and

extracted with ethyl acetate (30 mL × 3), washed with water (30 mL × 3). The obtained organic layer was dried over sodium sulfate and then solvent was evaporated under reduced pressure. The obtained crude product was purified using silica gel column chromatography (hexane), obtaining a pale yellow solid of 4,4-bis(8-bromooctyl)cyclopenta[2,1-b:3,4-b']dithiophene (0.88 g, 78%) which is represented by the chemical formula (i).
$^1$H-NMR: δ = 7.12 (d, J = 4.9 Hz, 2H), 7.07 (d, J = 4.9 Hz, 2H), 3.15 (t, J = 7.0 Hz, 4H), 2.33 - 2.10 (m, 4H), 1.52 - 1.41 (m, 12H), 1.38 - 1.09 (m, 16H)
MS (GC-MS) m / z = 560 (M +)

[Synthesis Example 2]

A monomer represented by the following chemical formula (ii) was synthesized.

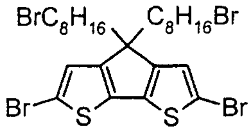

· · · (ii)

Under a nitrogen atmosphere, the compound (0.62 g, 1.1 mmol) represented by formula (i) and tetrahydrofuran (13 mL) were charged into a 100 mL three-necked flask, and then cooled to below 0°C. Then, N-bromosuccinimide (0.39 g, 2.2 mmol) was added slowly, followed by stirring for 1 hour below 0°C. The temperature was raised to room temperature. After completion of the reaction, the reacted mixture was poured into saturated brine (100 ml), extracted with hexane (30 mL × 3), and then washed with water (30 mL × 3). The obtained organic layer was dried over sodium sulfate, then solvent was evaporated under reduced pressure, obtaining a crude product that was purified using silica gel column chromatography (hexane) to obtain a yellow solid of 2,6-dibromo-4,4-bis(8-bromooctyl)cyclopenta[2,1-b:3,4-b']dithiophene (0.7 g, 88%) that is represented by the chemical formula (ii).
$^1$H-NMR: δ = 6.94 (s, 2H), 3.15 (t, J = 7.0 Hz, 4H), 2.35 - 2.12 (m, 4H), 1.54 - 1.40 (m, 12H), 1.37 - 1.06 (m, 16H)
MS (GC-MS) m / z = 718 (M +)

[Synthesis Example 3]

A monomer represented by the following chemical formula (iii) was synthesized.

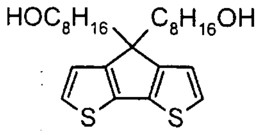

· · · (iii)

Under a nitrogen atmosphere, cyclopenta[2,1-b:3,4-b']dithiophene (0.36 g, 2.0 mmol) and tetrahydrofuran (30 mL) were charged into a 100 mL three-necked flask and then cooled to below 0°C. Then 1.6M solution of n-butyl lithium in hexane (1.38 mL, 2.2 mmol) was added dropwise slowly. The temperature was raised to room temperature, followed by stirring for 1 hour. The temperature was cooled down again to below 0°C. 8-bromooctane-1-ol (0.42 g, 2.0 mmol) was added, followed by stirring for 1 hour. Then 1.6M solution of n-butyl lithium in hexane (1.38 mL, 2.2 mmol) was slowly added dropwise. The temperature was raised to room temperature, followed by stirring for 1 hour. The temperature was cooled down below 0°C again, then 8-bromooctane-1-ol (0.42 g, 2.0 mmol) was added, followed by stirring for 1 hour. After the completion of the reaction, the reacted mixture was poured into saturated brine (100 ml), extracted with ethyl acetate (30 mL × 3) and washed with water (30mL × 3). After the organic layer was dried over sodium sulfate, solvent was evaporated under reduced pressure, obtaining a crude product that was purified using silica gel column chromatography (hexane), obtaining a pale yellow solid of 4,4-bis(8-hydroxyoctyl)cyclopenta[2,1-b:3,4-b']dithiophene (0.68 g, 78%) which was represented by the chemical formula (iii).
$^1$H-NMR: δ = 7.12 (d, J = 4.9 Hz, 2H), 7.07 (d, J = 4.9 Hz, 2H), 2.95 (t, J = 7.0 Hz, 4H), 2.35 - 2.12 (m, 4H), 1.54 - 1.41 (m, 12H), 1.37 - 1.08 (m, 16H)
MS (GC-MS) m / z = 434 (M +)

[Synthesis Example 4]

A polymer precursor represented by the following chemical formula (iv) was synthesized.

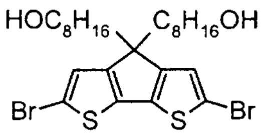

· · · (iv)

Under nitrogen atmosphere, the compound represented by the chemical formula (iii) (0.60 g, 1.38 mmol) and tetrahydrofuran (13 mL) were charged into a 100 mL three-necked flask and then cooled to below 0°C. Then, N-bromosuccinimide (0.49 g, 2.76 mmol) was slowly added, followed by stirring below 0°C for 1hour and then the temperature was raised to room temperature. After completion of the reaction, the reacted mixture was poured into saturated brine (100 mL), extracted with hexane (30 mL × 3) and washed with water (30 mL × 3). The organic layer was dried over sodium sulfate, then the solvent was evaporated under reduced pressure, obtaining a crude product that was purified using silica gel column chromatography (hexane), obtaining a yellow solid of 2,6-dibromo-4,4-bis(8-hydroxyoctyl)cyclopenta[2,1-b:3,4-b']dithiophene (0.66 g, 81 %) that is represented by the chemical formula (iv).
$^1$H-NMR: δ = 6.94 (s, 2H), 2.95 (t, J = 7.0 Hz, 4H), 2.35 - 2.12 (m, 4H), 1.54 - 1.41 (m, 12H), 1.37 - 1.08 (m, 16H)
MS (GC-MS) m / z = 592 (M +)

[Synthesis Example 5]

A monomer represented by the following chemical formula (v) was synthesized.

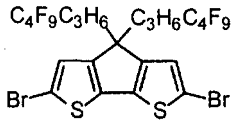

· · · (v)

2,6-dibromo-4,4-bis(4,4,5,5,6,6,7,7,7-nonafluoroheptyl)cyclopenta[2,1-b:3, 4-b']dithiophene (0.99 g, 77%) represented by the following chemical formula (v) was obtained using cyclopenta[2,1-b:3,4-b']dithiophene as a starting material in the same manner as in Synthesis Example 1 and 2, except that 1-iodo-4,4,5,5,6,6,7,7,7-nonafluoroheptane (0.64 g, 1.7 mmol) was used instead of 8-bromo-1-iodo-octane.
$^1$H-NMR: δ = 6.94 (s, 2H), 1.96 - 1.80 (m, 8H), 1.54 - 1.51 (m, 4H), 1.27-1.15 (m, 4H)
MS (GC-MS) m / z = 928.34 (M +)

[Synthesis Example 6]

2,6-bis(trimethyltin)-4,8-bis(ethylhexyloxy)benzo[1,2-b:4,5-b']dithiophene represented by the chemical formula (vi) was synthesized from 4,8-bis(2-ethylhexyloxy)benzo[1,2-b:4,5-b']dithiophene in the same manner described in J. Am. Chem. Soc., 131, p.7792 (2009). Hereinafter, in the following chemical formulas and reaction formulas, Me = methyl, and EtHex = 2-ethylhexyl.

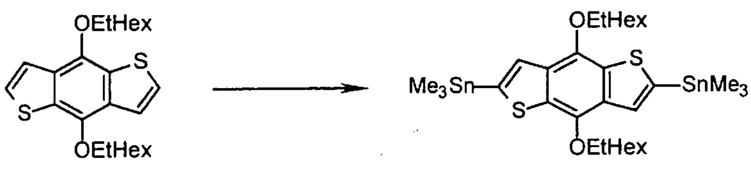

· · · (vi)

$^1$H-NMR: δ = 7.51 (s, 2H), 4.19 (d, J = 5.0 Hz, 4H), 1.58 - 1.53 (m, 4H), 1.82 - 1.30 (m, 18H), 1.10 - 0 .88 (m, 18H), 0.43 (s, 18H).

[Synthesis Example 7]

2,6-bis(trimethyltin)-4,8-bis(propyloxy)benzo[1,2-b:4,5-b']dithiophene represented by the chemical formula (vii) was synthesized from 4,8-bis(propyloxy)benzo[1,2-b:4,5-b']dithiophene in the same manner as described in J. Am. Chem. Soc., 131, p.7792 (2009).

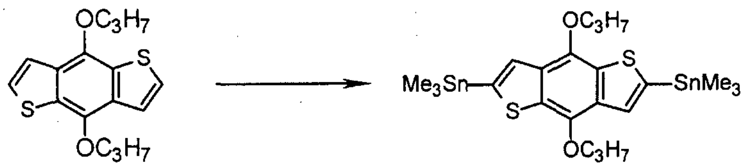

· · · (vii)

$^1$H-NMR: δ = 7.51 (s, 2H), 4.27 (t, J = 3.5 Hz, 4H), 1.95 - 1.88 (m, 4H), 1.36 (t, J = 4.2 Hz, 6H), 0.50 - 0 .34 (s, 18H)

[Synthesis Example 8]

2,6-bis(trimetyltin)-4,8-dioctylbenzo[1,2-b:4,5-b']dithiophene represented by the following chemical formula (viii) was synthesized from 4,8-dioctylbenzo[1,2-b:4,5-b']dithiophene in the same manner as described in J. Am. Chem. Soc., 131, p.7792 (2009).

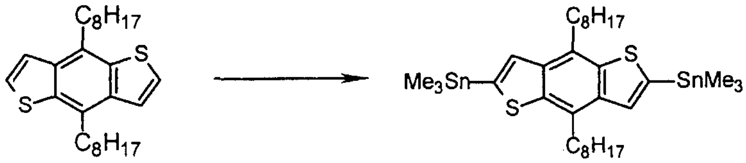

· · · (viii)

$^1$H-NMR: δ = 7.50 (s, 2H), 3.21 (t, J = 8.0 Hz, 4H), 1.54 - 1.21 (m, 20H), 0.89 (t, J = 7.0 Hz, 6H), 0.46 (s, 18H)

[Synthesis Example 9]

2,6-bis(trimethyltin)-4,8-dipropylbenzo[1,2-b:4,5-b']ditiophen represented by the following chemical formula (ix) was synthesized from 4,8-dipropylbenzo[1,2-b:4,5-b']dithiophene in the same manner as described in J. Am. Chem. Soc., 131, p.7792 (2009).

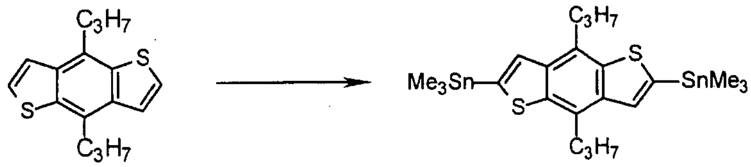

· · · (ix)

$^1$H-NMR: δ = 7.50 (s, 2H), 3.20 (t, J = 4.3 Hz, 4H), 1.89 - 1.85 (m, 4H), 1.06 (t, J = 4.0 Hz, 6H), 0.45 (s, 18H)

[Synthesis Example 10]

2,6-bis(trimethyltin)-4,8-didodecylbenzo[1,2-b:4,5-b']dithiophene represented by the following chemical formula (x) was synthesized from 4,8-didodecylbenzo[1,2-b:4,5-b']dithiophene in a similar manner as described in J. Am. Chem. Soc., 131, p.7792 (2009).

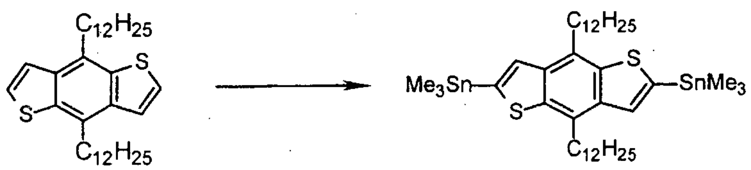

· · · (x)

$^1$H-NMR: δ = 7.49 (s, 2H), 3.20 (t, J = 8.0 Hz, 4H), 1.83 (m, 4H), 1.54 - 1.22 (m, 36H), 0.88 (t, J = 7.0 Hz, 6H), 0.45 (s, 18H)

Synthesis of other monomers are described, for example, in JACS, 130, p.7812 (2008), Chem. Com., 20, p. 2314 (2004), Macromolecules, 32, p.4232 (1999), US6960643B2, Macromolecules, 36, p.61 (2003), Macromolecules, 44, p.719 (2011), Organomethallics, 30, p.3233 (2011) etc.

[Example 1]

A block copolymer (1) was synthesized according to the following reaction formula. Hereinafter, note that in chemical formulas and reaction formulas, (-b-) represents a block copolymer, and (-r-) represents a random copolymer.

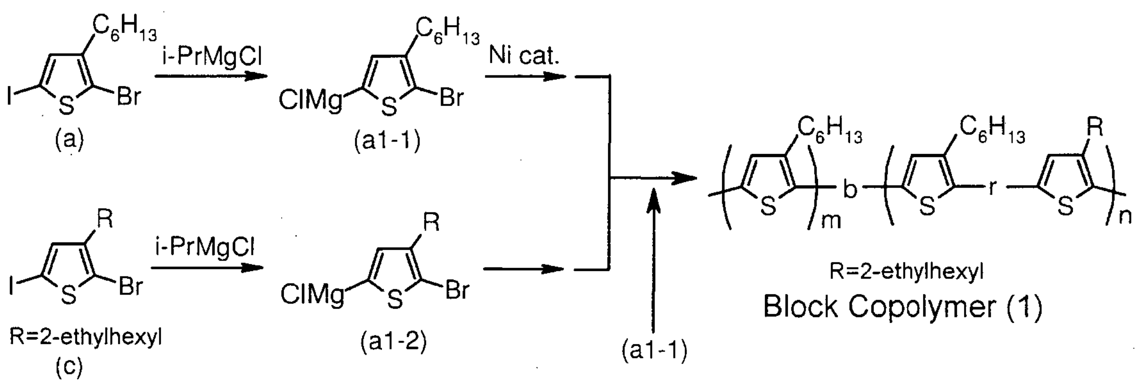


Into an eggplant flask (A), which was purged with argon and dried sufficiently, dehydrated and peroxide-removed THF (18 mL), 2-bromo-5-iodo-3-hexylthiophene (1.34 g, 3.6 mmol, a monomer that might constitute the polymer block (A)) and 2.0M solution (1.8 mL) of i-propyl magnesium chloride (i-PrMgCl) were charged and then stirring was continued for 30 minutes at 0°C, synthesizing a solution of an organomagnesium compound represented by the chemical formula (a1-1). In another eggplant flask (B) that is dried and purged with argon, THF (7 mL) that was subjected to peroxide removal process and dehydration, 2-bromo-5-iodo-3-(2-ethylhexyl)thiophene (0.56 g, 1.4 mmol, one of the monomers that might constitute the polymer block (B)) and 2.0M solution (0.7 mL) of i-propyl magnesium chloride were added and stirred for 30 minutes at 0°C, obtaining a solution of organomagnesium compound represented by the chemical formula (a1-2).

Into an eggplant flask (C) that is dried and purged with argon, a dehydrated and peroxide-removed THF (25 mL) and $NiCl_2$(dppp) (27 mg, 0.05 mmol) were charged and heated to 35°C, then 70% of the previously prepared organic magnesium compound solution (a1-1) was added. Heating and stirring were continued for 1.5 hours at 35°C. After addition of the organomagnesium compound solution (a1-2), the remaining organomagnesium compound solution (a1-1) was added dropwise for over 4 hours. After completion of dropwise addition, 1.0M solution (2 mL) of t-butyl magnesium chloride in THF was added, followed by stirring for 1 hour at 35°C. Then 5M hydrochloric acid (30 mL) was added and stirred for 1 hour at room temperature. The reacted mixture was extracted with chloroform (450 mL). The obtained organic layer was washed sequentially with aqueous sodium bicarbonate (100 mL), distilled water (100 mL), and dried over anhydrous sodium sulfate. The organic layer was concentrated, obtaining a dried solid. The black purple solid obtained was dissolved in chloroform and then reprecipitated in methanol (300 mL). The precipitated solid was purified using a preparative GPC column, obtaining a block copolymer (1) (0.685 g, 79%). Weight average molecular weight (Mw) and number average molecular weight (Mn) of the obtained block copolymer (1) were 23,200 and 20,500 respectively, and polydispersity (Mw/Mn) thereof was 1.13.
$^1$H-NMR: $\delta$ = 6.97 (s, 1H), 6.94 (s, 0.1H), 2.80 (m, 2.2H), 1.70 - 1.25 (m, 10.1H), 0.94 - 0.89 (m, 3.3H)

[Example 2]

A block copolymer (2) was synthesized according to the following reaction formula.

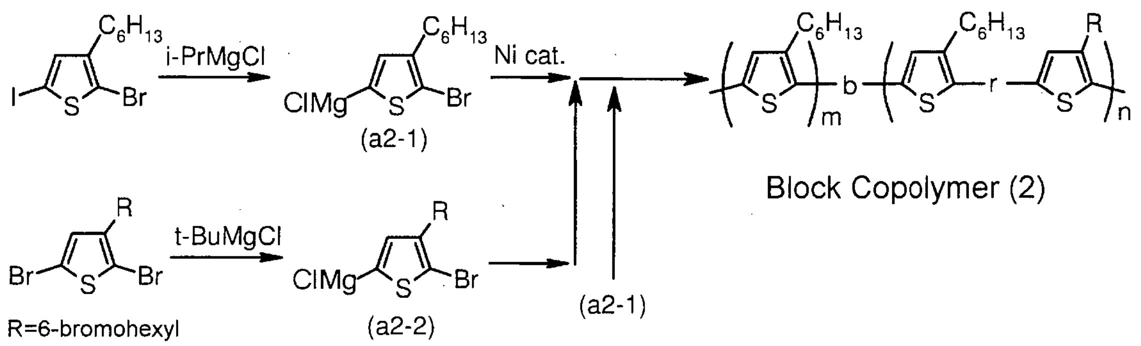

Into a sufficiently dried and argon purged eggplant flask (A), THF (21 mL) which was subjected to peroxide removal process and dehydration, 2-bromo-5-iodo-3-hexylthiophene (1.53 g, 4.1 mmol, a monomer that might constitute the polymer block (A)), and 2.0M solution (2.1 mL) of i-propylmagnesium chloride were charged and stirred for 30 minutes at 0°C, obtaining a solution of an organomagnesium compound represented by the chemical formula (a2-1). In a sufficiently dried and argon purged eggplant flask (B), THF (4 mL) which was subjected to peroxide removal process and dehydration, 2,5-dibromo-3-(6-bromohexyl)thiophene (0.36 g, 0.9 mmol, one of monomers that might constitute the polymer block (B)), and 1.0M solution (0.9 mL) of t-butylmagnesium chloride was added and stirred for 2 hours at 60°C, obtaining a solution of an organomagnesium compound represented by the chemical formula (a2-2).

Into a dried and argon purged eggplant flask (C), THF (25 mL) which was subjected to peroxide removal process and dehydration, and $NiCl_2$(dppp) (27 mg, 0.05 mmol) were added and then heated to 35°C. 70% of the previously prepared organomagnesium compound solution (a2-1) was added and then heated and stirred for 1.5 hours at 35°C. Then, the remaining organomagnesium compound solution (a2-1) and the organomagnesium compound solution (a2-2) were added and allowed to react for 2 hours at 35°C. After completion of the reaction, 1.0M solution (2 mL) of t-butyl magnesium chloride in THF was added and stirred for 1 hour at 35°C, then 5M hydrochloric acid (30 mL) was added and stirred for 1 hour at room temperature. The reaction mixture was extracted with chloroform (450 mL). The organic layer was washed sequentially with aqueous sodium bicarbonate (100 mL), distilled water (100 mL) and was dried over anhydrous sodium sulfate, obtaining a concentrated solid. The obtained black purple solid was dissolved in chloroform (30 mL) and then reprecipitated in methanol (300 mL). The precipitated solid was purified using a preparative GPC column, obtaining a block copolymer (2) (0.75 g, 83%). The weight average molecular weight (Mw) and the number average molecular weight (Mn) of the obtained block copolymer (2) were each 27,400 and 25,370, and the polydispersity thereof was 1.08.

$^1$H-NMR: $\delta$ = 6.97 (s, 1H), 3.41 (t, J = 6.8 Hz, 0.2H), 2.80 (t, J = 8.0 Hz, 2H), 1.89 - 1.27 (m, 9.8H), 0.91 (t, J = 6.8 Hz, 2.7H)

[Example 3]

A block copolymer (3) was synthesized according to the following reaction formula.

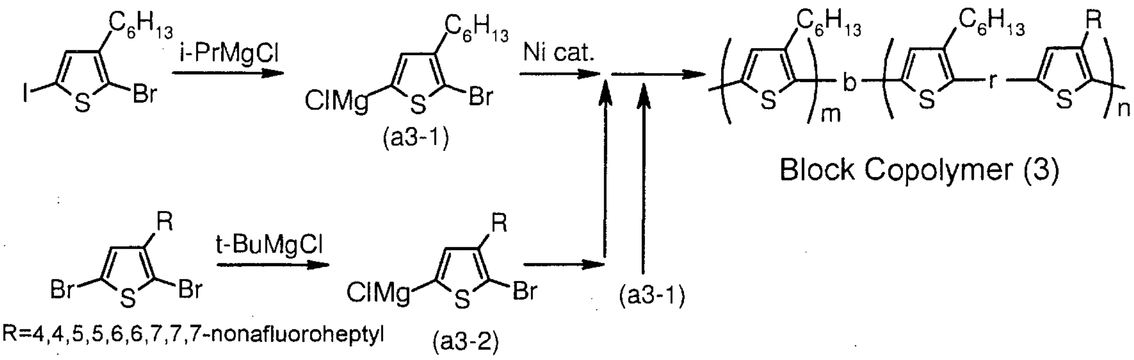


(a3-1)

Block Copolymer (3)

R=4,4,5,5,6,6,7,7,7-nonafluoroheptyl

(a3-2)

(a3-1)

The block copolymer (3) (0.72 g, 3.6 mmol) was obtained in a similar manner as described in Example 2, except that 2-bromo-5-iodo-3-hexylthiophene (1.34 g, 3.6 mmol, one of the monomers that might constitute the polymer block (A)), and 2, 5-dibromo-3-(4,4,5,5,6,6,7,7,7-nonafluoroheptyl)thiophene (0.39 g, 0.8 mmol, one of the monomers that might constitute the polymer block (B)). The weight average molecular weight and the number average molecular weight of the obtained block copolymer (3) were each 23,400 and 20,800, and the polydispersity thereof was 1.13.

$^1$H-NMR: $\delta$ = 6.97 (s, 1H), 2.80 (t, J = 8.0 Hz, 2H), 1.73 - 1.34 (m, 9.4H), 0.91 (t, J = 6.8 Hz, 2.7H)

[Example 4]

A block copolymer (4) was synthesized according to the following reaction formula.

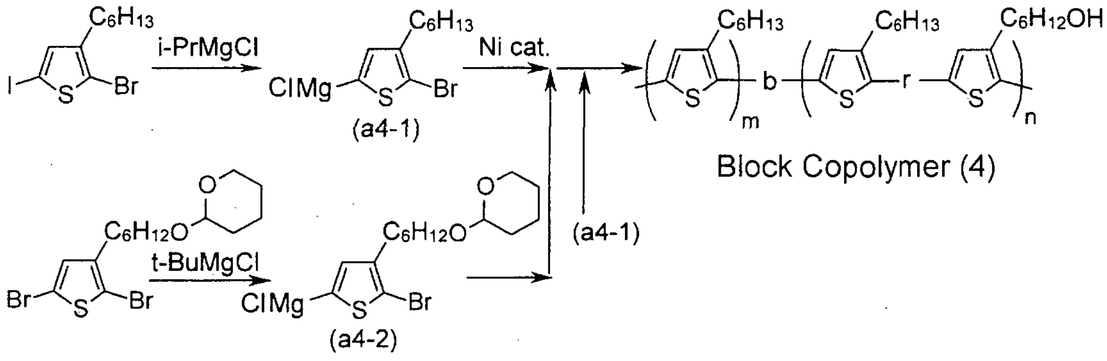


The block copolymer (4) (0.65 g, 83%) was obtained in a similar manner as described in Example 2, except that 2-bromo-5-iodo-3-hexylthiophene (1.34 g, 3.6 mmol, one of the monomers that might constitute the polymer block (A)), and 2,5-dibromo-3-[6-(2-tetrahydropyranyl)oxyhexyl]thiophene (0.43 g, 1.0 mmol, one of the monomers that might constitute the polymer block (B)). Incidentally, an OH protecting group (tetrahydropyranyloxy group) was removed at the stage of treatment with 5M hydrochloric acid. The weight average molecular weight and the number average molecular weight of the obtained block copolymer (4) were each 23,400 and 20,800, and the polydispersity thereof was 1.13.
$^1$H-NMR: $\delta$ = 6.97 (s, 1H), 3.65 (t, J = 5.0 Hz, 0.2H), 2.80 (t, J = 8.0 Hz, 2H), 1.71 - 1.34 (m, 9.8H), 0.91 (t, J = 6.8 Hz, 2.7H)

[Example 5]

A block copolymer (5) was synthesized according to the following reaction formula.

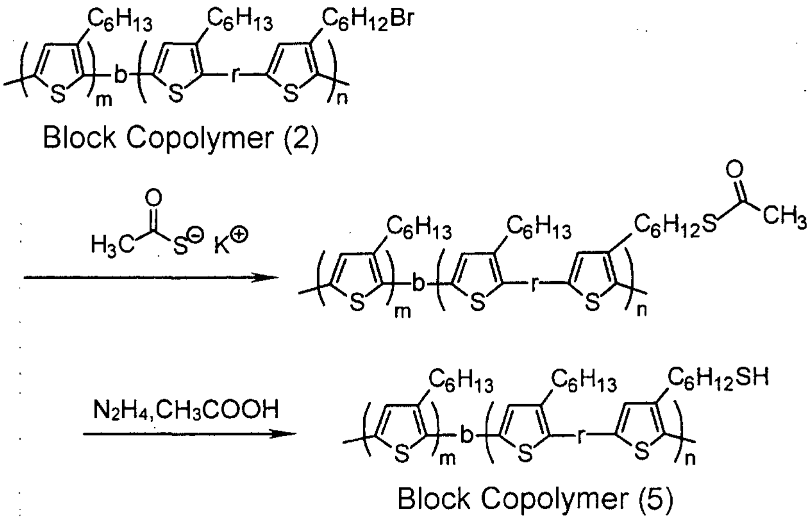


Into a, glass eggplant flask that is sufficiently dried and purged with nitrogen, block copolymer (2) (0.72 g, 3.98 mmol (Br group-based conversion mol: 0.80 mmol)), THF (stabilizer free, 30 mL) and potassium thioacetate (0.14 g, 1.22 mmol) were charged and heated for 10 hours at 65°C. After 10 hours, the reacted mixture was cooled, and distilled water (150 mL) was added. Further, extraction was carried out with chloroform (100 mL). The organic layer was condensed and dried. The obtained solid was dissolved in chloroform (50 mL) and then reprecipitated in methanol (700 mL). The precipitated solid was dried, obtaining a precursor (0.69 g, 96%) of the block copolymer (5).
$^1$H-NMR: $\delta$ = 6.97 (s, 1H), 3.77 - 3.72 (m, 2.2H), 2.31 (s, 0.2H), 1.71-1.30 (m, 9.8H), 0.91 (t, J = 6.8 Hz, 2.7H)

Subsequently, into a glass eggplant flask that is sufficiently dried and purged with argon, the precursor of block copolymer (5) (0.69 g, 3.82 mmol (conversion mol based on sulfur atom: 0.76 mmol)), dimethylformamide (28 mL) and THF (stabilizer free, 140 mL) were added and dissolved. Further, hydrazine-acetic acid complex (0.56 g, 6.5 mmol) was added and stirred for 6 hours at 40°C. 2 g of trifluoroacetic acid was added to stop the reaction. To the reaction solution, distilled water (150 mL) was added, and extraction with chloroform (200 mL) was carried out. The weight average molecular weight and the number average molecular weight of the block copolymer (5) were each 27,100 and 22,300, and the polydispersity thereof was 1.22.
$^1$H-NMR: $\delta$ = 6.97 (s, 1H), 2.80 (t, J = 8.0 Hz, 2H), 1.71 - 1.30 (m, 10H), 0.91 (t, J = 6.8 Hz, 2.7H).

[Example 6]

A block copolymer (6) was synthesized according to the following reaction formula.

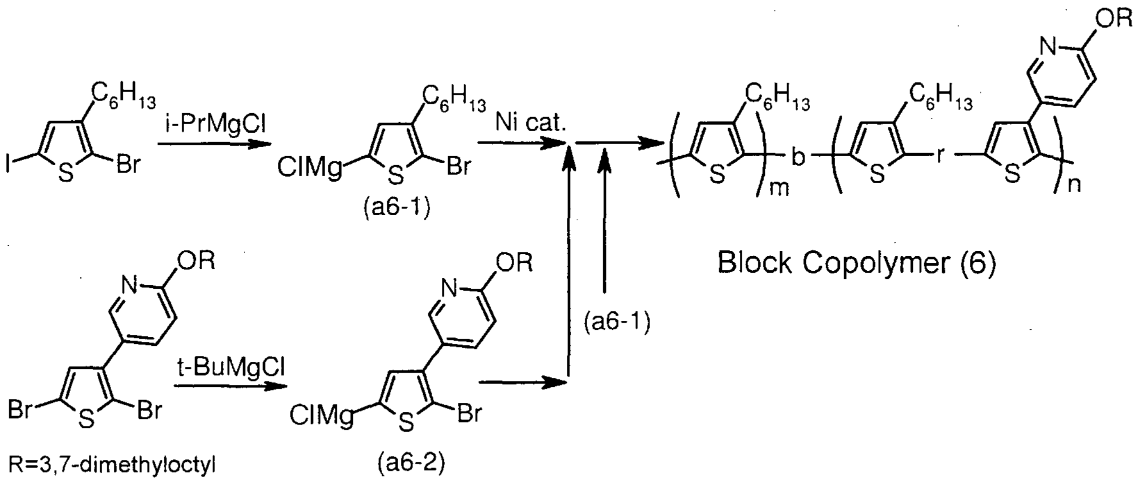


The block copolymer (6) (0.75 g, 82%) was obtained in a similar manner as described in Example 2, except that 2-bromo-5-iodo-3-hexylthiophene (1.34 g, 3.6 mmol, one of the monomers that might constitute the polymer block (A)) and 2,5-dibromo-3-[2-(3,7-dimethyloctyloxy)pyridine-5-yl]thiophene (0.48 g, 1.0 mmol, one of the monomers that might constitute the polymer block (B)) were used. The weight average molecular weight and the number average molecular weight of the obtained block copolymer (6) were each 22,200 and 18,500, and the polydispersity thereof was 1.20.
$^{1}$H-NMR: δ = 8.4 (m, 0.1H), 7.78 (m, 0.1H), 7.27 (s, 0.1H), 6.97 (s, 1H), 6. 77 (m, 0.1H), 3.96 (t, J = 5.0 MHz, 0.2H), 2.80 (t, J = 8.0 Hz, 2H), 1.71-1.30 (m, 10H), 0.94 - 0.89 (m, 3.6H)

[Polymerization Example 1]

A polymer block (B1) was synthesized according to the following reaction formula.

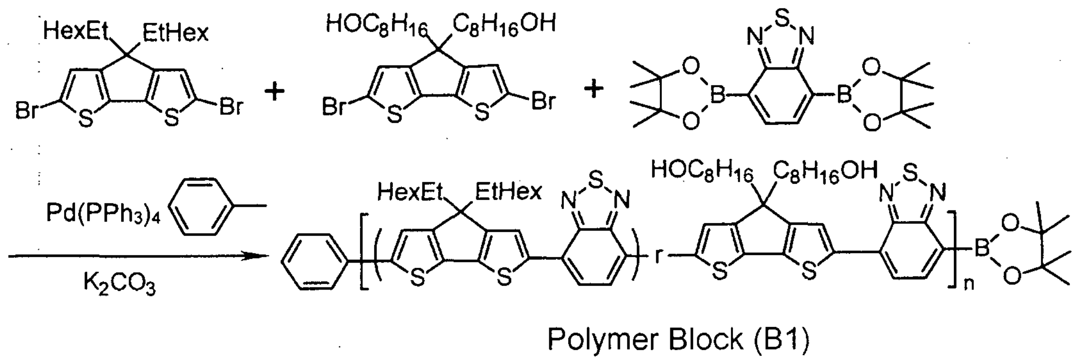


Under a nitrogen atmosphere, to a 100 mL three-necked flask, monomers of 2,6-dibromo-4,4'-bis(2-ethylhexyl) cyclopenta[2,1-b:3,4-b']dithiophene (0.75 g, 1.34 mmol), 2,6-dibromo-4,4'-bis(8-hydroxyoctyl)cyclopenta[2,1-b:3,4-b'] dithiophene (0.79 g, 1.34 mmol), and 4,7-bis(3,3,4,4-tetramethyl-2,5,1-dioxaborolane-1-yl)benzo[c][1,2,5]thiadi azole (1.04 g, 2.68 mmol) were added as monomers that might constitute the polymer block (B1). Further, toluene (50 mL), 2M aqueous solution of potassium carbonate (25 mL, 50 mmol), tetrakis(triphenylphosphine)palladium(0) (61.9 mg, 53.5 μmol) and aliquat 336 (2 mg, 4.95 μmol) were added and stirred for 2 hours at 80°C. Then phenylboronic acid pinacol ester (273 mg, 1.34 mmol) was added as an endcapping agent and stirred for 18 hours at 80°C. After completion of the reaction, the reacted mixture was poured into methanol (500 mL) and then filtered to obtain the precipitated solid. The obtained solid was washed with water (100 mL) and methanol (100 mL) and then dried under reduced pressure, obtaining crude product. After washed with acetone (200 mL) and hexane (200 mL), the crude product was extracted with chloroform (200 mL) using a Soxhlet extractor. The organic layer was concentrated to dry, then the obtained solid was dissolved

in chloroform (30 mL) and was reprecipitated in methanol (300 mL). The precipitated solid was dried under a reduced pressure, obtaining the polymer block (B1) as a black purple solid (0.93 g, 63%). The weight average molecular weight and the number average molecular weight of the obtained polymer block (B1) were each 28,900 and 13,100, and the polydispersity thereof was 2.21.
$^1$H-NMR (270 MHz, $CDCl_3$), $\delta$ (ppm): $\delta$ = 7.89 - 6.93 (m, 8H), 3.02 - 2.88 (m, 4H), 2.36 - 2.11 (m, 8H), 1.60 - 1.32 (m, 36H), 1.18 - 0.82 (m, 18H)

[Polymerization Example 2]

A polymer block (B2) was synthesized according to the following reaction formula.

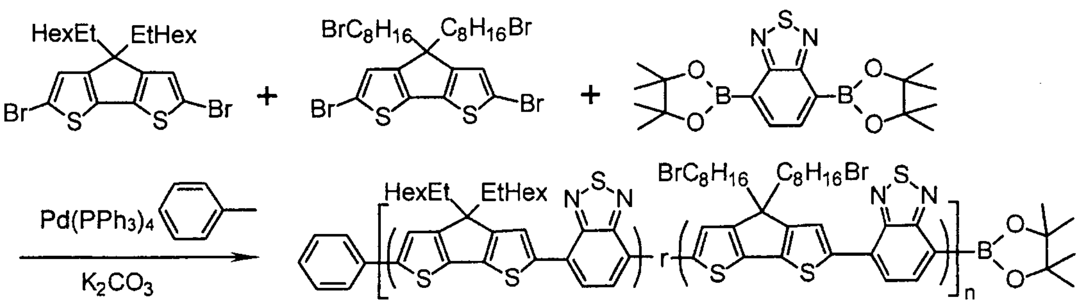


Polymer Block (B2)

The polymer block (B2) (1.38 g, 84%) was obtained in a similar method as described in Polymerization Example 1 except that 2,6-dibromo-4,4'-bis(2-ethylhexyl)cyclopenta[2,1-b:3,4-b']dithiophene (0.75 g, 1.34 mmol), 2,6-dibromo-4,4'-bis(8-bromooctyl)cyclopenta[2,1-b:3,4-b']dithiophene (0.96 g, 1.34 mmol), and 4,7-bis(3,3,4,4-tetramethyl-2,5,1-dioxaborolane-1-yl)benzo[c][,2,5]thiadi azole (1.04 g, 2.68 mmol) were added as monomers that might constitute the polymer block (B2). The weight average molecular weight and the number average molecular weight of the obtained polymer block (B2) were each 30,000 and 13,900, and the polydispersity thereof was 2.16.
$^1$H-NMR (270 MHz, $CDCl_3$): $\delta$ = 7.90 - 6.88 (m, 8H), 3.19 - 2.99 (m, 4H), 2.32 - 2.07 (m, 8H), 1.62 - 1.34 (m, 36H), 1.21 - 0 .89 (m, 18H)

[Polymer Synthesis 3]

A polymer block (B3) was synthesized according to the following reaction formula.

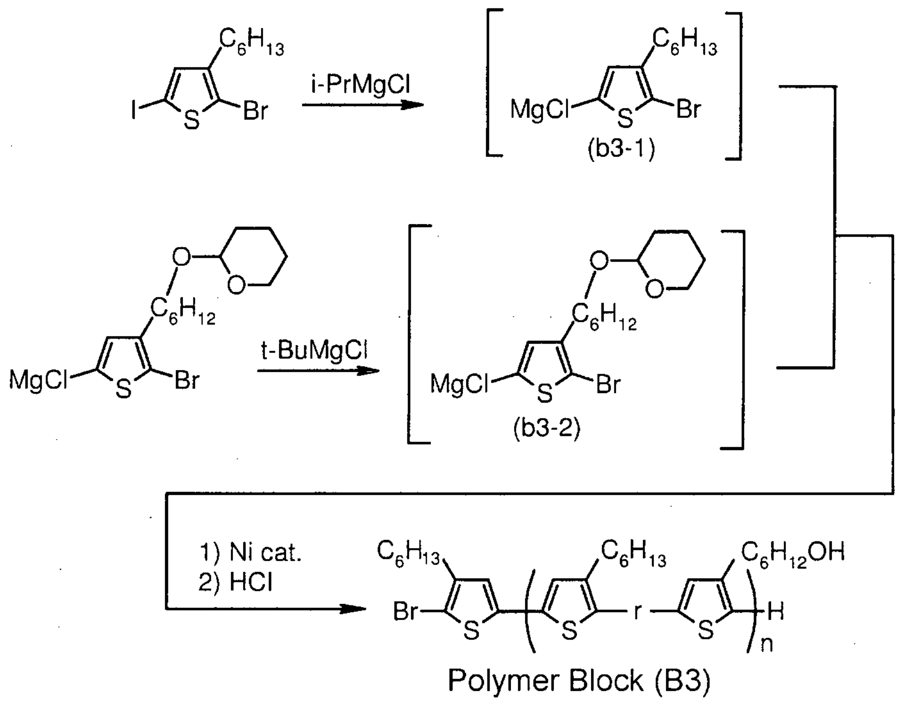


In an eggplant flask (A) that is sufficiently dried and purged with argon, THF (20 mL) that was subjected to dehydration and peroxide removal processes, 2-bromo-5-iodo-3-hexylthiophene (1.31 g, 3.5 mmol) and 2.0M solution (1.75 mL) of i-propyl magnesium chloride were added and stirred for 30 minutes at 0°C, obtaining a solution of organomagnesium compound represented by the chemical formula (b3-1). In another eggplant flask (B) that is dried and purged with argon, THF (7.5 mL) that was subjected to dehydration and peroxide removal processes, 2,5-dibromo-3-(6-tetrahydropyranyloxy)hexylthiophene (0.64 g, 1.5 mmol), 1.0M solution (1.5 mL) of t-butyl magnesium chloride were reacted for 2 hours at 60°C, obtaining a solution of organomagnesium compound (b3-2). Into an eggplant flask (C) that was dried and purged with argon, THF (25 mL) that was subjected to dehydration and peroxide removal processes, $NiCl_2$(dppp) (27 mg, 0.05 mmol) were charged and heated to 35°C. Then the solution of organomagnesium compound (b3-1) was added at first and then the solution of the organomagnesium compound (b3-2) was added sequentially. After stirring for 1.5 hours at 35°C, 1.0M solution (2 mL) of t-butyl magnesium chloride in THF was added and stirred for 1 hour at 35°C. Then 5M hydrochloric acid (30 mL) was added and stirred for 1 hour at room temperature. The reacted mixture was extracted with chloroform (450 mL). The organic layer was washed with aqueous sodium bicarbonate (100 mL) and distilled water (100 mL), sequentially. The organic layer was dried over anhydrous sodium sulfate and then concentrated and dried. The obtained black purple solid was dissolved in chloroform (30 mL) and then reprecipitated in methanol (300 mL). The precipitated solid was purified using a preparative GPC column, obtaining a polymer block (B3) (0.72 g, 84%). The weight average molecular weight and the number average molecular weight of the obtained polymer block (B3) were each 22,400 and 18,800, and the polydispersity thereof was 1.19.

$^1$H-NMR: $\delta$ = 6.97 (s, 1H), 3.65 (t, J = 5.0 Hz, 0.6H), 2.80 (t, J = 8.0 Hz, 2H), 1.71 - 1.34 (m, 8H), 0.91 (t, J = 6.8 Hz, 2.1H)

[Polymerization Example 4]

A polymer block (A1) was synthesized according to the following reaction formula.

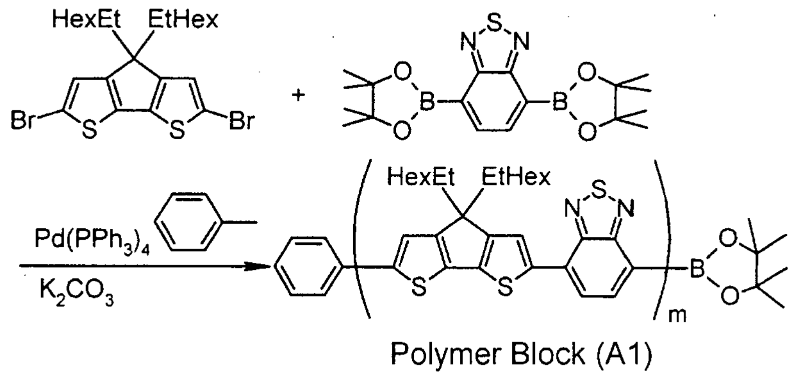


Into a 100 mL three necked flask under a nitrogen atmosphere, 2,6-dibromo-4,4'-bis(2-ethylhexyl)cyclopenta [2,1-b:3,4-b']dithiophene (1.50 g, 2.68 mmol), 4,7-bis(3,3,4,4-tetramethyl-2,5,1-dioxaborolane-1-yl)benzo[c][1,2,5]thiadi azole (1.04 g, 2.68 mmol), toluene (50 mL), 2M aqueous solution of potassium carbonate (25 mL, 50 mmol), tetrakis (triphenylphosphine)palladium(0) (61.9 mg, 53.5 μmol), aliquat 336 (2 mg, 4.95 μmol), were charged and stirred for 2 hours at 80°C. After that, phenylboronic acid pinacol ester (0.27 g, 1.34 mmol) was added as an endcapping agent and stirred for 18 hours at 80°C. After the completion of the reaction, the reaction mixture was poured into methanol (500 mL). The precipitated solid was filtered and washed with water (100 mL), methanol (100 mL), obtaining a solid that was dried under reduced pressure to obtain a crude product. After the crude product was washed with acetone (200 mL) and hexane (200 mL), and then extracted with chloroform (200 mL) using a Soxhlet extractor. The organic layer was concentrated and dried. The obtained solid was dissolved in chloroform (30 mL), then reprecipitated in methanol (300 mL). The precipitated solid was dried under reduced pressure, obtaining the polymer block (A1) or a black purple solid (1.04 g, 73%). The weight average molecular weight and the number average molecular weight of the obtained polymer block (A1) were each 45,500 and 19,600, and the polydispersity thereof was 2.32.
$^1$H-NMR (270 MHz, $CDCl_3$): δ = 8.10 - 7.95 (m, 2H) 7.80 - 7.61 (m, 2H), 2.35 - 2.12 (m, 4H), 1.60 - 1.32 (m, 18H), 1.18 - 0.82 (m, 12H)

[Polymerization Example 5]

A polymer block (A2) was synthesized according to following reaction formula.

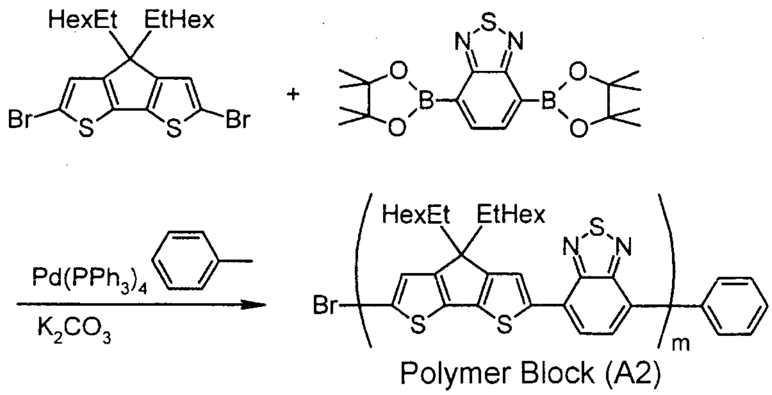


The polymer block (A2) (1.09 g, 73%) was obtained in a similar manner as described in Polymer Synthesis 4 except that bromobenzene (0.21 g, 1.34 mmol) was used as an endcapping agent. The weight average molecular weight and the number average molecular weight of the obtained polymer block (A2) were each 46,300 and 20,100, and the polydispersity thereof was 2.30.
$^1$H-NMR (270 MHz, $CDCl_3$): δ = 8.11 - 7.94 (m, 2H) 7.82 - 7.63 (m, 2H), 2.35 - 2.13 (m, 4H), 1.60 - 1.32 (m, 18H), 1.18 - 0.82 (m, 12H)

[Polymerization Example 6]

A polymer block (A3) was synthesized according to the following reaction formula.

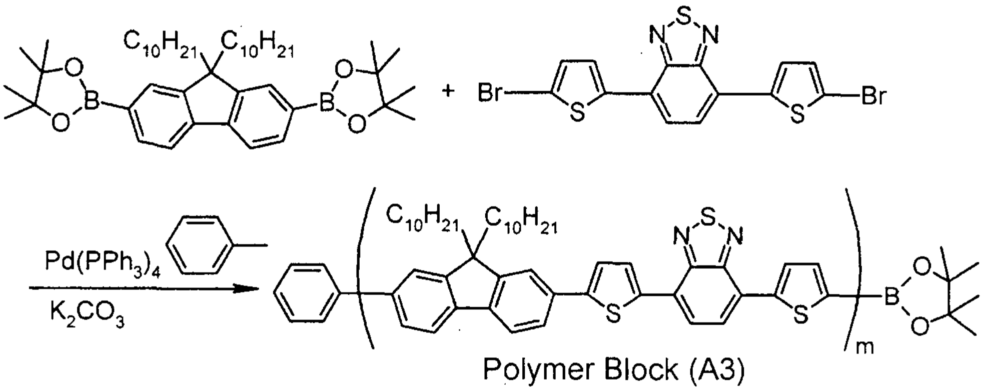


Polymer Block (A3)

Under a nitrogen atmosphere, 2,7-boryl-9,9-didecylfluorenes (1.62 g, 2.68 mmol), 4,7-di(2'-bromothien-5'-yl)-2,1,3-benzothiadiazole (1.23 g, 2.68 mmol) tetrakis(triphenylphosphine)palladium(0) (61.9 mg, 53.5 $\mu$mol) and toluene (50 mL) were stirred for 10 minutes under reflux. Then 20% tetraethylammonium hydroxide 8 mL was added and then stirred for 3 hours at 80°C. Then phenylboronic acid pinacol ester (0.27 g, 1.34 mmol) was added as an endcapping agent and stirred for 18 hours at 80°C. After completion of the reaction, the reacted mixture was reprecipitated in methanol (500 mL). The precipitated solid was filtered, washed with water (100 mL) and methanol (100 mL), and dried under reduced pressure, obtaining a crude product. The crude product was washed with acetone (200 mL) and hexane (200 mL), and then was extracted with chloroform (200 mL) using a Soxhlet extractor. The organic layer was concentrated and dried. The obtained solid was dissolved in chloroform (30 mL) and then reprecipitated in methanol (300 mL). The precipitated solid was dried under reduced pressure, so that polymer block (A3) was obtained as a black purple solid (1.28 g, 64%). The weight average molecular weight and the number average molecular weight of the obtained polymer block (A3) were each 47,400 and 18,900, and the polydispersity thereof was 2.51.
$^1$H-NMR (270 MHz, $CDCl_3$): $\delta$ = 8.11 (d, J = 3.5 Hz, 2H), 8.09 - 7.92 (m, 8H), 7.45 (d, J = 3.6 Hz, 2H), 2.32 - 2.11 (m, 4H), 1.61 - 1.34 (m, 28H), 1.32 - 1.20 (m, 4H), 1.15 - 0.82 (m, 6H)

[Polymerization Example 7]

A polymer block (A4) was synthesized according to the following reaction formula.

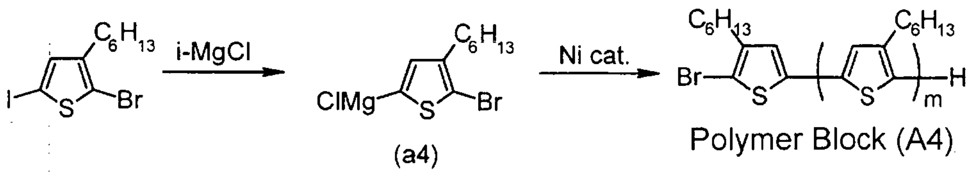


(a4)

Polymer Block (A4)

In an eggplant flask (A) that was sufficiently dried and purged with argon, THF (25 mL) that was subjected to dehydration and peroxide removal processes, 2-bromo-5-iodo-3-hexylthiophene (1.87 g, 5 mmol) and 2.0M solution (2.5 mL) of i-propyl magnesium chloride were charged and stirred for 30 minutes at 0°C, obtaining a solution of organomagnesium compound represented by the chemical formula (a4).

In an eggplant flask (B) that was dried and purged with argon, THF (25 mL) that was subjected to dehydration and peroxide removal processes, and $NiCl_2$(dppp) (27 mg, 0.05 mmol) were charged and heated to 35°C. Then the solution of an organomagnesium compound (a4) was added. After stirring for 1.5 hours at 35°C, 5M hydrochloric acid (50 mL) was added and stirred for 1 hour at room temperature. The reacted mixture was extracted with chloroform (450 mL) and the organic layer was washed sequentially with aqueous sodium bicarbonate (100 mL), distilled water (100 mL). The obtained organic layer was dried over anhydrous sodium sulfate and then concentrated to be dried. The obtained black purple solid was dissolved in chloroform (30 ml), and then reprecipitated in methanol (300 ml). The precipitated solid was purified using a preparative GPC column, obtaining the polymer block (A4) (0.69 g, 83%). The weight average molecular weight and the number average molecular weight of the obtained polymer block (A4) were each 24,150 and 21,000, the polydispersity thereof was 1.15.
$^1$H-NMR: $\delta$ = 6.97 (s, 1H), 2.80 (t, J = 8.0 Hz, 2H), 1.89 - 1.27 (m, 10H), 0.91 (t, J = 6.8 Hz, 3H)

[Example 7]

A block copolymer (7) was synthesized according to the following reaction formula.

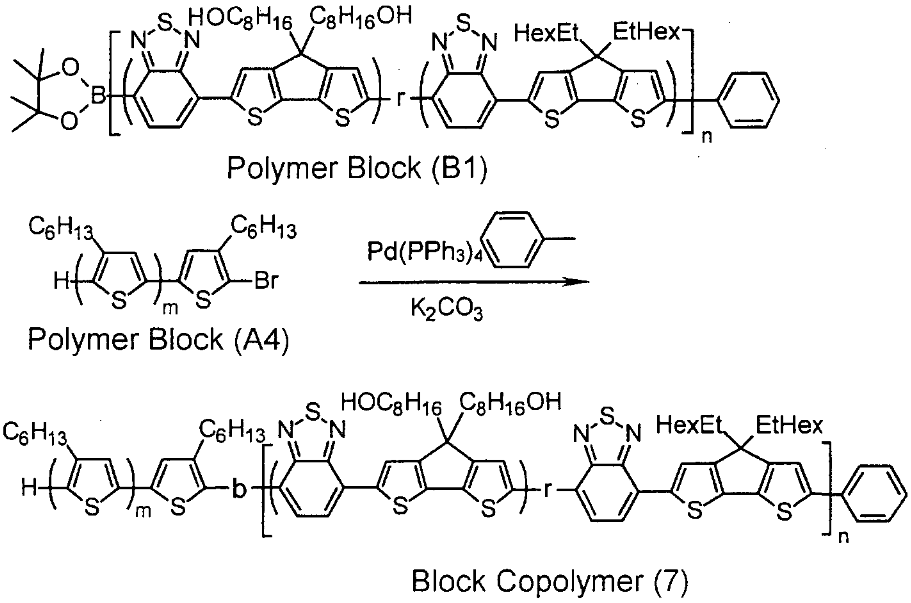


Polymer Block (B1)

Polymer Block (A4)

Block Copolymer (7)

In a 100 mL three-necked flask under a nitrogen atmosphere, the polymer block (B1) (1.03 g, 1.87 mmol), the polymer block (A4) (0.60 g, 3.61 mmol), toluene (20 mL), 2M aqueous solution of potassium carbonate (10 mL, 20 mmol), tetrakis(triphenylphosphine)palladium(0) (20.5 mg, 17.7 μmol), aliquat 336 (0.8 mg, 1.98 μmol) were charged and stirred for 24 hours at 80°C. After completion of the reaction, the reacted mixture was poured into methanol (200 mL). Then the precipitated solid was filtered, washed sequentially with water (20 mL) and methanol (20 mL) and then dried under reduced pressure, obtaining a crude product. The crude product was washed with acetone (100 mL) and hexane (100 mL), then extracted with chloroform (100 mL) using a Soxhlet extractor. The organic layer was concentrated and dried. The obtained black purple solid was dissolved in chloroform (30 mL) and then reprecipitated in methanol (300 mL). The precipitated solid was dried under reduced pressure, obtaining a black purple solid of the block copolymer (7) (0.51 g, 31%). The weight average molecular weight and the number average molecular weight of the obtained polymer block (A7) were each 109,500 and 41,000. The polydispersity thereof was 2.67.
$^1$H-NMR (270 MHz, $CDCl_3$): δ = 7.89 - 6.93 (m, 8H), 3.02 - 2.88 (m, 4H), 2.80 (t, J = 8.0 Hz), 2.36 - 2.11 (m, 8H), 1.60 - 1.32 (m, 36H), 1.18 - 0.82 (m, 18H)

[Example 8]

A block copolymer (8) was synthesized according to the following reaction formula.

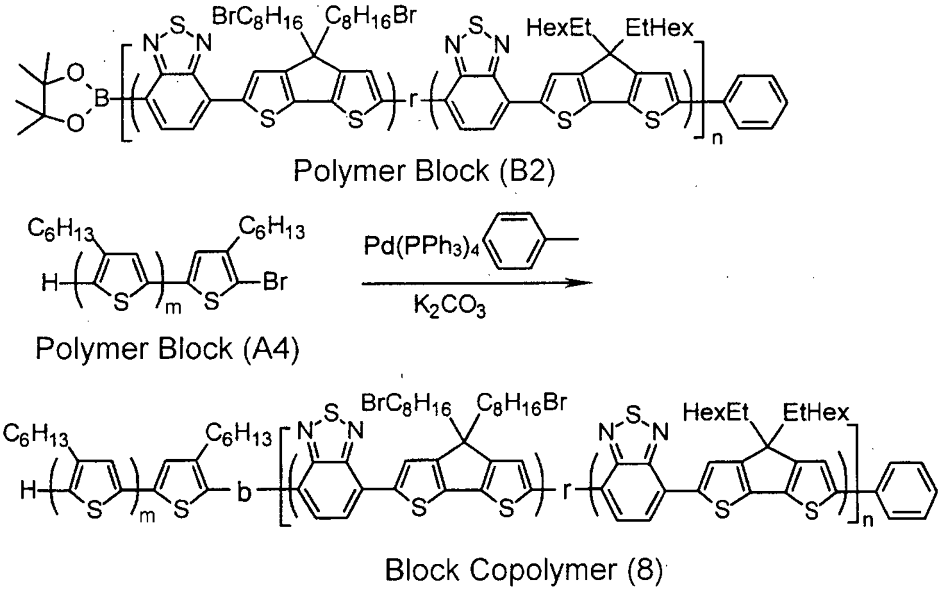


Polymer Block (B2)

Polymer Block (A4)

Block Copolymer (8)

The block copolymer (8) (0.60 g, 3.61 mmol) was obtained in a similar manner as described in Example 7 except that the polymer block (B2) (1.25 g, 2.24 mmol) which was used instead of the polymer block (B1), and polymer block (A4) were used. The weight average molecular weight and the number average molecular weight were each 86,000 and 40,600. The polydispersity thereof was 2.12.

$^1$H-NMR (270 MHz, $CDCl_3$): $\delta$ = 7.90 - 6.88 (m, 8H), 3.19 - 2.99 (m, 4H), 2.80 (t, J = 8.0 Hz), 2.32 - 2.07 (m, 8H), 1.62 - 1.34 (m, 36H), 1.21 - 0.89 (m, 18H)

[Example 9]

A block copolymer (9) was synthesized according to the following reaction formula.

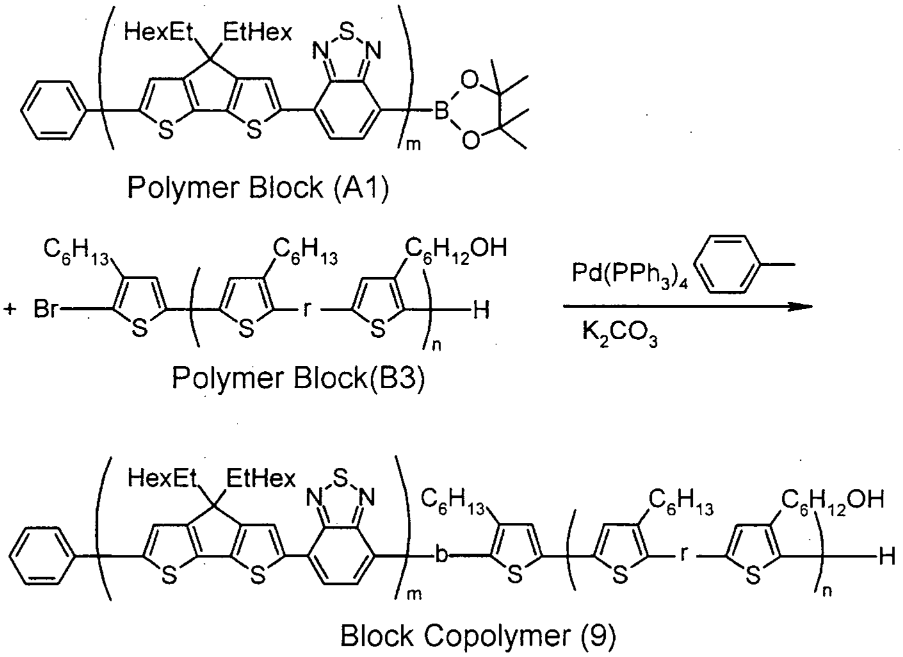


Polymer Block (A1)

Polymer Block(B3)

Block Copolymer (9)

The block copolymer (9) (0.51 g, 31%) was obtained in the same manner as described in Example 7 except that the polymer block (A1) (1.0 g, 1.87 mmol) and the polymer block (B3) (0.65 g, 3.80 mmol) were used instead of polymer block (B1) and the polymer block (A4). The weight average molecular weight and the number average molecular weight of the obtained block copolymer (9) were each 93,000 and 43,700. The polydispersity thereof was 2.13.

$^1$H-NMR (270 MHz, $CDCl_3$): $\delta$ = 8.10 - 7.95 (m, 2H), 7.80 - 7.61 (m, 2H), 6.97 (s, 1H), 3.70 - 3.60 (m, 0.6H), 3.42 (m,

1H), 2.86 - 2.72 (m, 2H), 2.35 - 2.12 (m, 8H), 1.70 - 1.32 (m, 26H), 1.18 - 0.82 (m, 20H)

[Example 10]

A block copolymer (10) was synthesized according to the following reaction formula.

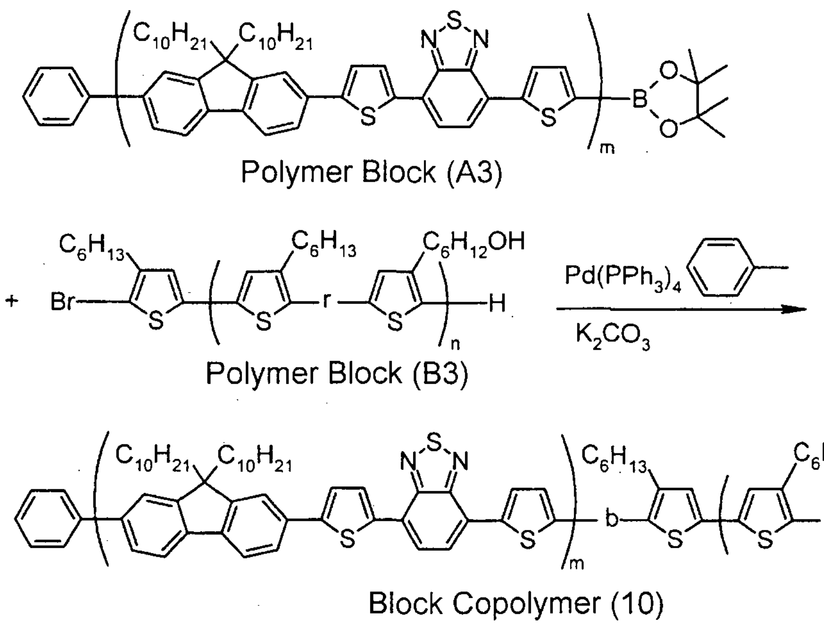


The block copolymer (10) (0.62 g, 36%) was obtained in the same manner as described in Example 7 except that the polymer block (A3) (1.0 g, 1.46 mmol) and the polymer block (B3) (0.73 g, 4.27 mmol) were used instead of the polymer block (B1) and the polymer block (A4). The weight average molecular weight and the number average molecular weight of the block copolymer (10) were each 90,500 and 42,500. The polydispersity thereof was 2.13.
$^1$H-NMR (270 MHz, $CDCl_3$): $\delta$ = 8.11 (d, J = 3.5 Hz, 2H), 8.08 - 7.93 (m, 8H), 7.45 (d, J = 3.6 Hz , 2H), 6.97 (s, 1H), 3.70 - 3.60 (m, 0.6H), 3.42 (m, 1H), 2.86 - 2.72 (m, 2H), 2.33 - 2.12 (m, 6H), 1.70 - 1.32 (m, 38H), 1.19-0.82 (m, 8H)

[Example 11]

A block copolymer (11) was synthesized according to the following reaction formula.

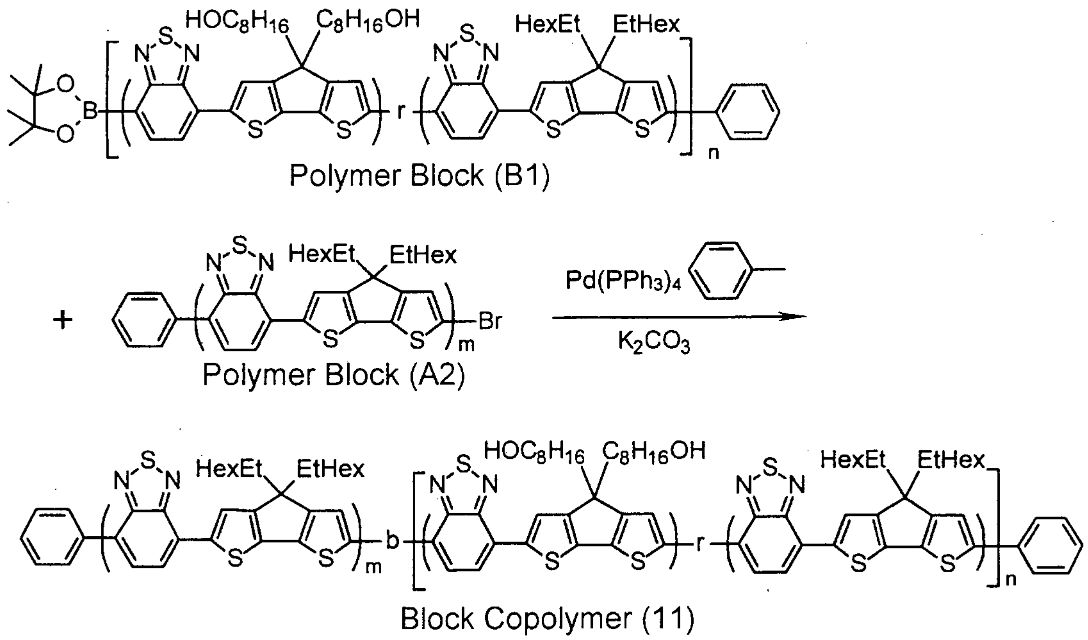


Polymer Block (B1)

Polymer Block (A2)

Block Copolymer (11)

The block copolymer (11) (0.78 g, 39%) was obtained in the same manner as described in Example 7 except that the polymer block (B1) (1.03 g, 1.87 mmol), and polymer block (A2) (0.96 g, 1.80 mmol) which was used instead of the polymer block (A4) were used. The weight average molecular weight and the number average molecular weight of the block copolymer (10) were each 107,300 and 41,600. The polydispersity thereof was 2.58.
$^1$H-NMR (270 MHz, $CDCl_3$): $\delta$ = 8.05 - 6.93 (m, 12H), 3.02 - 2.88 (m, 1.5H), 2.36 - 2.11 (m, 12H), 1.82 - 1.62 (m, 2.4H), 1.60 - 1.32 (m, 33H), 1.16 - 0.84 (m, 27H)

[Polymerization Example 8]

A polymer block (A5) was synthesized according to the following reaction formula.

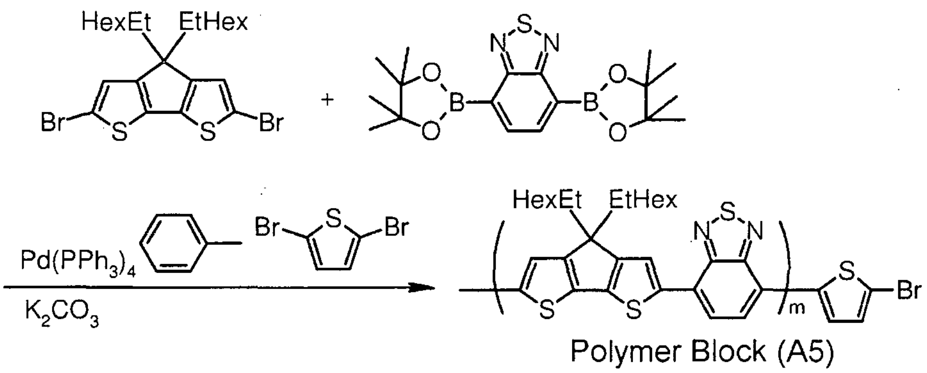


Polymer Block (A5)

Into a 100 mL three necked flask under a nitrogen atmosphere, 2,6-dibromo-4,4'-bis(2-ethylhexyl)cyclopenta [2,1-b:3,4-b']dithiophene (1.50 g, 2.68 mmol), 4,7-bis(3,3,4,4-tetramethyl-2,5,1-dioxaborolane-1-yl)benzo[c][1,2,5]thiadi azole (1.08 g, 2.68 mmol), toluene (51 mL), 0.21M aqueous solution of potassium carbonate (51 mL, 10.7 mmol), tetrakis (triphenylphosphine)palladium(0) (62.0 mg, 54.0 μmol), aliquat 336 (2 mg, 4.95 μmol), were charged and stirred for 1 hour at 80°C. Then, 2,5-dibromothiophene (6.47 g, 26.8 mmol) was added as a linker compound, and stirred for 16 hours at 80°C. After the completion of the reaction, the reacted mixture was poured into methanol (100 mL). The precipitated solid was collected by filtration and washed with water (100 mL) and methanol (100 mL). The obtained solid was dried under reduced pressure to obtain a crude product. The crude product was washed with acetone (200 mL) and hexane (200 mL), then extracted with chloroform (200 mL) using a Soxhlet extractor. The organic layer was concentrated to a solid. The obtained black purple solid was dissolved in chloroform (30 mL), and then reprecipitated in methanol (300 mL). The obtained solid was collected by filtration, and dried under reduced pressure, obtaining a black purple solid (1.24 g, 87%). Then the solid was purified using a preparative GPC column, obtaining a black purple solid

of polymer block (A5) (0.54 g, 38%). The weight average molecular weight and the number average molecular weight of the polymer block (A5) were each 29,800 and 18,600. The polydispersity thereof was 1.60.
$^{1}$H-NMR (270 MHz, $CDCl_3$): δ = 8.10 - 7.95 (m, 2H), 7.80 - 7.61 (m, 2H), 2.35 - 2.12 (m, 4H), 1.60 - 1.32 (m, 18H), 1.18 - 0.82 (m, 12H)

[Polymerization Example 9]

A polymer block (A6) was synthesized according to the following reaction formula.

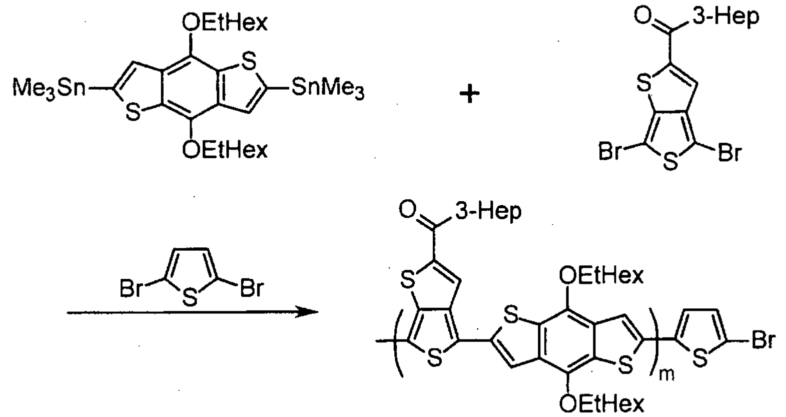

Polymer Block (A6)

Into a 50 mL eggplant flask under a nitrogen atmosphere, as monomers that might constitute the polymer block (A) 2,6-bis(trimethyltin)-4,8-bis(2-ethylhexyloxy)benzo[1,2-b:4,5-b']dithiophe ne (0.66 g, 0.86 mmol), 1-(4,6-dibromothieno[3,4-b]thiophene-2-yl)-2-ethylhexane-1-on (0.32 g, 0.75 mmol) were added. Then DMF (1.1 mL), toluene (4.3 mL), tetrakis(triphenylphosphine)palladium(0) (9.2 mg, 7.8 μmol) were added and stirred for 1.5 hours at 115°C. Then 2,5-dibromothiophene (1.84 g, 7.6 mmol) was added as a linker compound and heating was continued for 8 hours at 115°C. After completion of the reaction, the reaction mixture was poured into methanol (500 mL) the precipitated solid was collected by filtration and dried under reduced pressure, obtaining a crude product. The crude product was washed with acetone (200 mL) and hexane (200 mL), and then extracted with chloroform (30 mL) using a Soxhlet extractor. The organic layer was concentrated to a solid. The obtained black purple solid was dissolved in chloroform (30 mL), then re-precipitated in methanol (300 mL). The obtained solid was collected by filtration and then dried under reduced pressure to obtain a polymer block (A6), a black purple solid (0.53 g, quant.). The weight average molecular weight and the number average molecular weight of the polymer block (A6) were each 519,000 and 89,000. The polydispersity thereof was 5.89.
$^{1}$H-NMR (270 MHz, $CDCl_3$): δ = 7.60 - 7.30 (br, 3H), 4.30 - 4.00 (br, 4H), 3.20 - 3.00 (Br, 1H), 2.00 - 0.60 (br, 44H)

[Polymerization Example 10]

A polymer block (A7) was synthesized according to the following reaction formula.

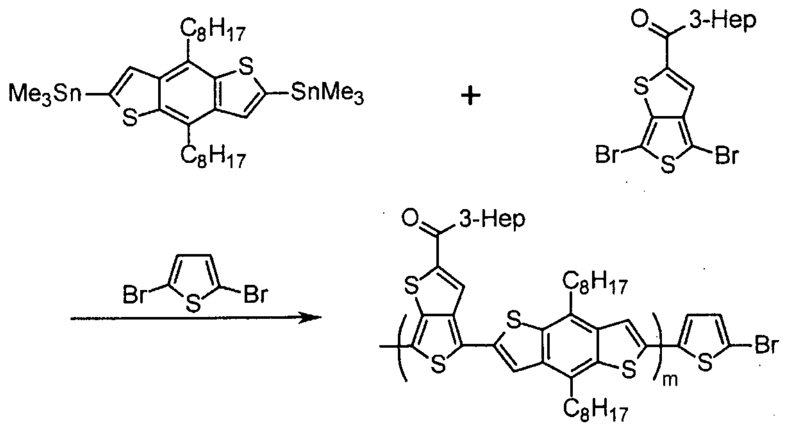

Polymer Block (A7)

The polymer block (A7) was carried out in a similar manner described in Example 9 except that 2,6-bis(trimethyltin)-4,8-dioctylbenzo[1,2-b:4,5-b']dithiophene (0.59 g, 0.79 mmol) and 1-(4,6-dibromothieno[3,4-b]thiophene-2-yl)-2-ethylhexane-1-on (0.32 g, 0.75 mmol) were used as monomers that might constitute the polymer block (A). The weight average molecular weight and the number average molecular weight of the obtained polymer block (A7) (0.47 g, 93%) were each 680,000 and 60,000. The polydispersity thereof was 11.3.
$^1$H-NMR (270 MHz, $CDCl_3$): δ = 7.60 - 7.30 (br, 3H), 3.30 - 0.30 (br, 5H), 2.00 - 1.20 (br, 32H), 1.00 - 0.70 (br, 12H)

[Polymerization Example 11]

A polymer block (A8) was synthesized according to the following reaction formula.

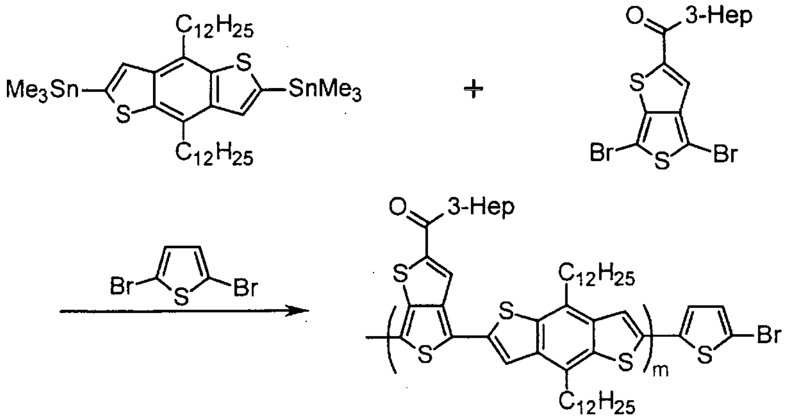

Polymer Block (A8)

The polymer block (A8) (0.51 g, 86%) was obtained in a similar manner as described in Polymerization Example 9, except that 2,6-bis(trimethyltin)-4,8-didodecylbenzo[1,2-b:4,5-b']dithyophene (0.74 g, 0.87 mmol) and 1-(4,6-dibromothieno[3,4-b]thiophene-2-yl)-2-ethylhexane-1-on (0.32 g, 0.75 mmol) were used as monomers that might constitute the polymer block (A).
$^1$H-NMR (270 MHz, $CDCl_3$), δ = 7.60 - 7.30 (br, 3H), 3.30 - 3.00 (Br, 5H), 2.00 - 1.10 (br, 52H), 1.00 - 0.70 (br, 12H)

[Polymerization Example 12]

A polymer block (A9) was synthesized according to the following reaction formula.

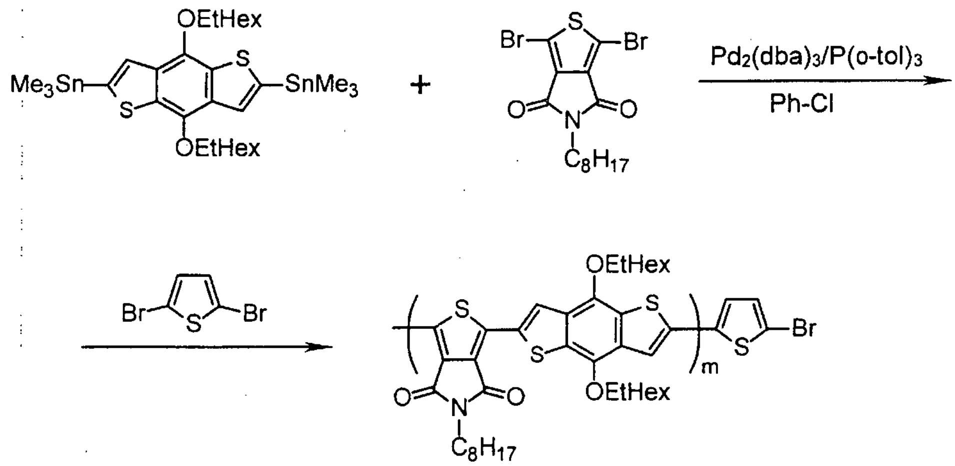


Polymer Block (A9)

In a 50 mL eggplant flask under a nitrogen atmosphere, tris(o-tolyl)phosphine (37 mg, 0.12 mmol), tris(dibenzylideneacetone)dipalladium (14 mg, 15 μmol) and chlorobenzene (32 mL) were heated for 10 minutes at 50°C. The temperature was once cooled down to room temperature. Then 2,6-bis(trimethyltin)-4,8-di(ethylhexyloxy)benzo[1,2-b:

4,5-b']dithiophene (0.64 g, 0.75 mmol) and 1,3-dibromo-5-octylthieno[3,4-c]pyrrole-4,6-dione (0.32 g, 0.75 mmol) were added as monomers that might constitute the polymer block (A9), then heated for 3 hours at 130°C. Next, 2,5-dibromothiophene (1.84 g, 7.6 mmol) was added as a linker compound and heated for 8 hours at 115°C. After the completion of the reaction, polymer block (A9) (0.51 g, 96%) was obtained in a similar manner as described in Polymerization Example 9. The weight average molecular weight and the number average molecular weight of the obtained polymer block (A9) were each 250,000 and 52,000. The polydispersity thereof was 4.80.
$^1$H-NMR: δ = 8.52 (br, 2H), 4.65 - 3.66 (br, 4H), 3.58 (s, 2H), 1.38 - 1.25 (m, 30H), 0.97-0.90 (br, 15H)

[Example 12]

A block Copolymer (12) was synthesized according to the following reaction formula.

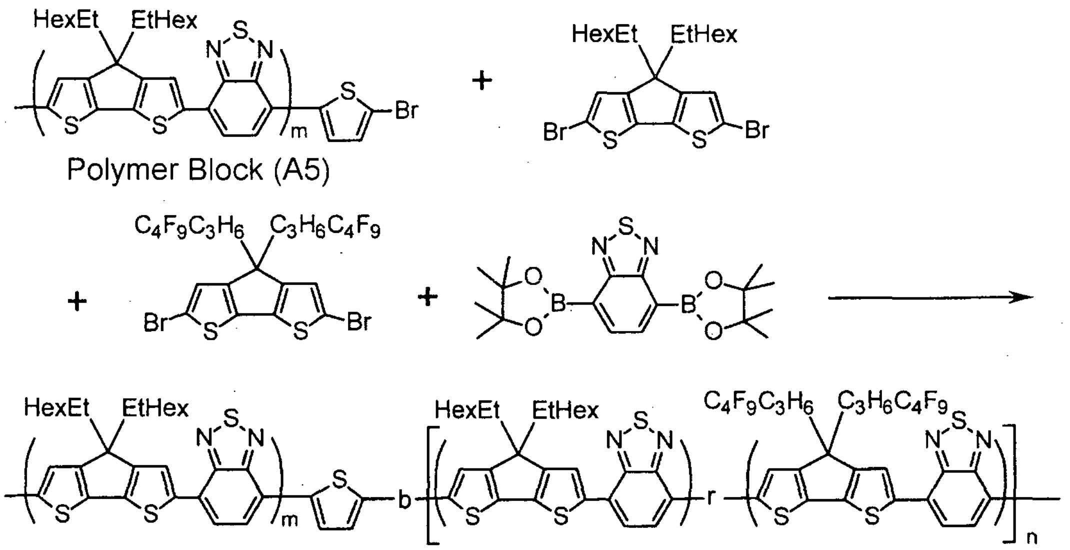

Polymer Block (A5)

Block Copolymer (12)

In a 25 mL three-necked flask under a nitrogen atmosphere, the polymer block (A5) (0.50 g, 0.94 mmol), plurality of monomers of 2,6-dibromo-4,4'-bis(2-ethylhexyl)cyclopenta[2,1-b:3,4-b']dithiophene (0.26 g, 0.47 mmol), 2,6-dibromo-4,4'-bis(4,4,5,5,6,6,7,7,7-nonafluoroheptyl)cyclopenta[2,1-b: 3,4-b']dithiophene (0.41 g, 0.47 mmol) and 4,7-bis(3,3,4,4-tetramethyl-2,5,1-dioxaborolane-1-yl)benzo[c][1,2,5]thiadi azole (0.47 g, 1.22 mmol), which might constitute the polymer block (B), were added. Further, toluene (6.8 mL), 2M aqueous solution of potassium carbonate (3.4 mL, 6.8 mmol), tetrakis(triphenylphosphine)palladium(0) (8.17 mg, 7.07 μmol) and aliquat 336 (8.0 mg, 19.8 μmol) were added and stirred for 24 hours at 80°C. After the completion of the reaction, the reacted mixture was poured into methanol (200 mL), obtaining a precipitated solid that was then collected by filtration and washed with water (20 mL) and with methanol (20 mL), then dried under reduced pressure, obtaining a crude product. After washed with acetone (500 mL) and hexane (500 mL), the crude product was extracted with chloroform (500 mL) using a Soxhlet extractor. The organic layer was concentrated to dryness. The black purple solid was dissolved in chloroform (30 mL) and was reprecipitated with methanol (300 mL). The solid was collected by filtration and dried under reduced pressure to obtain the block copolymer (12) (0.57 g, 76%) as a solid black purple. The weight average molecular weight and the number average molecular weight of the obtained block polymer (12) were each 76,700 and 27,200. The polydispersity thereof was 2.82.
$^1$H-NMR (270 MHz, $CDCl_3$): δ = 8.12 - 7.96 (m, 8H), 7.90 - 7.61 (m, 8H), 2.75 (t, J = 7.56 Hz, 4H), 2.35 - 1.92 (m, 20H), 1.59- 1.32 (m, 54H), 1.18 - 0.81 (m, 36H))

[Example 13]

A block copolymer (13) was synthesized according to the following reaction formula.

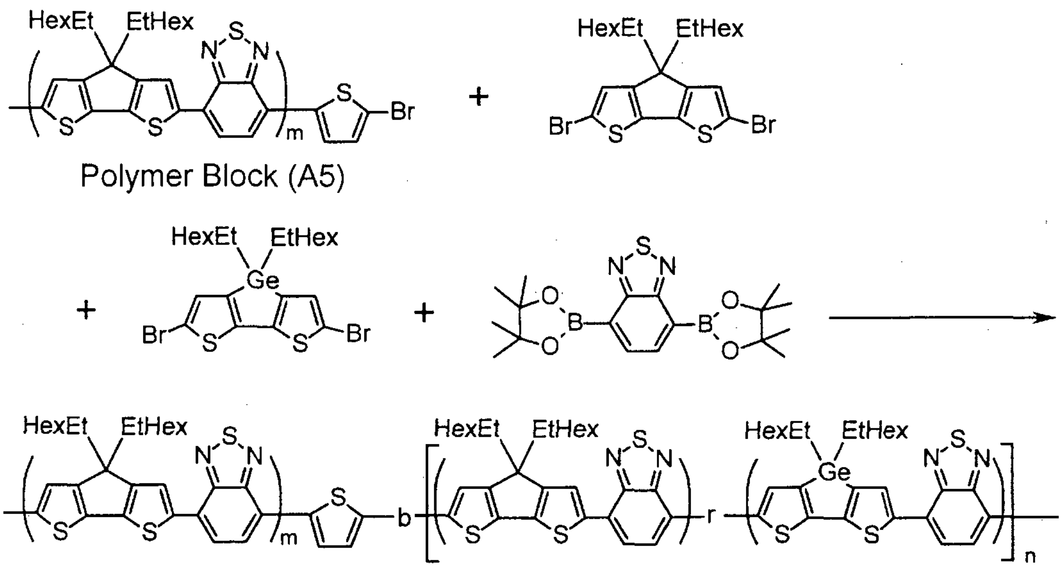

Polymer Block (A5)

Block Copolymer (13)

The block copolymer (13) was synthesized in a similar manner as described in Example 12 except that the polymer block (A5) (0.5 g, 0.93 mmol), and 2,6-dibromo-4,4'-bis(2-ethylhexyl)cyclopenta[2,1-b:3,4-b']dithiophene (0.26 g, 0.47 mmol), 2,6-dibromo-4,4'-bis(2-ethylhexyl)-dithieno[2,1-b:3,4-b']germole (0.29 g, 0.47 mmol) and 4,7-bis(3,3,4,4-tetramethyl-2,5,1-dioxaborolane-1-yl)benzo[c][1,2,5]thiadi azole (0.47 g, 1.22 mmol) for being two types monomers which might constitute the polymer block (B), were added. The weight average molecular weight and the number average molecular weight of the obtained block polymer (13) (0.74 g, 70%) were each 78,000 and 28,500. The polydispersity thereof was 2.74.

$^1$H-NMR (270 MHz, $CDCl_3$): $\delta$ = 8.12 - 7.94 (m, 2H), 7.81 - 7.61 (m, 2H), 2.35 - 2.10 (m, 4H), 1.62 - 1.29 (m, 18H), 1.21 - 0.84 (m, 12H)

[Example 14]

A block copolymer (14) was synthesized according to the following reaction formula.

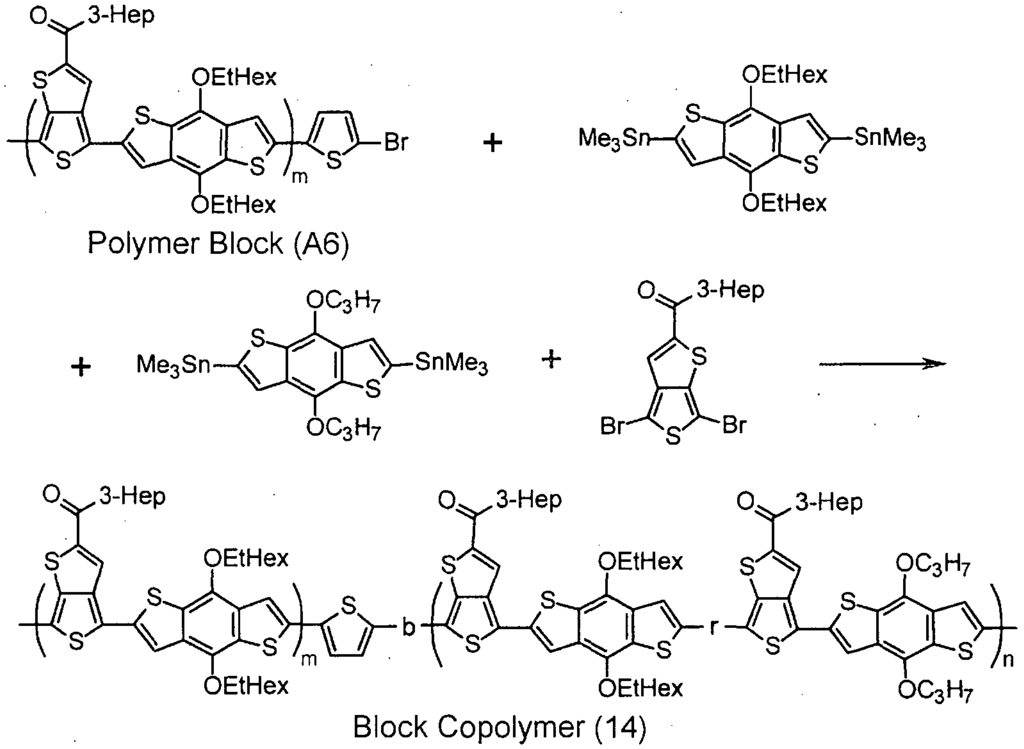

Polymer Block (A6)

Block Copolymer (14)

Into a 5 mL flask under argon atmosphere, the polymer block (A6) (60.0 mg, 0.08 mol), and 2,6-bis(trimethyltin)-4,8-bis(2-ethylhexyloxy)benzo[1,2-b:4,5-b']dithiophe ne (58.5 mg, 0.076 mmol), 2,6-bis(trymethyltin)-4,8-bis(propyloxy) benzo[1,2-b:4,5-b']dithiophene (25.2 mg, 0.05 mmol) and 1-(4,6-dibromothieno[3,4-b]thiophene-2-yl)-2-ethylhexane-1-on (36.0 mg, 0.085 mmol) for being two types monomers which might constitute the polymer block (B), were added. And DMF (0.3 mL), toluene (1.4 mL) and tetrakis(triphenylphosphine)palladium(0) (3.4 mg, 2.98 μmol) were added. Babbling was carried out within the reaction container with argon gas for 20 minutes, and then the container was heated for 10 hours at 110°C. After the completion of the reaction, the reaction mixture was poured into methanol (500 mL) and the precipitated solid was collected by filtration and dried under reduced pressure, obtaining a crude product. The crude product was washed with acetone (200 mL) and hexane (200 mL), then extracted with chloroform (200 mL) using a Soxhlet extractor. The obtained solution was poured into methanol (300 mL), then the precipitated solid was collected by filtration and dried under reduced pressure, obtaining the block copolymer (14) (76.3 mg, 65%) as a black purple solid. The weight average molecular weight and the number average molecular weight of the obtained block polymer (14) were each 245,000 and 18,000. The polydispersity thereof was 13.60.
$^1$H-NMR (270 MHz, $CDCl_3$): $\delta$ = 7.60 - 7.30 (br, 3H), 4.40 - 4.00 (br, 4H), 3.20 - 3.00 (Br, 1H), 2.00 - 0.60 (br, 39H)

[Example 15]

A block copolymer (15) was synthesized according to the following reaction formula.

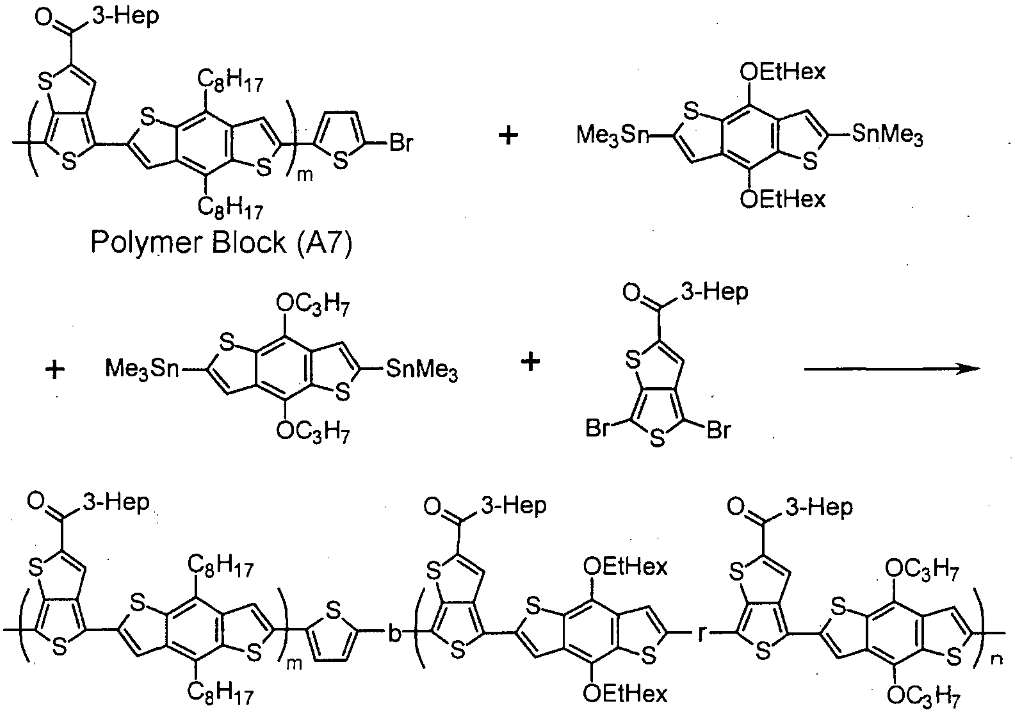

Polymer Block (A7)

Block Copolymer (15)

The block copolymer (15) (105.5 mg, 66.4%) was synthesized in a similar manner as described in Example 14 except that the polymer block (A7) (80.0 mg, 0.12 mol), and 2,6-bis(trimethyltin)-4,8-bis(2-ethylhexyloxy)benzo[1,2-b:4,5-b']dithiophe ne (71.4 mg, 0.09 mmol), 2,6-bis(trimethyltin)-4,8-bis(propyloxy)benzo[1,2-b:4,5-b']dithiophene (25.1 mg, 0.04 mmol) and 1-(4,6-dibromothieno[3,4-b]thiophene-2-yl)-2-ethylhexane-1-on (50.1 mg, 0.12 mmol) for being two types monomers which might constitute the polymer block (B), were used.

$^1$H-NMR (270 MHz, $CDCl_3$): $\delta$ = 7.60 - 7.30 (br, 3H), 4.40 - 4.00 (br, 4H), 3.20 - 3.00 (br, 3H), 2.00 - 0.60 (br, 41H)

[Example 16]

A block copolymer (16) was synthesized according to the following reaction formula.

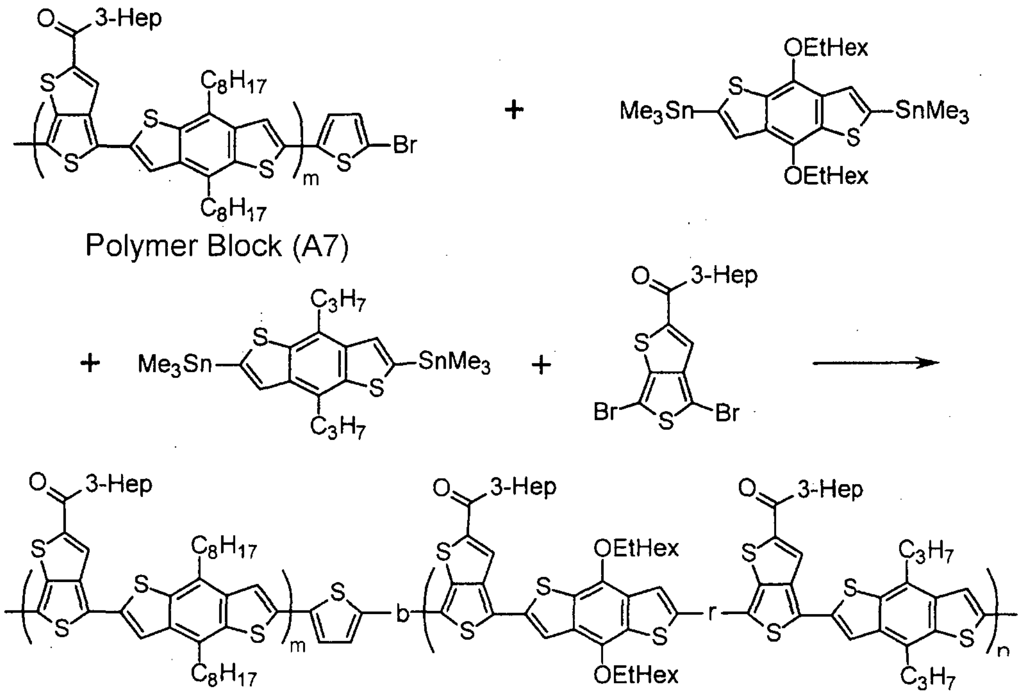

Polymer Block (A7)

Block Copolymer (16)

The block copolymer (16) (116.1 mg, 73.1%) was synthesized in a similar manner as described in Example 14 except that the polymer block (A7) (80.0 mg, 0.12 mol), and 2,6-bis(trimethyltin)-4,8-bis(2-ethylhexyloxy)benzo[1,2-b: 4,5-b']dithiophe ne (71.4 mg, 0.09 mmol), 2,6-bis(trimethyltin)-4,8-dipropylbenzo[1,2-b:4,5-b']dithiophene (23.8 mg, 0.04 mmol) and 1-(4,6-dibromothieno[3,4-b]thiophene-2-yl)-2-ethylhexane-1-on (50.1 mg, 0.12 mmol) for being two types monomers which might constitute a polymer block (B), were used.

$^1$H-NMR (270 MHz, $CDCl_3$): $\delta$ = 7.60 - 7.30 (br, 3H), 4.40 - 4.00 (br, 4H), 3.30 - 3.00 (Br, 4H), 2.00 - 0.60 (br, 41H)

[Example 17]

A block copolymer (17) was synthesized according to the following reaction formula.

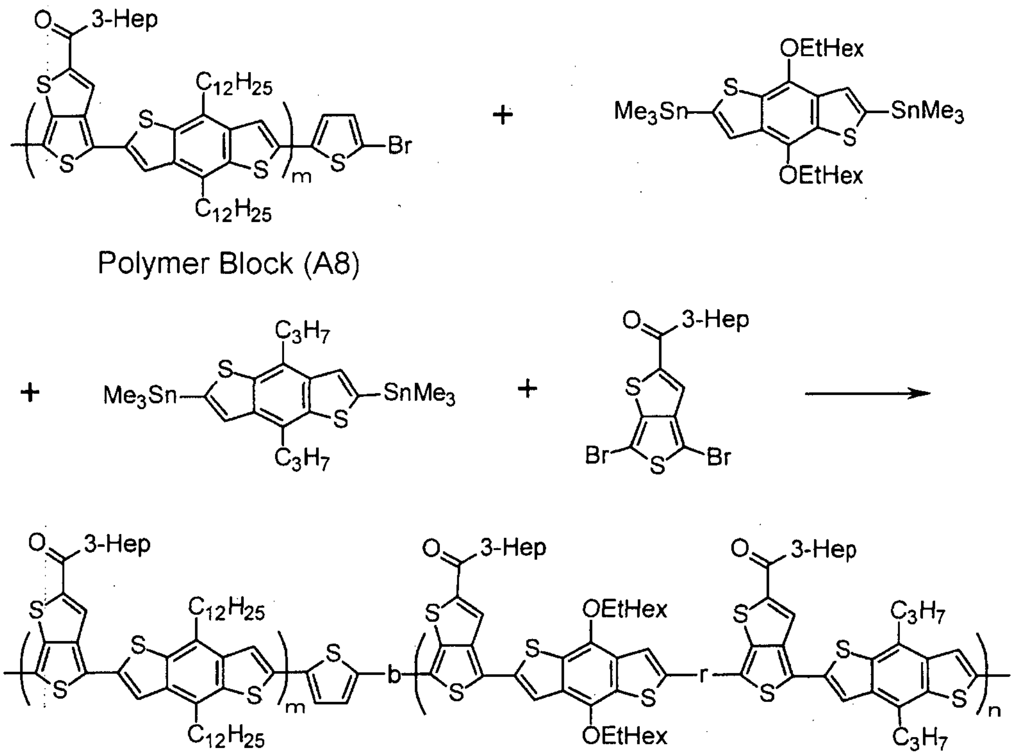

Polymer Block (A8)

Block Copolymer (17)

The block copolymer (17) (221.0 mg, 75.4%) was synthesized in a similar manner as described in Example 14 except that the polymer block (A8) (160.0 mg, 0.12 mol), and 2,6-bis(trimethyltin)-4,8-bis(2-ethylhexyloxy)benzo[1,2-b:4,5-b']dithiophe ne (113.0 mg, 0.16 mmol), 2,6-bis(trimethyltin)-4,8-dipropylbenzo[1,2-b:4,5-b']dithiophene (40.9 mg, 0.07 mmol) and 1-(4,6-dibromothieno[3,4-b]thiophene-2-yl)-2-ethylhexane-1-on (86.0 mg, 0.20 mmol) for being two types monomers which might constitute the polymer block (B), were used.
$^1$H-NMR (270 MHz, $CDCl_3$): $\delta$ = 7.60 - 7.30 (br, 3H), 4.40 - 4.00 (br, 4H), 3.30 - 3.00 (Br, 4H), 2.00 - 0.60 (br, 51H)

[Example 18]

A block copolymer (18) was synthesized according to the following reaction formula.

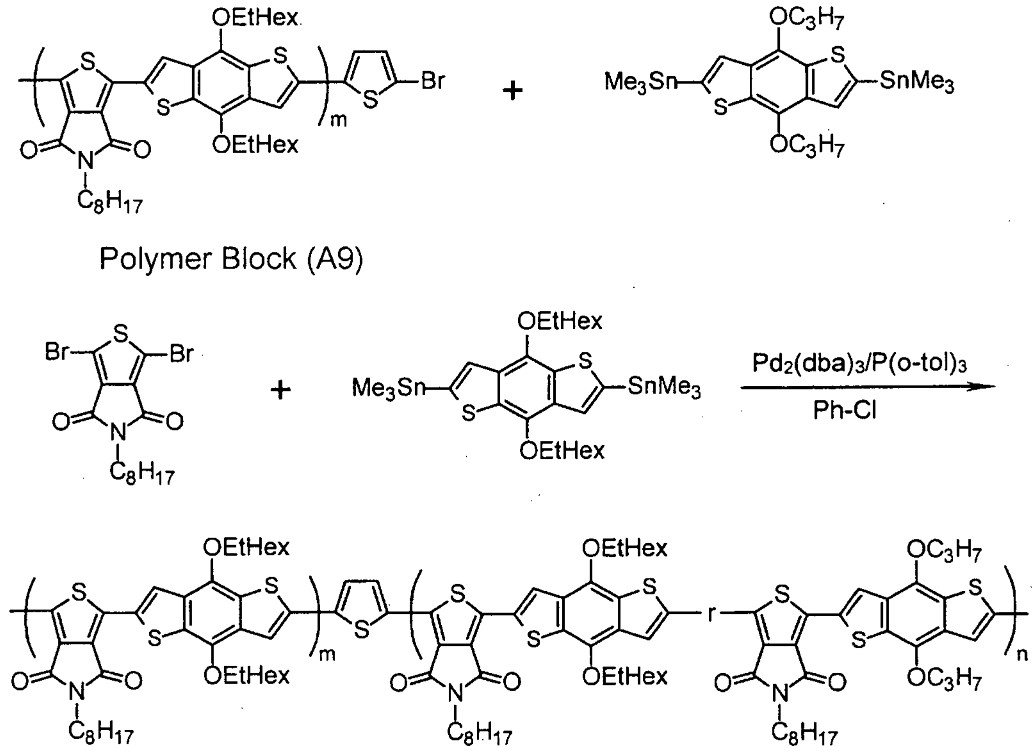


Polymer Block (A9)

Block Copolymer (18)

In 50 mL eggplant flask under a nitrogen atmosphere, tris(o-tolyl)phosphine (37 mg, 0.12 mmol), tris(dibenzylideneacetone dipalladium) (14 mg, 15 μmol) and chlorobenzene (32 mL) were heated for 10 minutes at 50°C. Then the temperature was allowed to cool to room temperature. Then polymer block (A9) (0.16 g, 0.12 mmol), and 2,6-bis(trimethyltin)-4,8-bis(propyloxy)benzo[1,2-b:4,5-b']dithiophene (24 mg, 0.04 mmol), 2,6-bis(trimethyltin)-4,8-bis(2-ethylhexyloxy)benzo[1,2-b:4,5-b']dithiophe ne (65 mg, 0.08 mmol) and 1,3-dibromo-5-octylthieno[3,4-c]pyrrole-4,6-dione (51 mg, 0.12 mmol) for being two types monomers which might constitute the polymer block (B), were added, then heated for 15 hours at 130°C. After completion of the reaction, the block copolymer (18) (0.16 g, 69%) was obtained in a similar manner as described in Example 14. The weight average molecular weight and the number average molecular weight of the obtained block polymer (18) were each 908,000 and 250,000. The polydispersity thereof was 8.90.
$^1$H-NMR: $\delta$ = 8.52 (br, 2H), 4.65 - 3.66 (br, 4H), 3.58 (s, 2H), 1.38 - 1.25 (m, 26H), 0.97 - 0.90 (br, 13H)

[Preparation of the Mixed Solution of the Electron Accepting Material and the Block Copolymer]

16.0 mg of the block copolymer (1) obtained in Example 1, 12.8 mg of PCBM (E100H produced by Frontier Carbon Corporation) as an electron accepting material and 1 mL chlorobenzene as solvent were mixed for 6 hours at 40°C. After that, the temperature was cooled to room temperature (20°C). The mixture was filtered using a PTFE filter with a pore size of 0.45 μm, obtaining a solution containing a block copolymer and PCBM. PCBM containing solution was also prepared from each block copolymer (2) - (18) obtained in Examples 2 - 18 in the same way as described here.

[Production of Organic Solar Cell with a Layer of Block Copolymer Composition]

A glass substrate having an ITO film (resistance 10Ω / □) with a thickness of 150 nm by sputtering was subjected to a surface treatment by ozone UV treatment for 15 minutes. PEDOT : PSS aqueous solution (produced by H.C.Starck Inc., CLEVIOS PH500) was spin-coated to deposit a hole transport layer having a thickness of 40nm on the substrate by spin coating method. After 20 minutes heating and drying at 140°C with a hot plate, a solution containing the block copolymer prepared above and PCBM was applied by spin coating, obtaining an organic photoelectric conversion layer (thickness: about 100 nm) of an organic solar cell. After 3 hours vacuum drying, and after thermal annealing for 30 minutes at 120°C, lithium fluoride was deposited to a thickness of 1nm by a vacuum deposition device. And then Al was deposited to a film thickness of 100 nm.

An organic thin film solar cell was obtained as a photoelectric conversion element having a layer comprising a composition that included the block copolymer obtained in Examples 1 - 18. The size of the light receiving surface of

the organic thin film solar cell was a regular tetragon of 5 × 5 mm.

[Comparative Example 1]

By using a mixture of the polymer block (B3) (8 mg) obtained in Polymerization Example 3 and the polymer block (A4) (8 mg) obtained in Polymerization Example 7, a mixed solution with an electron accepting material was produced in the same manner as mentioned above, and an organic thin film solar cell of Comparative Example 1 was fabricated from the mixed solution.

[Comparative Example 2]

A diblock copolymer whose molar ratio of 3-hexylthiophene and 3-(2-ethylhexyl)thiophene was 8 : 2 was synthesized (detailed step-by-step procedure is described in J. Am. Chem. Soc., 130, p.7812 (2008) (Non-Patent Document 2)). Then a mixed solution with the electron accepting material was produced in the same manner as described above. By using the mixed solution, an organic thin film solar cell of Comparative Example 2 was produced.

[Comparative Example 3]

A diblock copolymer whose molar ratio of 3-butylthiophene and 3-octylthiophene was 1 : 1 was synthesized (detailed step-by-step procedure is described in Chem. Mater., 22, p.2020 (2010) (Non-Patent Document 4)). Then a mixed solution including the electron accepting material was produced in the same manner as described above. By using the mixed solution, an organic thin film solar cell of Comparative Example 3 was produced.

[Comparative Example 4]

By using a mixture of the polymer block (B1) (8 mg) obtained in Polymerization Example 1 and a polymer block (A4) (8 mg) obtained in Polymerization Example 7, a mixed solution including the electron accepting material was produced in the same manner as described above. By using the mixed solution, an organic thin film solar cell of Comparative Example 4 was produced.

[Comparative Example 5]

A diblock copolymer of an alternating copolymer block comprising a dialkyl fluorene and a substituted thiophene 5-mer and another alternating copolymer block comprising a dialkyl fluorene and a dithienobenzothiadiazole was synthesized (detailed step-by-step procedure is described in Japan Patent Publication No. 2008-266459 (Patent Document 1)). An organic thin film solar cell of Comparative Example 5 was produced in the same manner as described in the Examples and Comparative Examples.

[Evaluation of Organic Solar Cells]

Photoelectric conversion efficiencies of organic thin film solar cells of Examples and Comparative Examples were measured using 300 W Solar Simulator (Peccell Technologies, Inc., trade name PEC L11 : AM1.5G filter, irradiance 100 mW/cm$^2$). Measurement results are shown in Tables 1 - 3.

Table 1

| | Block Copolymer | Polymer Block (A) | Polymer Block (B) | Photoelectric Conversion Efficiency (%) |
|---|---|---|---|---|
| Ex. 1 | Block Copolymer (1) | 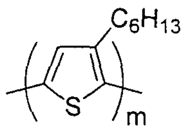 | 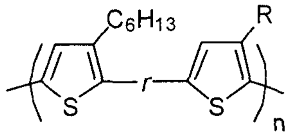 R=2-ethylhexyl | 3.3 |

(continued)

| | Block Copolymer | Polymer Block (A) | Polymer Block (B) | Photoelectric Conversion Efficiency (%) |
|---|---|---|---|---|
| Ex. 2 | Block Copolymer (2) | 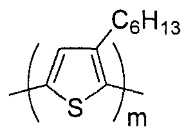 | 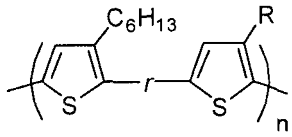 R=6-bromohexyl | 4.3 |
| Ex. 3 | Block Copolymer (3) | 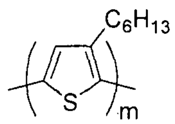 | 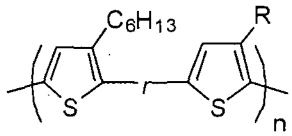 R=4,4,5,5,6,6,7,7,7,-nonafluoroheptyl | 4.0 |
| Ex. 4 | Block Copolymer (4) | 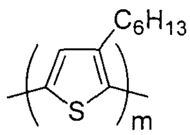 | 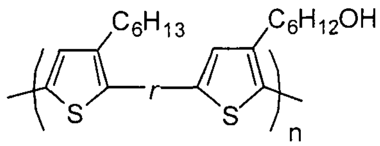 | 3.2 |
| Ex. 5 | Block Copolymer (5) | 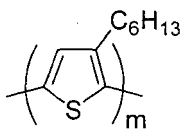 | 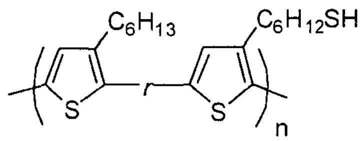 | 3.2 |
| Ex. 6 | Block Copolymer (6) | 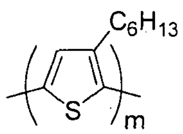 | 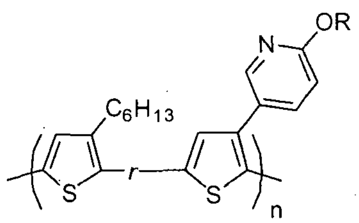 R=3,7-dimethyloctyl | 3.1 |
| Comp. Ex. 1 | Mixture of Polymer Block (A4) and Polymer Block (B3) | 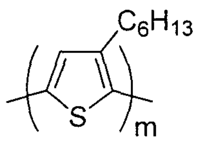 | 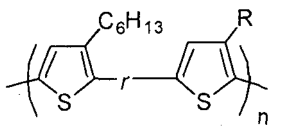 R=6-bromohexyl | 2.4 |
| Comp. Ex. 2 | Polymer Described in Non-patent Document 2 | 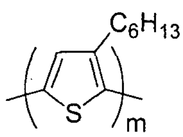 | 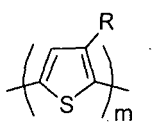 R=2-ethyhexyl | 2.8 |
| Comp. Ex. 3 | Polymer Described in Non-patent Document 4 | 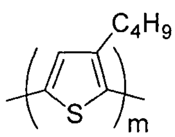 | 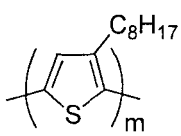 | 2.8 |

Table 2

| | Block Copolymer | Polymer Block (A) | Polymer Block (B) | Photoelectric Conversion Efficiency (%) |
|---|---|---|---|---|
| Ex.7 | Block Copolymer (7) | 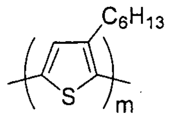 | 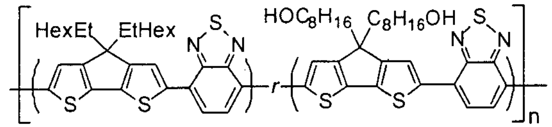 | 3.8 |
| Ex.8 | Block Copolymer (8) | 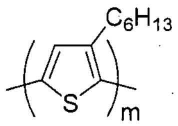 | 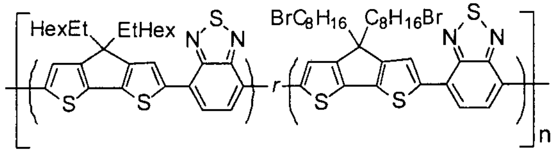 | 3.5 |
| Ex.9 | Block Copolymer (9) | 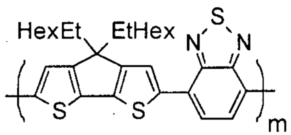 | 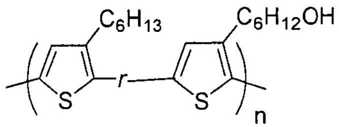 | 3.6 |
| Ex. 10 | Block Copolymer (10) | 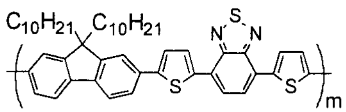 | 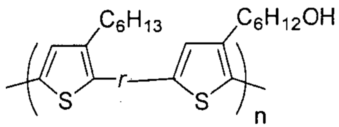 | 3.3 |
| Ex.11 | Block Copolymer (11) | 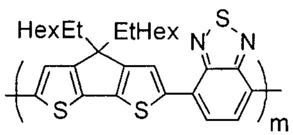 | 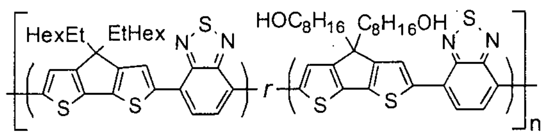 | 3.1 |
| Ex.12 | Block Copolymer (12) | 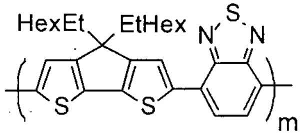 | 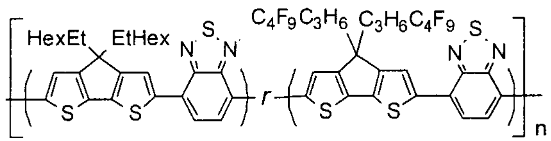 | 3.2 |
| Ex.13 | Block Copolymer (13) | 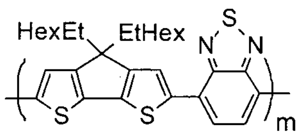 | 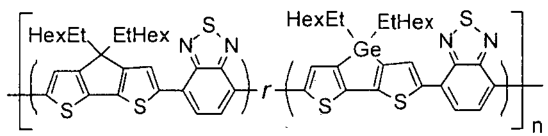 | 3.5 |

(continued)

| | Block Copolymer | Polymer Block (A) | Polymer Block (B) | Photoelectric Conversion Efficiency (%) |
|---|---|---|---|---|
| Comp. Ex. 4 | Mixture of Polymer Block (A4) and Polymer Block (B1) | 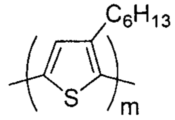 | 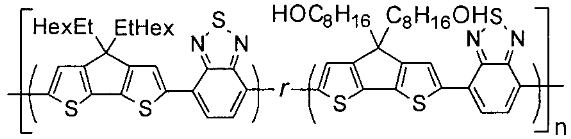 | 1.5 |
| Comp. Ex. 5 | Polymer Described in Non-patent Document 1 | 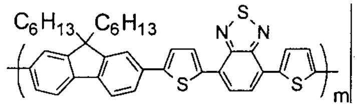 | 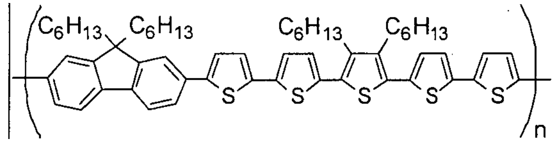 | 2.2 |

Table 3

| | Block Copolymer | Polymer Block (A) | Polymer Block (B) | Photoelectric Conversion Efficiency (%) |
|---|---|---|---|---|
| Ex. 14 | Block Copolymer (14) | 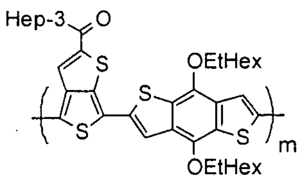 | 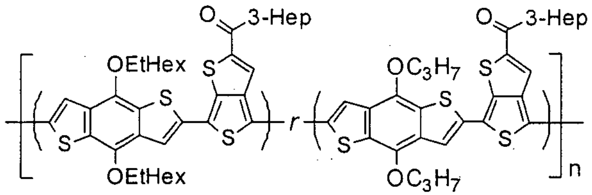 | 6.0 |
| Ex. 15 | Block Copolymer (15) | 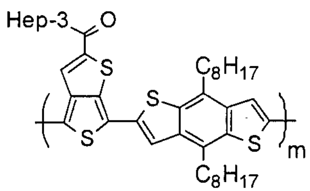 | 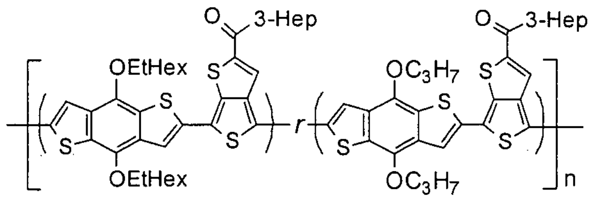 | 5.4 |
| Ex. 16 | Block Copolymer (16) | 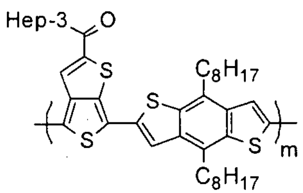 | 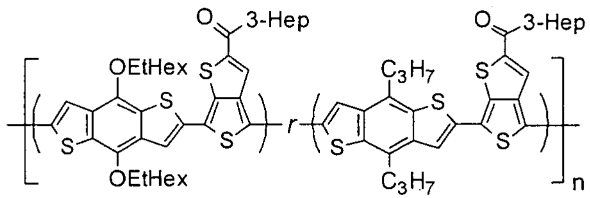 | 6.0 |
| Ex. 17 | Block Copolymer (17) | 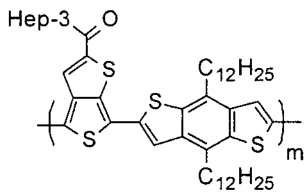 | 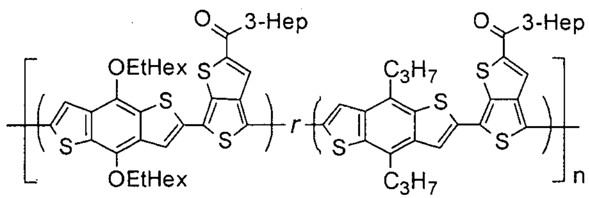 | 7.0 |
| Ex. 18 | Block Copolymer (18) | 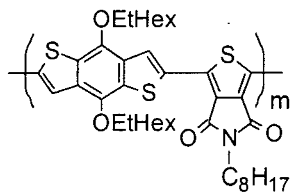 | 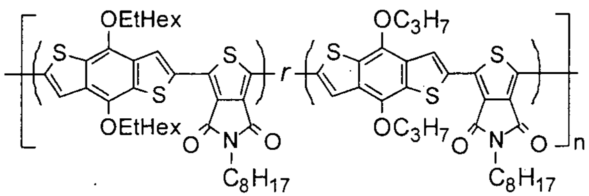 | 7.0 |

As is clear from Tables, the organic thin film solar cells produced using a π-electron conjugated block copolymer of the present invention having the copolymer block involving at least two types of monomer units each having a different substituent $R^{nB}$ from each other as the polymer block (B), showed a high photoelectric conversion efficiency compared to an organic thin film solar cell produced using a conventional π-electron conjugated

## Claims

1. A π-electron conjugated block copolymer contiguously or non-contiguously bonding a polymer block (A) involving a monomer unit having in a portion of a chemical structure at least one heteroaryl skeleton selected from a thiophene, a fluorene, a carbazole, a dibenzosilole and a dibenzogermole; and a polymer block (B) involving a monomer unit similarly having at least one heteroaryl skeleton; wherein
the polymer block (A) comprises a homopolymer block of a monomer unit having a substituent $R^{nA}$ that is an alkoxy group or an alkyl group having 1 - 18 carbon atoms, and
the polymer block (B) comprises a copolymer block of at least two different from each other types of monomer units having substituents $R^{nB}$ selected from an alkoxy group or an alkyl group having 1 - 18 carbon atoms, which may be substituted with an alkoxy group, a halogen atom, a hydroxyl group, an amino group, a thiol group, a silyl group, an aryl group, an ester group or a heteroaryl group.

2. The π-electron conjugated block copolymer according to Claim 1, which is **characterized in that** the heteroaryl skeleton of the monomer unit that constitutes the polymer block (A) and the polymer block (B) is a group having at least one thiophene ring in a portion of the chemical structure thereof.

3. The π-electron conjugated block copolymer according to Claim 1, which is **characterized in that** the polymer block (A) or the polymer block (B) includes a monomer unit of -a-b-, and
the -a- has any one of groups represented by chemical formulas (1) - (8) below,

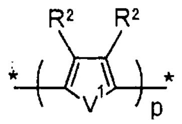

· · · (1)

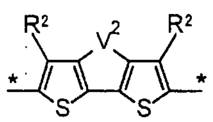

· · · (2)

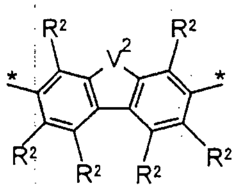

· · · (3)

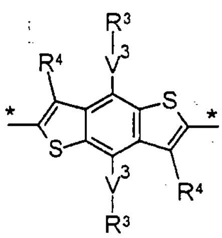

· · · (4)

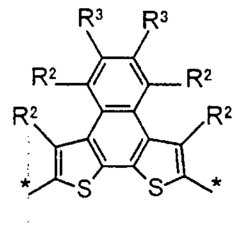

・・・ (5)

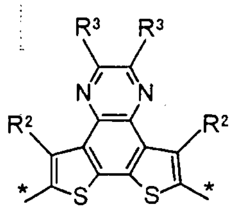

・・・ (6)

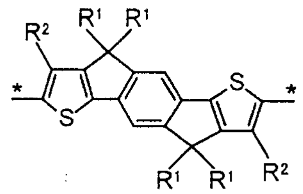

・・・ (7)

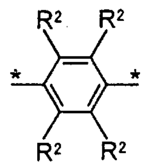

・・・ (8)

the -b- has any one of groups represented by chemical formulas (9) - (19) below,

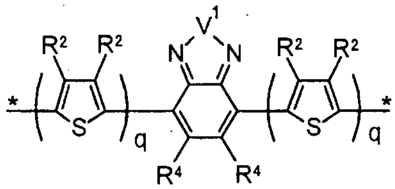

・・・ (9)

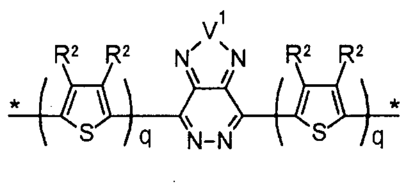

・・・ (10)

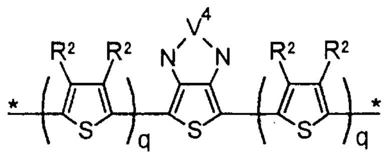

・・・ (11)

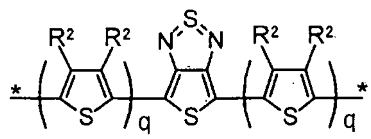

・・・ (12)

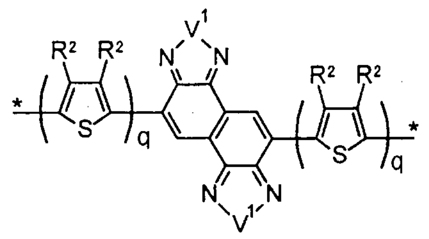

・・・ (13)

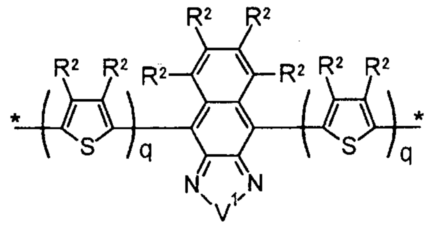

・・・ (14)

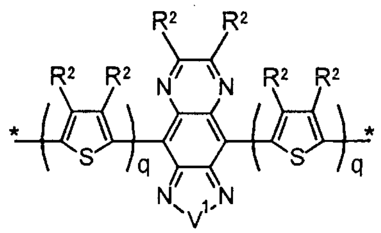

・・・ (15)

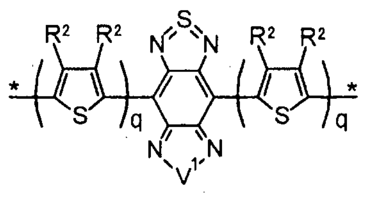

・・・ (16)

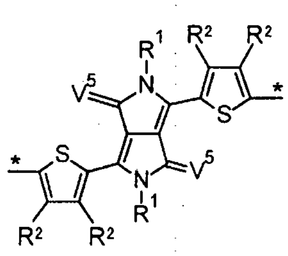

・・・ (17)

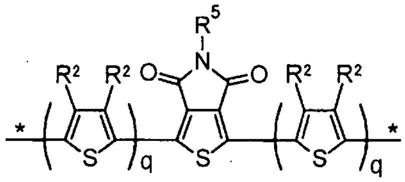

・・・（１８）

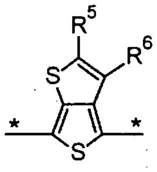

・・・（１９）

in the formulas (1) - (19):

$V^1$ is nitrogen ($-NR^1-$), oxygen (-O-) or sulfur (-S-); $V^2$ is carbon ($-CR^1_2-$), nitrogen ($-NR^1-$), silicone ($-SiR^1_2-$) or germanium ($-GeR^1_2-$); $V^3$ is an aryl group or hetero aryl group represented by -(Ar)q- ; $V^4$ is nitrogen ($-NR^1-$), oxygen (-O-) or $-CR^2=CR^2-$; and $V^5$ is oxygen (O) or sulfur (S):

$R^1$ is each independently an alkyl group having 1 - 18 carbon atoms which may be substituted, $R^2$ is each independently a hydrogen atom or an alkyl group having 1-18 carbon atoms which may be substituted each independently, $R^3$ is each independently an alkyl group or an alkoxy group having 1-18 carbon atoms which may be substituted, $R^4$ is each independently a hydrogen atom, a halogen atom, or an aryl group or an alkyl group having 1-18 carbon atoms which may be substituted, $R^5$ is an aryl group, an alkylcarbonyl group, an alkyloxy carbonyl group, or an alkyl group having 1 - 18 carbon atoms which may be substituted, $R^6$ is a hydrogen atom or a halogen atom:

p is an integer of 1 - 3 and q represents an integer of 0 - 3:

here, at least one of $R^1$ - $R^5$ of monomer unit -a-b-, which is included in the polymer block (A), is $R^{nA}$, and at least one of $R^1$ - $R^5$ of monomer unit -a-b-, which is included in the polymer block (B), is $R^{nB}$ that may be substituted with an alkoxy group, a halogen atom, a hydroxyl group, an amino group, a thiol group, a silyl group, an ester group, an aryl group or a heteroaryl group.

4. The $\pi$-electron conjugated block copolymer according to Claim 3, which is **characterized in that** the monomer unit -a-b- is any one of groups selected from the following chemical formulas (20) - (31),

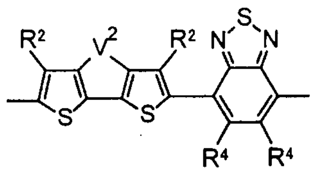

・・・（２０）

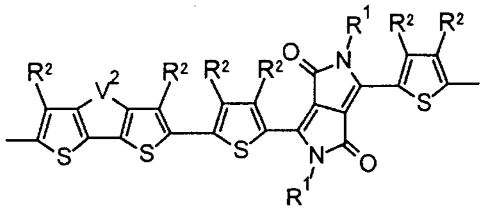

・・・（２１）

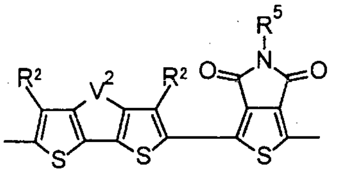

・・・（２２）

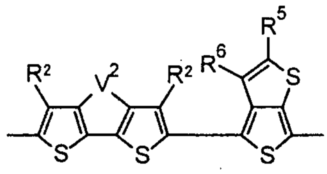

・・・（２３）

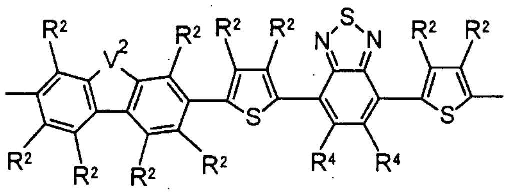

・・・（２４）

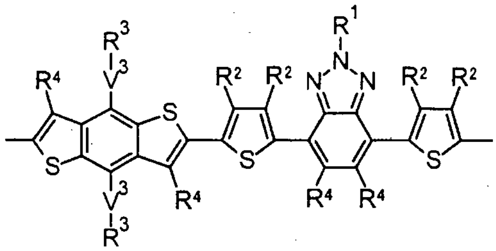

・・・（２５）

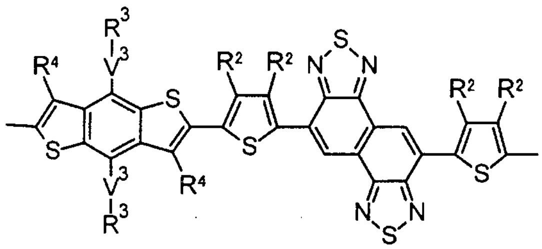

・・・（２６）

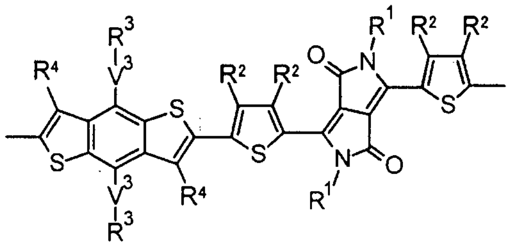

・・・（２７）

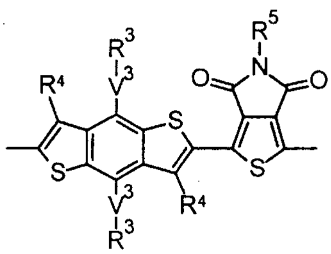

・・・（２８）

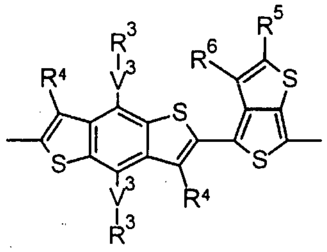

・・・(29)

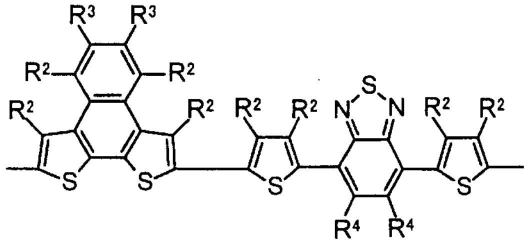

・・・(30)

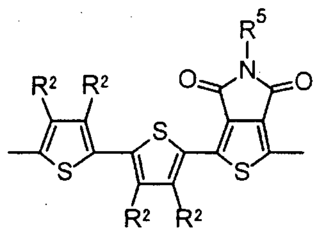

・・・(31)

in the formulas (20) - (31):

$V^2$ is a carbon ($-CR^1{}_2-$), nitrogen ($-NR^1-$), silicon ($-SiR^1{}_2-$) or germanium ($-GeR^1{}_2$); $V^3$ is an aryl group or a heteroaryl group represented by -(Ar)q-:
$R^1$, $R^2$, $R^3$, $R^4$, $R^5$ and $R^6$ are the same as defined above:
q represents an integer of 0 - 3 :
here, at least one of $R^1$ - $R^5$ of monomer unit -a-b-, which is included in the polymer block (A), is $R^{nA}$ and at least one of $R^1$ - $R^5$ of the monomer unit -a-b-, which is included in the polymer block (B), is $R^{nB}$ that may be substituted with an alkoxy group, a halogen atom, a hydroxyl group, an amino group, a thiol group, a silyl group, an ester group, an aryl group or a heteroaryl group.

5. The $\pi$-electron conjugated block copolymer according to Claim 3, which is **characterized in that** a polymer block including the monomer unit -a-b- is both of the polymer block (A) and the polymer block (B).

6. The $\pi$-electron conjugated block copolymer according to Claim 1, which is **characterized in that** the polymer block (B) is a random copolymer.

7. The $\pi$-electron conjugated block copolymer according to Claim 6, which is **characterized in that** the random copolymer comprises a plurality of different types of monomer units -a-b- from each other.

8. A composition comprising an electron accepting material and the $\pi$-electron conjugated block copolymer above claimed.

9. A photoelectric conversion element comprising a layer essentially consisting of the composition according to Claim 8.

10. The photoelectric conversion element according to Claim 9, which is **characterized in that** the electron accepting material comprises a fullerene or/and a derivative thereof.

**INTERNATIONAL SEARCH REPORT**

International application No.
PCT/JP2012/056118

A. CLASSIFICATION OF SUBJECT MATTER
*C08G61/12*(2006.01)i, *C08K3/04*(2006.01)i, *C08L65/00*(2006.01)i, *H01L51/42* (2006.01)i

According to International Patent Classification (IPC) or to both national classification and IPC

B. FIELDS SEARCHED

Minimum documentation searched (classification system followed by classification symbols)
C08G61/12, C08K3/04, C08L65/00, H01L51/42

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | WO 2009/104781 A1 (Sumitomo Chemical Co., Ltd.),<br>27 August 2009 (27.08.2009),<br>claims; examples<br>& JP 2010-74127 A & US 2010/0327271 A1<br>& EP 2246382 A1 & CN 101945922 A<br>& KR 10-2010-0116667 A | 1,2,8-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 June, 2012 (01.06.12) | 12 June, 2012 (12.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2012/056118

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-515264 A (Dow Global Technologies Inc.), 26 May 2005 (26.05.2005), claims; entire text & US 2003/0045642 A1 & EP 1921688 A2 & EP 2262021 A1 & EP 2262022 A1 & WO 2003/007395 A1 & DE 60229850 D & DE 60239646 D & CA 2448514 A & TW 593627 B & CN 1599964 A & AT 414330 T & AT 504090 T | 1,2,8-10 |
| A | WO 2009/151144 A1 (Sumitomo Chemical Co., Ltd.), 17 December 2009 (17.12.2009), claims; entire text & JP 2010-18790 A & US 2011/0127512 A1 & EP 2289966 A1 & CN 102056960 A & KR 10-2011-0041463 A | 1,2,8-10 |
| A | WO 2008/093823 A1 (Sumitomo Chemical Co., Ltd.), 07 August 2008 (07.08.2008), claims; entire text & JP 2008-208359 A & US 2010/0096980 A1 & EP 2112184 A1 & CN 101595155 A & KR 10-2009-0114382 A | 1,2,8-10 |
| A | WO 2008/093822 A1 (Sumitomo Chemical Co., Ltd.), 07 August 2008 (07.08.2008), claims; entire text & JP 2008-208358 A & US 2010/0108993 A1 & EP 2110400 A1 & CN 101611070 A & KR 10-2009-0114381 A | 1,2,8-10 |

Form PCT/ISA/210 (continuation of second sheet) (July 2009)

**INTERNATIONAL SEARCH REPORT**

International application No.
PCT/JP2012/056118

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet

1. ☐ As all required additional search fees were timely paid by the applicant, this international search report covers all searchable claims.
2. ☐ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1, 2 and 8-10

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

INTERNATIONAL SEARCH REPORT

International application No.
PCT/JP2012/056118

Continuation of Box No.III of continuation of first sheet(2)

A "π-electron conjugated block copolymer" of claim 1 of this international application is set forth in document 1 below. Consequently, claim 1 cannot be considered novel and thus does not have a special technical feature.

Document 1: WO 2009/104781 A1 (Sumitomo Chemical Co., Ltd.), 27 August, 2009 (27.08.2009), claims, examples; JP 2010-74127 A; US 2010/0327271 A1; EP 2246382 A1; CN 101945922 A; KR 10-2010-0116667 A

Consequently, the inventions of claims 1-10 cannot be considered to have a common special technical feature, and thus these inventions are not considered so linked as to form a single general inventive concept.

The inventions of claims 1-10 are therefore considered to contain the following four groups of inventions respectively linked by the special technical features mentioned below.

In this connection, the invention of claim 1, which does not have a special technical feature, is considered to fall under invention group 1.

(Invention group 1) the inventions of claims 1 and 2, and parts of the inventions of claims 8-10 dependent on claims 1 and 2 (excluding (Invention group 2) to (Invention group 4) explained below)

Inventions related to a "π-electron conjugated block copolymer" of claim 1, wherein "the monomer unit constituting the polymer block A or the polymer block B has a heteroaryl skeleton that is a group which has at least one thiophene ring in a part of the chemical structure thereof".

(Invention group 2) the inventions of claims 3 and 4, and parts of the inventions of claims 8-10 dependent on claims 3 and 4 (excluding (Invention group 3) explained below)

Inventions related to a "π-electron conjugated block copolymer" of claim 1, wherein "the polymer block A or the polymer block B contains a monomer unit -ab-, and -a- has a group that is represented by one of formulae (1)-(8) ··· , while -b- is a monomer unit that has a group represented by one of formulae (9)-(19) ··· ".

(Invention group 3) the invention of claim 5, and parts of the inventions of claims 8-10 dependent on claim 5

Inventions related to a "π-electron conjugated block copolymer" of claim 1, wherein "the polymer block A or the polymer block B contains a monomer unit -ab-, and -a- has a group that is represented by one of formulae (1)-(8) ··· , while -b- is a monomer unit that has a group represented by one of formulae (9)-(19) ··· " and "both of the polymer block A and the polymer block B are polymer blocks that contain the monomer unit -a-b-".

(Invention group 4) the inventions of claims 6 and 7, and parts of the inventions of claims 8-10 dependent on claims 6 and 7

Inventions related to a "π-electron conjugated block copolymer" of claim 1, wherein "the polymer block B is a random copolymer".

This international search has been carried out on the above-described invention group 1.

Form PCT/ISA/210 (extra sheet) (July 2009)

**INTERNATIONAL SEARCH REPORT**

International application No.
PCT/JP2012/056118

(Regarding PCT Article 5 and Article 6)

Claims 1, 2 and 8-10

It is not clear what kind of structure the "heteroaryl skeleton" in claim 1 means.

"Fluorene" listed as one example of the "heteroaryl skeleton" is not generally considered as a "heteroaryl".

Consequently, claim 1 fails to satisfy the requirement of clearness prescribed under PCT Article 6. The same applies to claims 2 and 8-10 that are dependent on claim 1.

Claims 1, 2 and 8-10

A "monomer unit which has, in a part of the chemical structure thereof, at least one heteroaryl skeleton that is selected from among thiophene, fluorene, carbazole, dibenzosilole and dibenzogermole" of the "π-electron conjugated block copolymer" in the above-mentioned claims includes monomer units that have extremely various structures.

Only a few polymer blocks among the claimed polymer blocks, namely monomer units set forth in examples or the like are, however, disclosed within the meaning of PCT Article 5. Consequently, claims 1, 2 and 8-10 are not fully supported within the meaning of PCT Article 6.

Claims 1, 2 and 8-10

The "polymer block B" of the "π-electron conjugated block copolymer" in the above-mentioned claims is "configured of a copolymer block of at least two kinds of monomer units that have substituents $R^{nB}$ different from each other" and includes polymer blocks that have extremely various structures.

Only a few polymer blocks among the claimed polymer blocks, namely those wherein "the polymer block B is a random copolymer" and the structure other than "the substituents $R^{nB}$" is configured of a copolymer block that is composed of at least two kinds of monomer units that have the same structure are, however, disclosed within the meaning of PCT Article 5. Consequently, claims 1, 2 and 8-10 are not fully supported within the meaning of PCT Article 6.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008266459 A
- US 6960643 B2


### Non-patent literature cited in the description


- *Angew. Chem. Int. Ed,* 2008, vol. 47, 58
- *J. Am. Chem. Soc.,* 2008, vol. 130, 7812
- *Organic Electronics,* 2009, vol. 10, 1541
- *Chem. Mater.,* 2010, vol. 22, 2020
- *J. Polym. Sci. Part A: Polym, Chem.,* 2010, vol. 48, 614
- **A. YOKOYAMA ; R. MIYAKOSHI ; T. YOKOZAWA.** *Macromolecules,* 2007, vol. 40, 4093
- *J. Am. Chem. Soc.,* 2009, vol. 131, 7792
- *JACS,* 2008, vol. 130, 7812
- *Chem. Com.,* 2004, vol. 20, 2314
- *Macromolecules,* 1999, vol. 32, 4232
- *Macromolecules,* 2003, vol. 36, 61
- *Macromolecules,* 2011, vol. 44, 719
- *Organomethallics,* 2011, vol. 30, 3233